# EUROPEAN PATENT APPLICATION

(11) **EP 4 691 998 A1**
(43) Date of publication of application: **11.02.2026**
(21) Application number: 24781090.6
(22) Date of filing: 18.03.2024
(51) Int. Cl.: C01G 53/04, C09D 11/033, C09D 11/037, H10K 50/15, H10K 50/115, H10K 71/12, H10K 71/40, H10K 50/81, H10K 50/82, H10K 50/18

(54) **METHOD FOR PRODUCING METAL OXIDE NANOPARTICLES, METAL OXIDE NANOPARTICLES, INK COMPOSITION COMPRISING SAME, LIGHT-EMITTING ELEMENT, ELECTRONIC DEVICE, AND ELECTRONIC APPLIANCE**

(30) Priority: 24.03.2023 KR 20230038974; 05.06.2023 KR 20230072345
(71) Applicant: Samsung Display Co., Ltd., Yongin-si, Gyeonggi-do 17113 (KR); Research & Business Foundation Sungkyunkwan University, Suwon-si, Gyeonggi-do 16419 (KR)
(72) Inventor: NOH, Seung Uk, Yongin-si Gyeonggi-do 17113 (KR); LIM, Jae Hoon, Seongnam-si Gyeonggi-do 13603 (KR); JUNG, Woon Ho, Suwon-si Gyeonggi-do 16358 (KR); CHOI, Yeong Ho, Seongnam-si Gyeonggi-do 13611 (KR)
(74) Representative: Dr. Weitzel & Partner
(86) International application number: PCT/KR2024/003385
(87) International publication number: WO 2024/205099

(57) **Abstract**

A method of preparing a metal oxide nanoparticle represented by Formula 1 includes: forming a first composition including a nickel-containing precursor and an M-containing precursor, and heat-treating the first composition, wherein the M-containing precursor includes at least one halogen element:

Formula 1 Ni₁₋ₓMₓO

wherein, in Formula 1, x satisfies the condition of 0 <x<1, and M includes at least one metal element.

## Description

### Technical Field

One or more embodiments relate to a method of preparing metal oxide nanoparticles, metal oxide nanoparticles, and an ink composition, a light-emitting device, an electronic apparatus, and electronic device, each including the metal oxide nanoparticles.

### Background Art

From among light-emitting devices, self-emissive devices have wide viewing angles, high contrast ratios, short response times, and excellent characteristics in terms of luminance, driving voltage, and response speed.

In a light-emitting device, a first electrode is located on a substrate, and a hole transport region, an emission layer, an electron transport region, and a second electrode are sequentially arranged on the first electrode. Holes provided from the first electrode move toward the emission layer through the hole transport region, and electrons provided from the second electrode move toward the emission layer through the electron transport region. Carriers, such as holes and electrons, recombine in the emission layer to produce excitons. These excitons transition from an excited state to a ground state to thereby generate light.

### Disclosure of Invention

### Technical Problem

One or more embodiments include a method of preparing metal oxide nanoparticles, metal oxide nanoparticles, and an ink composition, a light-emitting device, an electronic apparatus, and electronic device, each including the metal oxide nanoparticles.

### Solution to Problem

According to one or more embodiments,
a method of preparing a metal oxide nanoparticle, represented by Formula 1, includes
forming a first composition including a nickel-containing precursor and an M-containing precursor, and
heat-treating the first composition, wherein
the M-containing precursor may include at least one halogen element:

   Formula 1 Ni₁₋ₓMₓO
wherein, in Formula 1, x may satisfy the condition of 0 <x<1, and M may include at least one metal element.

According to one or more embodiments, provided are metal oxide nanoparticles prepared by using the method of preparing metal oxide nanoparticles.

According to one or more embodiments, an ink composition includes the metal oxide nanoparticles and at least one solvent.

According to one or more embodiments,
a light-emitting device includes
a first electrode,
a second electrode facing the first electrode, and
an interlayer arranged between the first electrode and the second electrode and including an emission layer, wherein
the interlayer may further include a hole transport region between the emission layer and the second electrode, and
the hole transport region may include the metal oxide nanoparticles.

According to one or more embodiments, a method of manufacturing the light-emitting device includes preparing an ink composition including the metal oxide nanoparticles and at least one solvent, and
forming the hole transport region including the metal oxide nanoparticles by spin-coating the ink composition.

According to one or more embodiments, an electronic apparatus includes the light-emitting device.

According to one or more embodiments, electronic device includes the light-emitting device.

### Advantageous Effects of Invention

By manufacturing metal oxide nanoparticles according to the method of manufacturing metal oxide nanoparticles, not only can metal oxide nanoparticles be manufactured at low-temperature, but also the generation of by-products other than metal oxide nanoparticles can be prevented. In addition, the metal oxide nanoparticles have increased bandgaps and deepened electron valence bands, and thus, the hole conductivity and the hole transport performance thereof can be increased. Therefore, by using the metal oxide nanoparticles, a light-emitting device with increased luminescence efficiency and maximum luminance and a high-quality electronic device including the same can be manufactured.

### Brief Description of Drawings

FIG. 1 is a schematic view of a structure of a light-emitting device according to an embodiment.
FIG. 2 is a schematic view of a structure of an electronic apparatus according to an embodiment.
FIG. 3 is a schematic view of a structure of an electronic apparatus according to another embodiment.
FIGS. 4, 5, 6A, 6B, and 6C are each a schematic view of a structure of electronic device according to an embodiment.
FIG. 7 shows a diagram showing absorbance of metal oxide nanoparticles prepared according to Preparation Example 1 and Comparative Preparation Example 2.
FIG. 8 shows a diagram showing band gaps of Preparation Example 1, Preparation Example 2, and Comparative Preparation Example 1.
FIGS. 9 and 10 show diagrams showing energy levels of valence bands of Preparation Example 1, Preparation Example 2, and Comparative Preparation Example 1.
FIG. 11 shows a diagram of hole conductivities of Preparation Example 1, Preparation Example 2, and Comparative Preparation Example 1.
FIG. 12 shows a diagram of hole conductivities of Example 1, Example 2, and Comparative Example 1.
FIG. 13 shows a diagram illustrating measurements of turn-on voltage and luminance of Example 1, Example 2, and Comparative Example 1.
FIG. 14 shows a diagram illustrating measurements of maximum external quantum efficiency of Example 1, Example 2, and Comparative Example 1.
FIG. 15 shows a diagram showing absorption and emission spectra of quantum dots included in Example 1.

### Mode for the Invention

Because the disclosure may have diverse modified embodiments, embodiments are illustrated in the drawings and are described in the detailed description. An effect and a characteristic of the disclosure, and a method of accomplishing these will be apparent when referring to embodiments described with reference to the drawings. The disclosure may, however, be embodied in many different forms and should not be construed as limited to the embodiments set forth herein.

It will be understood that although the terms "first," "second," etc. used herein may be used herein to describe various components, these components should not be limited by these terms. These components are only used to distinguish one component from another.

An expression used in the singular encompasses the expression of the plural, unless it has a clearly different meaning in the context.

The term "consist of" used herein refers to the existence of only the corresponding component while excluding the possibility that other components are added. For example, the wording "consist of A, B and C" refers to the existence of only A, B and C.

In the present specification, terms "include or have" refer to that a corresponding component is present, and the possibility of adding one or more other components is not excluded. Unless defined otherwise, the terms "include or have" may refer to both the case of consisting of the corresponding components and the case of further including other components.

It will be understood that when a layer, region, or component is referred to as being "on" or "onto" another layer, region, or component in the present specification, it may be directly or indirectly formed on the other layer, region, or component. That is, for example, intervening layers, regions, or components may be present.

Sizes of elements in the drawings may be exaggerated for convenience of explanation. In other words, because sizes and thicknesses of components in the drawings are arbitrarily illustrated for convenience of explanation, the following embodiments are not limited thereto.

An aspect provides
a method of preparing a metal oxide nanoparticle represented by Formula 1, the method including:
forming a first composition including a nickel-containing precursor and an M-containing precursor; and
heat-treating the first composition, wherein
the M-containing precursor may include at least one halogen element:

   Formula 1 Ni₁₋ₓMₓO
wherein, in Formula 1, x may satisfy the condition of 0 <x<1, and M may include at least one metal element.

According to an embodiment, x in Formula 1 may satisfy the condition of 0 <x<0.5.

For example, x may be more than about 0 and less than about 0.5, more than about 0 and not more than about 0.45, more than about 0 and not more than about 0.4, more than about 0 and not more than about 0.3, more than about 0 and not more than about 0.2, more than about 0 and not more than about 0.1, more than about 0 and not more than about 0.09, more than about 0 and not more than about 0.08, more than about 0 and not more than about 0.07, more than about 0 and not more than about 0.06, more than about 0 and not more than about 0.05, more than about 0 and not more than about 0.04, more than about 0 and not more than about 0.03, more than about 0 and not more than about 0.02, not less than about 0.01 and less than about 0.5, not less than about 0.01 and not more than about 0.45, not less than about 0.01 and not more than about 0.4, not less than about 0.01 and not more than about 0.3, not less than about 0.01 and not more than about 0.2, not less than about 0.01 and not more than about 0.1, not less than about 0.01 and not more than about 0.09, not less than about 0.01 and not more than about 0.08, not less than about 0.01 and not more than about 0.07, not less than about 0.01 and not more than about 0.06, not less than about 0.01 and not more than about 0.05, not less than about 0.01 and not more than about 0.04, not less than about 0.01 and not more than about 0.03, not less than about 0.01 and not more than about 0.02, not less than about 0.02 and less than about 0.5, not less than about 0.02 and not more than about 0.45, not less than about 0.02 and not more than about 0.4, not less than about 0.02 and not more than about 0.3, not less than about 0.02 and not more than about 0.2, not less than about 0.02 and not more than about 0.1, not less than about 0.02 and not more than about 0.09, not less than about 0.02 and not more than about 0.08, not less than about 0.02 and not more than about 0.07, not less than about 0.02 and not more than about 0.06, not less than about 0.02 and not more than about 0.05, not less than about 0.02 and not more than about 0.04, not less than about 0.02 and not more than about 0.03, not less than about 0.03 and less than about 0.5, not less than about 0.03 and not more than about 0.45, not less than about 0.03 and not more than about 0.4, not less than about 0.03 and not more than about 0.3, not less than about 0.03 and not more than about 0.2, not less than about 0.03 and not more than about 0.1, not less than about 0.03 and not more than about 0.09, not less than about 0.03 and not more than about 0.08, not less than about 0.03 and not more than about 0.07, not less than about 0.03 and not more than about 0.06, not less than about 0.03 and not more than about 0.05, or not less than about 0.03 and not more than about 0.04.

According to an embodiment, the heat-treating of the first composition may be performed in a temperature range of not less than about 100 °C and less than about 300 °C.

For example, the temperature range may be not less than about 100 °C and less than about 300 °C, not less than about 100 °C and not more than about 290 °C, not less than about 100 °C and not more than about 280 °C, not less than about 100 °C and not more than about 270 °C, not less than about 100 °C and not more than about 260 °C, not less than about 100 °C and not more than about 250 °C°C, not less than about 100 °C and not more than about 240 °C, not less than about 100 °C and not more than about 230 °C, not less than about 100 °C and not more than about 220 °C°C, not less than about 100 °C and not more than about 210 °C, not less than about 100 °C and not more than about 200 °C, not less than about 100 °C and not more than about 190 °C, not less than about 100 °C and not more than about 180 °C, not less than about 100 °C and not more than about 170 °C, not less than about 100 °C and not more than about 160 °C, not less than about 110 °C and not more than about 290 °C, not less than about 110 °C and not more than about 270 °C, not less than about 110 °C and not more than about 250 °C, not less than about 110 °C and not more than about 230 °C, not less than about 110 °C and not more than about 210 °C, not less than about 110 °C and not more than about 190 °C, not less than about 110 °C and not more than about 170 °C, not less than about 110 °C and not more than about 160 °C, not less than about 130 °C and not more than about 290 °C, not less than about 130 °C and not more than about 280 °C, not less than about 130 °C and not more than about 260 °C, not less than about 130 °C and not more than about 240 °C, not less than about 130 °C and not more than about 220 °C, not less than about 130 °C and not more than about 200 °C, not less than about 130 °C and not more than about 180 °C, not less than about 130 °C and not more than about 160 °C, not less than about 140 °C and not more than about 290 °C, not less than about 140 °C and not more than about 270 °C, not less than about 140 °C and not more than about 250 °C, not less than about 140 °C and not more than about 230 °C, not less than about 140 °C and not more than about 210 °C, not less than about 140 °C and not more than about 190 °C°C, not less than about 140 °C and not more than about 170 °C, not less than about 140 °C and not more than about 160 °C, not less than about 150 °C and not more than about 290 °C, not less than about 150 °C and not more than about 280 °C, not less than about 150 °C and not more than about 260 °C, not less than about 150 °C and not more than about 240 °C, not less than about 150 °C and not more than about 220 °C, not less than about 150 °C and not more than about 200 °C, not less than about 150 °C and not more than about 180 °C°C, not less than about 150 °C and not more than about 170 °C, or not less than about 150 °C and not more than about 160 °C.

According to an embodiment, M may include Zn, Mg, Cu, Pb, Al, In, Sr, Pd, Cd, Ag, or a combination thereof.

For example, M may include Zn, Mg, or a combination thereof.

For example, M may be Zn.

According to an embodiment, the M-containing precursor may be represented by Formula 2:

Formula 2 MX_{y}

wherein, in Formula 2,
X may be selected from CI, Br, and I, and y may satisfy the condition of 0 <y≤3.

For example, X may be an anion. Therefore, the wording "X is selected CI, Br, and I" indicates the wording "X is selected from Cl⁻, Br⁻, and I⁻.

For example, X may be Cl or Cl⁻.

According to an embodiment, the M-containing precursor may be MCl₂, MBr₂, or MI₂.

For example, the M-containing precursor may be ZnCl₂.

According to an embodiment, the nickel-containing precursor may include nickel nitrate hydrate, nickel acetate hydrate, nickel acetylacetonate, nickel formate hydrate, nickel chloride hydrate, or a combination thereof.

For example, the nickel-containing precursor may include nickel nitrate hydrate, nickel acetate hydrate, nickel chloride hydrate, or a combination thereof.

For example, the nickel-containing precursor may be nickel nitrate hydrate.

For example, the nickel-containing precursor may be Ni(NO₃)₂•6H₂O.

According to an embodiment, the first composition may further include a solvent.

For example, the solvent may include an organic solvent.

For example, the solvent may include dimethyl sulfoxide.

In addition, the solvent may include a solvent applied to an ink composition to be described below.

By manufacturing metal oxide nanoparticles according to the method of manufacturing metal oxide nanoparticles, not only can metal oxide nanoparticles be manufactured at low-temperature, but also the generation of by-products other than metal oxide nanoparticles can be prevented.

In particular, because the method for manufacturing metal oxide nanoparticles according to the present disclosure uses an M-containing precursor including a halogen element, generation of by-products other than metal oxide nanoparticles may be prevented, and metal oxide nanoparticles may be smoothly formed.

In addition, when a high temperature is applied during the manufacture of metal oxide nanoparticles, the type of the bottom substrate of a light-emitting device is limited or the bottom substrate may be likely to be damaged. However, the method of manufacturing metal oxide nanoparticles according to the present disclosure may provide metal oxide nanoparticles at low temperature, and the issues can be prevented.

In addition, by manufacturing metal oxide nanoparticles according to the method of manufacturing metal oxide nanoparticles according to the present disclosure, the size of the metal oxide nanoparticles may be reduced and the formation of nickel vacancies may be improved, thereby leading to the improvement in the hole transport performance.

In particular, metal oxide nanoparticles according to the present disclosure can reduce the energy level difference with the emission layer by increasing the absolute value of the valence band, enabling smooth transportation and injection of holes.

Another aspect provides metal oxide nanoparticles prepared according to the method of preparing metal oxide nanoparticles as described above and represented by Formula 1:

Formula 1 Ni₁₋ₓMₓO

wherein, in Formula 1, x may satisfy the condition of 0 <x<1, and M may include at least one metal element.

The detailed description of Formula 1 is the same as described in the specification.

According to an embodiment, the metal oxide nanoparticles may have an alloy structure including Ni, M, and O. That is, the metal oxide nanoparticles have a structure in which Ni, M and O are evenly distributed. In an embodiment, the metal oxide nanoparticles may have a structure in which Ni and O form a core and M is bonded or distributed on the surface thereof.

Since the metal oxide nanoparticles are prepared by the method of manufacturing metal oxide nanoparticles described above, the size of the metal oxide nanoparticles is reduced and the formation of nickel vacancies is improved, thereby improving the hole transport performance.

Therefore, light-emitting devices including the metal oxide nanoparticles may have excellent luminescence efficiency and luminance based on improved hole transport performance.

Another aspect provides an ink composition including the metal oxide nanoparticles as described above and at least one solvent.

According to an embodiment, the solvent may be an alcohol-based solvent, an ether-based solvent, an aromatic solvent, or a combination thereof.

For example, the solvent may include methanol, ethanol, propanol, butanol, pentanol, cyclohexylbenzene, 1,3-dipropoxybenzene, 4-methoxybenzaldehyde-dimethyl-acetal, 4,4'-difluorodiphenylmethane, diphenylether, 1,2-dimethoxy-4-(1-propenyl)benzene, 2-phenoxytoluene (MDPE), diphenylmethane, 2-phenylpyridine, dimethyl benzyl ether (DMDPE), 3-phenoxytoluene, 3-phenylpyridine, 2-phenylanisole, 2-phenoxytetrahydropuran, 1-propyl-4-phenyl benzene (NPBP), 2-phenoxy-1 (25DMDPE),4-dimethyl benzene (the boiling point of 280 °C), ethyl-2-naphtyl-ether, dodecylbenzene, 2,2,5-tri-methy diphenyl ether (225TMDPE), dibenzyl-ether, 2,3,5-tri-methy diphenyl ether (235TMDPE), N-methyldiphenylamine, 4-isopropylbiphenyl, α,α-dichlorodiphenylmethane, 4-(3-phenylpropyl)pyridine, benzyl-benzoate, 1,1-bis(3,4-dimethylphenyl)ethane, diethyleneglycol butyl methyl ether (DEGBME),diethyleneglycol monomethyl ether (DEGME), diethyleneglycol ethylmethyl ether (DEGEME), diethyleneglycol dibutyl ether (DEGDBE), propyleneglycol methyl ether acetate (PGMEA), triethyleneglycol monomethyl ether (TGME), diethylene glycol monobutyl ether (DGBE), or a combination thereof.

According to an embodiment, the ink composition may further include a dispersant. The dispersant may include anionic, cationic, and nonionic polymeric materials.

According to an embodiment, the content of the metal oxide nanoparticles may be not more than 10 wt% based on the total weight of the ink composition. For example, the content of the metal oxide nanoparticles may be less than 10 wt% based on the total weight of the ink composition.

For example, the content of the metal oxide nanoparticles may be about 0.01 wt% to about 10 wt% based on the total weight of the ink composition. For example, the content of the metal oxide nanoparticles may be about 0.05 wt% to about 10 wt% based on the total weight of the ink composition. For example, the content of the metal oxide nanoparticles may be about 0.1 wt% to about 10 wt% based on the total weight of the ink composition.

Because the ink composition may have excellent inkjet ejection stability, an inkjet printing process may be used. Accordingly, an arbitrary layer including the metal oxide nanoparticles may be formed by inkjet printing the ink composition. For example, a light-emitting device in which the hole transport region (for example, the hole transport layer) includes the metal oxide nanoparticles, may be fabricated by inkjet printing the ink composition.

In addition, for the ink composition, blade coating, photolithography, nozzle printing, spray printing, or slit printing may also be applicable. Accordingly, an arbitrary layer including the metal oxide nanoparticles may be formed by using black coating, photolithography, nozzle printing, spray printing, or slit printing the ink composition. For example, a light-emitting device in which the hole transport region (for example, the hole transport layer) includes the metal oxide nanoparticles, may be fabricated by blade coating, photolithography, nozzle printing, spray printing, or slit printing of the ink composition.

In an embodiment, the ink composition may be subjected to a spin-coating process. Accordingly, an arbitrary layer including the metal oxide nanoparticles may be formed by spin-coating the ink composition. For example, a light-emitting device in which the hole transport region (for example, the hole transport layer) includes the metal oxide nanoparticles, may be fabricated by spin coating the ink composition.

In this case, the inkjet printing process or the spin-coating process may use a known method, and may be clearly understood through Examples described later.

Another aspect provides a light-emitting device including the metal oxide nanoparticles as described above.

The light-emitting device includes:
a first electrode;
a second electrode facing the first electrode; and
an interlayer arranged between the first electrode and the second electrode and including an emission layer.

According to an embodiment, the interlayer may further include a hole transport region disposed between the first electrode and the emission layer, and the hole transport region may include the metal oxide nanoparticles.

In an embodiment, the first electrode may be an anode,
the second electrode may be a cathode,
the interlayer may further include an electron transport region located between the emission layer and the second electrode,
the hole transport region may include a hole injection layer, a hole transport layer, an emission auxiliary layer, an electron-blocking layer, or a combination thereof, and
the electron transport region may include a hole-blocking layer, an electron transport layer, an electron injection layer, an electron-blocking layer, or any combination thereof.

According to an embodiment, the metal oxide nanoparticles may be included in at least one of a hole transport layer or a hole injection layer.

According to an embodiment, the hole transport layer may include the metal oxide nanoparticles.

According to an embodiment, the hole injection layer may include the metal oxide nanoparticles.

In one or more embodiments, the emission layer may include a quantum dot.

According to an embodiment, the quantum dot may include a Group III-Group V semiconductor compound, a Group II-Group VI semiconductor compound, a Group III-Group VI semiconductor compound, a Group I-Group III-Group VI semiconductor compound, a Group IV-Group VI semiconductor compound, a Group IV element or compound, or any combination thereof.

For example, the quantum dot may include a Group III-Group V semiconductor compound, a Group II-Group VI semiconductor compound, or a combination thereof.

For example, the quantum dot may include InP, ZnSe, and ZnS.

In one embodiment, the emission layer may emit red light.

For example, quantum dots in the emission layer may emit red light.

According to an embodiment, the emission layer may emit light with a maximum emission wavelength of about 600 nm to about 700 nm.

For example, the emission layer may emit light with a maximum emission wavelength of about 600 nm to about 700 nm, about 610 nm to about 690 nm, about 610 nm to about 680 nm, about 610 nm to about 670 nm, about 610 nm to about 660 nm, about 610 nm to about 650 nm, about 610 nm to about 640 nm, or about 610 nm to about 630 nm.

According to an embodiment, the photoluminescence quantum yield (PLQY) value of the light-emitting device may be not less than 80 %.

For example, the PLQY value of the light-emitting device may be not less than 80 %, not less than 82 %, not less than 84 %, or not less than 86 %.

In an embodiment, the light-emitting device may further include a capping layer arranged outside the first electrode and/or outside the second electrode.

In an embodiment, the light-emitting device may further include at least one of a first capping layer located outside the first electrode and a second capping layer located outside the second electrode, and the metal oxide nanoparticle represented by Formula 1 may be included in at least one of the first capping layer and the second capping layer. More details on the first capping layer and/or second capping layer are the same as described herein.

In an embodiment, the light-emitting device may further include:
a first capping layer disposed outside the first electrode and including the a metal oxide nanoparticle represented by Formula 1; and
a second capping layer disposed outside the second electrode and including a nanocomposite including the a metal oxide nanoparticle represented by Formula 1; or
the first capping layer and the second capping layer.

The expression "(interlayer and/or capping layer) includes the metal oxide nanoparticle represented by Formula 1" as used herein may be understood as "(interlayer and/or capping layer) may include one kind of metal oxide nanoparticle represented by Formula 1 or two different kinds of metal oxide nanoparticles, each represented by Formula 1."

For example, the interlayer and/or capping layer may include only a first metal oxide nanoparticle as the metal oxide nanoparticle. In an embodiment, the first metal oxide nanoparticle may exist in the hole transport region of the light-emitting device. In an embodiment, the interlayer may include, as metal oxide nanoparticles, a first metal oxide nanoparticles and a second metal oxide nanoparticle. In an embodiment, the first metal oxide nanoparticle and the second metal oxide nanoparticle may exist in the same layer (for example, the first metal oxide nanoparticle and the second metal oxide nanoparticle may exist in the hole transport region) or in different layers (for example, the first metal oxide nanoparticle may exist in the hole transport region and the second metal oxide nanoparticle may exist in the electron transport region.)

The term "interlayer" as used herein refers to a single layer and/or all of a plurality of layers arranged between the first electrode and the second electrode of the light-emitting device.

For a more detailed description of the light-emitting devices, reference is made to the disclosure herein.

Another aspect provides a method of manufacturing a light-emitting device as described.

The method of manufacturing the light-emitting device may include:

preparing an ink composition including the metal oxide nanoparticles and at least one solvent; and

forming the hole transport region including the metal oxide nanoparticles by spin-coating the ink composition.

The solvent and the ink composition are the same as those described in the present specification.

According to an embodiment, in the forming of the hole transport region including the metal oxide nanoparticles by spin coating the ink composition, the spin coating may be performed at the rate of about 2000 rpm to about 4000 rpm.

For example, the spin coating in the method of producing the light-emitting device may be performed at the rate of about 2000 rmp to about 4000 rmp, about 2000 rmp to about 3500 rmp, about 2000 rmp to about 3300 rmp, about 2000 rmp to about 3100 rmp, about 2500 rmp to about 4000 rmp, about 2500 rmp to about 3800 rmp, about 2500 rmp to about 3500 rmp, about 2500 rmp to about 3300 rmp, or about 2500 rmp to about 3100 rmp.

According to an embodiment, the ink composition may be spin coated for about 10 seconds to about 180 seconds.

For example, the spin coating may be performed for about 10 seconds to about 180 seconds, about 20 seconds to about 180 seconds, about 30 seconds to about 180 seconds, about 40 seconds to about 180 seconds, about 50 seconds to about 180 seconds, about 60 seconds to about 180 seconds, about 10 seconds to about 170 seconds, about 20 seconds to about 170 seconds, about 30 seconds to about 170 seconds, about 40 seconds to about 170 seconds, about 50 seconds to about 170 seconds, about 60 seconds to about 170 seconds, about 10 seconds to about 160 seconds, about 20 seconds to about 160 seconds, about 30 seconds to about 160 seconds, about 40 seconds to about 160 seconds, about 50 seconds to about 160 seconds, about 60 seconds to about 160 seconds, about 10 seconds to about 150 seconds, about 20 seconds to about 150 seconds, about 30 seconds to about 150 seconds, about 40 seconds to about 150 seconds, about 50 seconds to about 150 seconds, about 60 seconds to about 150 seconds, about 10 seconds to about 140 seconds, about 20 seconds to about 140 seconds, about 30 seconds to about 140 seconds, about 40 seconds to about 140 seconds, about 50 seconds to about 140 seconds, about 60 seconds to about 140 seconds, about 10 seconds to about 130 seconds, about 20 seconds to about 130 seconds, about 30 seconds to about 130 seconds, about 40 seconds to about 130 seconds, about 50 seconds to about 130 seconds, about 60 seconds to about 130 seconds, about 10 seconds to about 120 seconds, about 20 seconds to about 120 seconds, about 30 seconds to about 120 seconds, about 40 seconds to about 120 seconds, about 50 seconds to about 120 seconds, about 60 seconds to about 120 seconds, about 10 seconds to about 100 seconds, about 20 seconds to about 100 seconds, about 30 seconds to about 100 seconds, about 40 seconds to about 100 seconds, about 50 seconds to about 100 seconds, about 60 seconds to about 100 seconds, about 10 seconds to about 80 seconds, about 20 seconds to about 80 seconds, about 30 seconds to about 80 seconds, about 40 seconds to about 80 seconds, about 50 seconds to about 80 seconds, about 60 seconds to about 80 seconds, about 10 seconds to about 60 seconds, about 20 seconds to about 60 seconds, about 30 seconds to about 60 seconds, or about 10 seconds to about 40 seconds.

According to an embodiment, the method of manufacturing the light-emitting device may further include heat-treating the ink composition after spin coating the ink composition.

According to an embodiment, the heat treatment may be performed in a temperature range of about 80 °C to about 200 °C.

For example, the heat treatment may be performed at about 80 °C to about 200 °C, about 80 °C to about 190 °C, about 80 °C to about 180 °C, about 80 °C to about 170 °C, about 80 °C to about 160 °C, about 80 °C to about 150 °C, about 80 °C to about 140 °C, about 80 °C to about 130 °C, about 80 °C to about 120 °C, about 80 °C to about 110 °C, about 90 °C to about 200 °C, about 90 °C to about 190 °C, about 90 °C to about 180 °C, about 90 °C to about 170 °C, about 90 °C to about 160 °C, about 90 °C to about 150 °C, about 90 °C to about 140 °C, about 90 °C to about 130 °C, about 90 °C to about 120 °C, about 90 °C to about 110 °C, about 95 °C to about 200 °C, about 95 °C to about 190 °C, about 95 °C to about 180 °C, about 95 °C to about 170 °C, about 95 °C to about 160 °C, about 95 °C to about 150 °C, about 95 °C to about 140 °C, about 95 °C to about 130 °C, about 95 °C to about 120 °C, about 95 °C to about 110 °C, or about 95 °C to about 105 °C.

Another aspect provides an electronic apparatus including the light-emitting device. The electronic apparatus may further include a thin-film transistor. For example, the electronic apparatus may further include a thin-film transistor including a source electrode and a drain electrode, wherein the first electrode of the light-emitting device may be electrically connected to the source electrode or the drain electrode. In an embodiment, the electronic apparatus may further include a color filter, a color conversion layer, a touch screen layer, a polarizing layer, or a combination thereof.

More details on the electronic apparatus are the same as described herein.

Another aspect provides electronic device including the light-emitting device.

For example, the electronic device may be one of a flat panel display, a curved display, a computer monitor, a medical monitor, a television, a billboard, an indoor or outdoor light and/or light for signal, a head-up display, a fully or partially transparent display, a flexible display, a rollable display, a foldable display, a stretchable display, a laser printer, a telephone, a portable phone, a tablet personal computer, a phablet, a personal digital assistant (PDA), a wearable device, a laptop computer, a digital camera, a camcorder, a viewfinder, a micro display, a three-dimensional (3D) display, a virtual reality or augmented reality display, a vehicle, a video wall with multiple displays tiled together, a theater or stadium screen, a phototherapy device, and a signboard.

More details on the electronic device are the same as described herein.

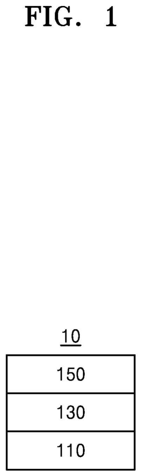

### [Description of FIG. 1]

FIG. 1 is a schematic cross-sectional view of a light-emitting device 10 according to an embodiment. The light-emitting device 10 includes a first electrode 110, an interlayer 130, and a second electrode 150.

Hereinafter, the structure of the light-emitting device 10 according to an embodiment and a method of manufacturing the light-emitting device 10 will be described with reference to FIG. 1.

### [First electrode 110]

In FIG. 1, a substrate may be additionally arranged under the first electrode 110 or on the second electrode 150. In an embodiment, as the substrate, a glass substrate or a plastic substrate may be used. In an embodiment, the substrate may be a flexible substrate, and may include plastics with excellent heat resistance and durability, such as polyimide, polyethylene terephthalate (PET), polycarbonate, polyethylene napthalate, polyarylate (PAR), polyetherimide, or a combination thereof.

The first electrode 110 may be formed by, for example, depositing or sputtering a material for forming the first electrode 110 on the substrate. When the first electrode 110 is an anode, a material for forming the first electrode 110 may be a high-work function material that facilitates injection of holes.

The first electrode 110 may be a reflective electrode, a semi-transmissive electrode, or a transmissive electrode. In an embodiment, when the first electrode 110 is a transmissive electrode, a material for forming the first electrode 110 may include indium tin oxide (ITO), indium zinc oxide (IZO), tin oxide (SnO₂), zinc oxide (ZnO), or a combination thereof. In one or more embodiments, when the first electrode 110 is a semi-transmissive electrode or a reflective electrode, a material for forming the first electrode 110 may include magnesium (Mg), silver (Ag), aluminum (Al), aluminum-lithium (Al-Li), calcium (Ca), magnesium-indium (Mg-In), magnesium-silver (Mg-Ag), or a combination thereof.

The first electrode 110 may have a single-layer structure consisting of a single layer or a multi-layer structure including a plurality of layers. For example, the first electrode 110 may have a three-layer structure of ITO/Ag/ITO.

### [Interlayer 130]

The interlayer 130 is arranged on the first electrode 110. The interlayer 130 may include the emission layer.

The interlayer 130 may further include a hole transport region arranged between the first electrode 110 and the emission layer, and an electron transport region arranged between the emission layer and the second electrode 150.

The interlayer 130 may further include inorganic materials such as metalcontaining compounds and quantum dots in addition to various organic materials.

In an embodiment, the interlayer 130 may include, i) two or more emitting units sequentially stacked between the first electrode 110 and the second electrode 150, and ii) a charge generation layer between the two or more emitting units. When the interlayer 130 includes the two or more emitting units and the charge generation layer, the light-emitting device 10 may be a tandem light-emitting device.

### [Hole transport region in interlayer 130]

The hole transport region may include a metal oxide nanoparticle represented by Formula 1 and/or a nanocomposite including the metal oxide nanoparticles.

The hole transport region may have: i) a single-layer structure consisting of a single layer consisting of a single material, ii) a single-layer structure consisting of a single layer consisting of a plurality of different materials, or iii) a multi-layer structure including a plurality of layers including a plurality of different materials.

The hole transport region may include a hole injection layer, a hole transport layer, an emission auxiliary layer, an electron-blocking layer, or a combination thereof.

For example, the hole transport region may have a multi-layer structure including a hole injection layer/hole transport layer structure, a hole injection layer/hole transport layer/emission auxiliary layer structure, a hole injection layer/emission auxiliary layer structure, a hole transport layer/emission auxiliary layer structure, or a hole injection layer/hole transport layer/electron-blocking layer structure, wherein constituent layers of each structure are stacked sequentially from the first electrode 110.

The hole transport region may include a compound represented by Formula 201, a compound represented by Formula 202, or a combination thereof:

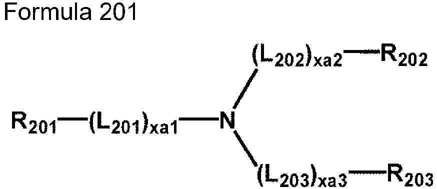

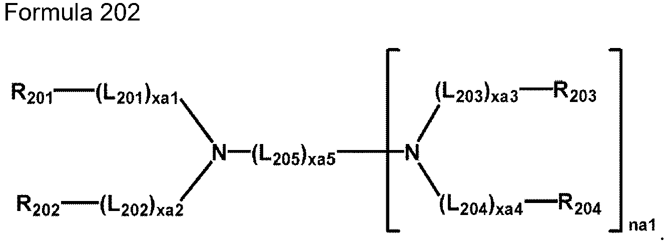

In Formulae 201 and 202,
L₂₀₁ to L₂₀₄ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
L₂₀₅ may be *-O-*', *-S-*', *-N(Q₂₀₁)-*', a C₁-C₂₀ alkylene group unsubstituted or substituted with at least one R₁₀ₐ, a C₂-C₂₀ alkenylene group unsubstituted or substituted with at least one R₁₀ₐ, a C₃-C₆₀ carbocyclic group unsubstituted or substituted with at least one R₁₀ₐ, or a C₁-C₆₀ heterocyclic group unsubstituted or substituted with at least one R₁₀ₐ,
xa1 to xa4 may each independently be an integer from 0 to 5,
xa5 may be an integer from 1 to 10,
R₂₀₁ to R₂₀₄ and Q₂₀₁ may each independently be a C₃-C₆₀ carbocyclic group unsubstituted or substituted with at least one R₁₀ₐ, or a C₁-C₆₀ heterocyclic group unsubstituted or substituted with at least one R₁₀ₐ,
R₂₀₁ and R₂₀₂ may optionally be linked to each other via a single bond, a C₁-C₅ alkylene group unsubstituted or substituted with at least one R₁₀ₐ, or a C₂-C₅ alkenylene group unsubstituted or substituted with at least one R₁₀ₐ to form a C₈-C₆₀ polycyclic group (e.g., a carbazole group or the like) unsubstituted or substituted with at least one R₁₀ₐ (e.g., see Compound HT16),
R₂₀₃ and R₂₀₄ may optionally be linked to each other via a single bond, a C₁-C₅ alkylene group unsubstituted or substituted with at least one R₁₀ₐ, or a C₂-C₅ alkenylene group unsubstituted or substituted with at least one R₁₀ₐ, to form a C₈-C₆₀ polycyclic group unsubstituted or substituted with at least one R₁₀ₐ, and
na1 may be an integer from 1 to 4.

For example, each of Formulae 201 and 202 may include at least one of groups represented by Formulae CY201 to CY217:

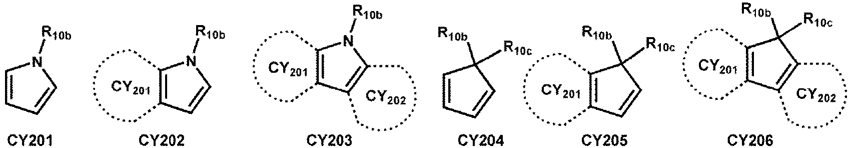

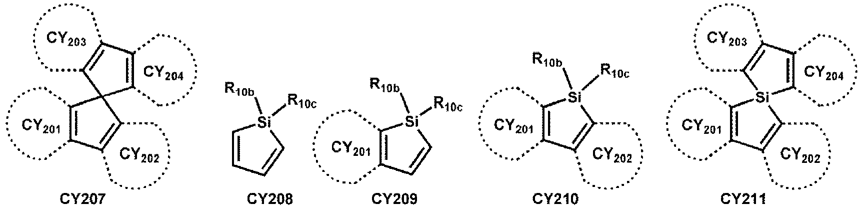

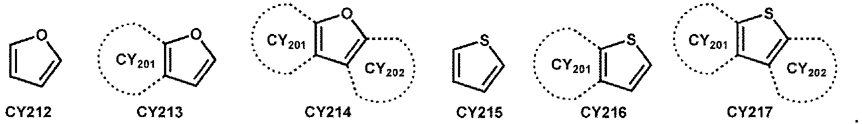

In Formulae CY201 to CY217, R_{10b} and R_{10c} may each be the same as described in connection with R₁₀ₐ, ring CY₂₀₁ to ring CY₂₀₄ may each independently be a C₃-C₂₀ carbocyclic group or a C₁-C₂₀ heterocyclic group, and at least one hydrogen in Formulae CY201 to CY217 may be unsubstituted or substituted with R₁₀ₐ.

In one or more embodiments, ring CY₂₀₁ to ring CY₂₀₄ in Formulae CY201 to CY217 may each independently be a benzene group, a naphthalene group, a phenanthrene group, or an anthracene group.

In one or more embodiments, each of Formulae 201 and 202 may include at least one of the groups represented by Formulae CY201 to CY203.

In one or more embodiments, Formula 201 may include at least one of the groups represented by Formulae CY201 to CY203 and at least one of the groups represented by Formulae CY204 to CY217.

In one or more embodiments, in Formula 201, xa1 may be 1, R₂₀₁ may be one of the groups represented by Formulae CY201 to CY203, xa2 may be 0, and R₂₀₂ may be one of the groups represented by Formulae CY204 to CY207.

In one or more embodiments, each of Formulae 201 and 202 may not include the groups represented by Formulae CY201 to CY203.

In one or more embodiments, each of Formulae 201 and 202 may not include the groups represented by Formulae CY201 to CY203, and may include at least one of the groups represented by Formulae CY204 to CY217.

In one or more embodiments, each of Formulae 201 and 202 may not include the groups represented by Formulae CY201 to CY217.

For example, the hole transport region may include: one of Compounds HT1 to HT46; m-MTDATA; TDATA; 2-TNATA; NPB(NPD); β-NPB; TPD; spiro-TPD; spiro-NPB; methylated NPB; TAPC; HMTPD; 4,4',4"-tris(N-carbazolyl)triphenylamine (TCTA); polyaniline/dodecylbenzenesulfonic acid (PANI/DBSA); poly(3,4-ethylenedioxythiophene)/poly(4-styrenesulfonate) (PEDOT/PSS); polyaniline/camphor sulfonic acid (PANI/CSA); polyaniline/poly(4-styrenesulfonate) (PANI/PSS); or a combination thereof:

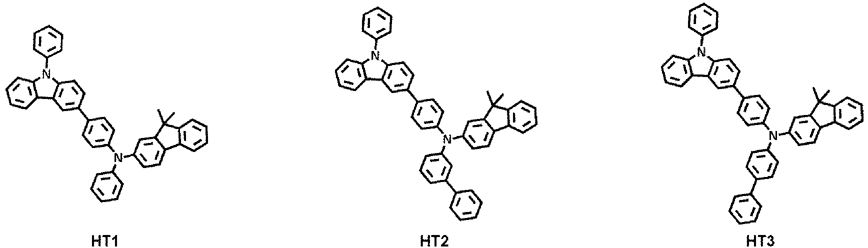

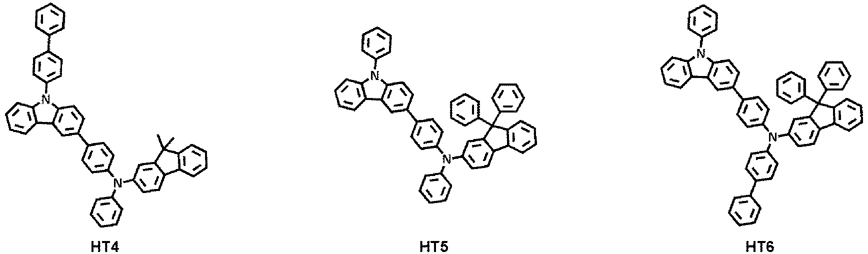

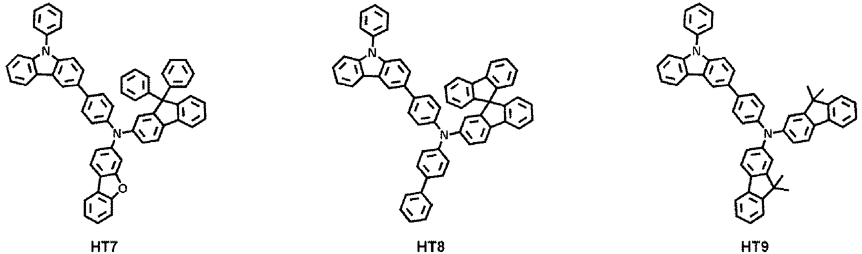

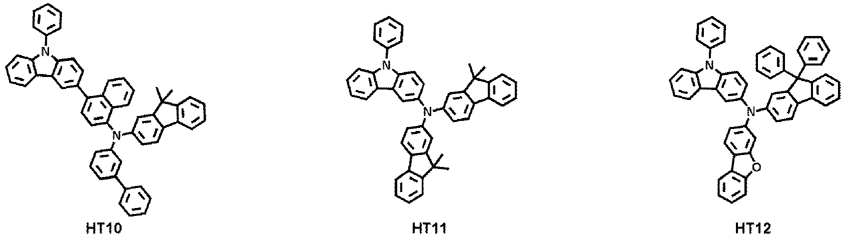

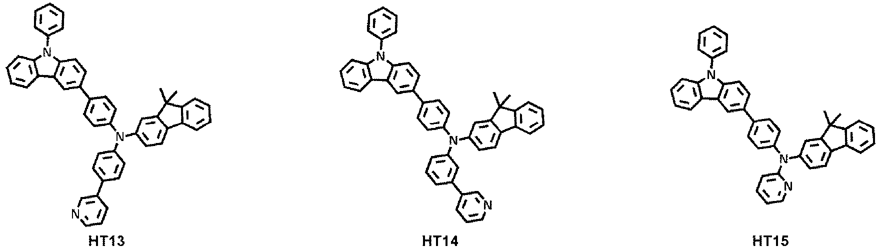

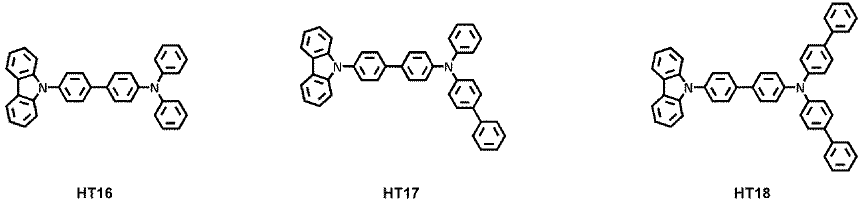

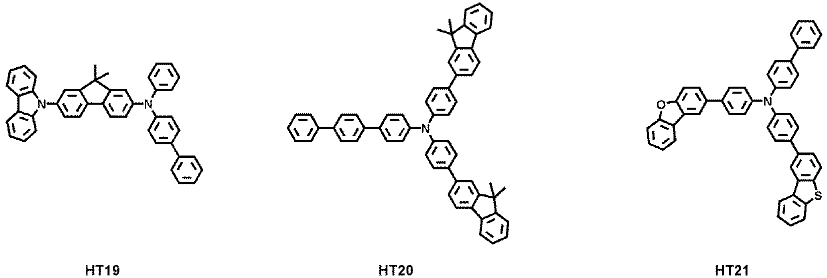

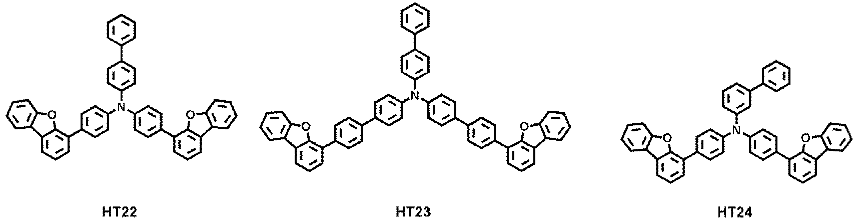

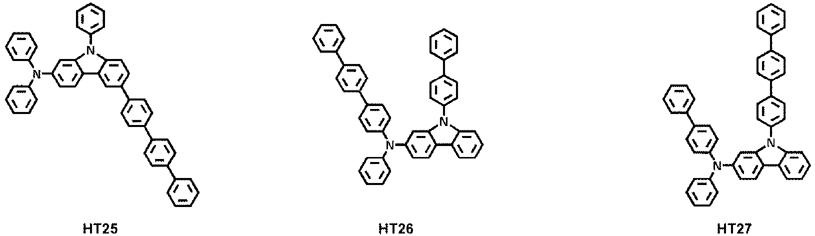

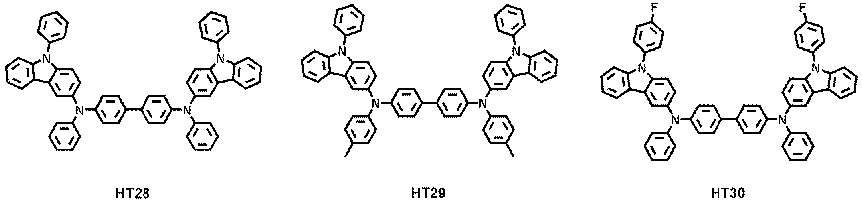

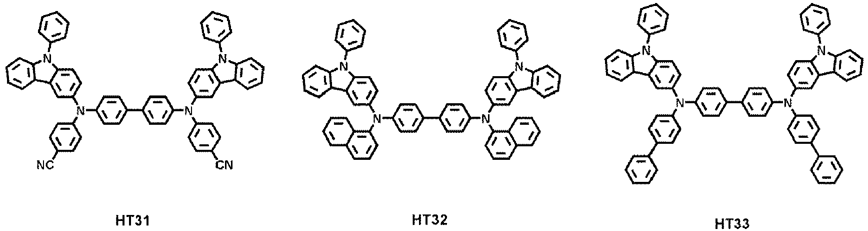

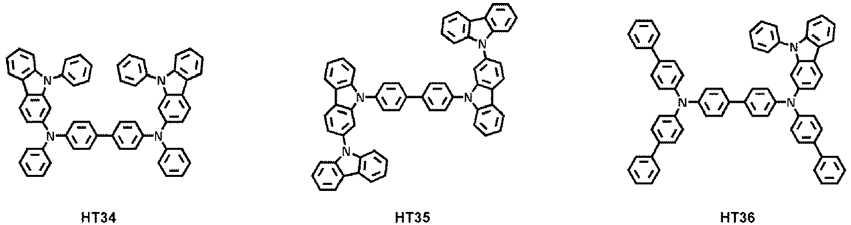

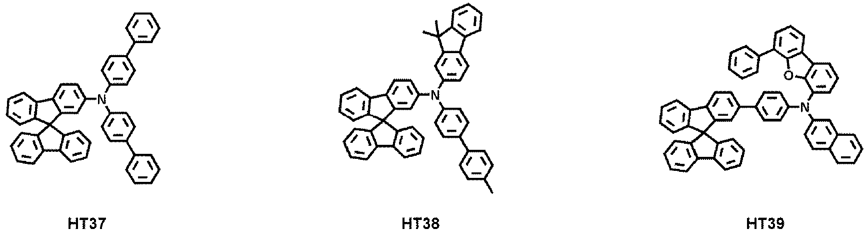

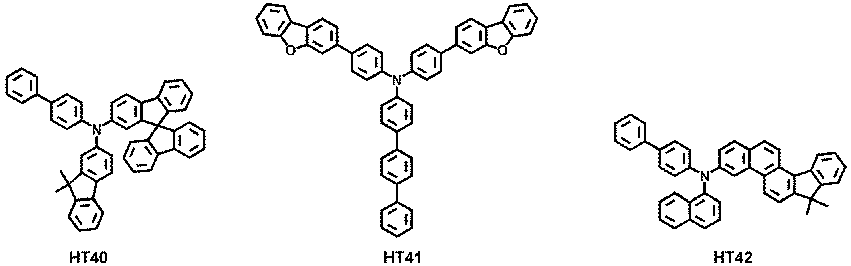

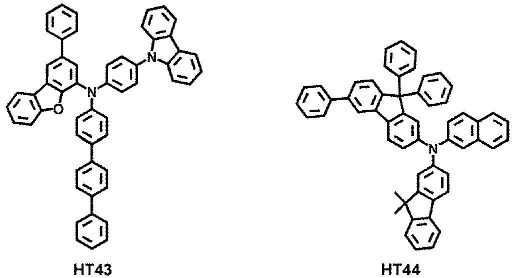

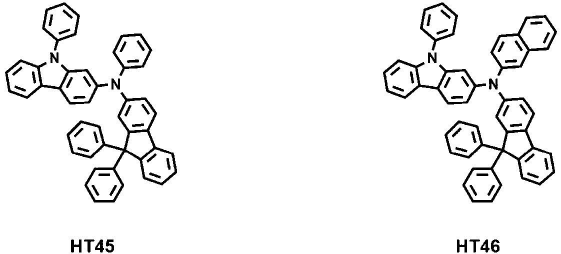

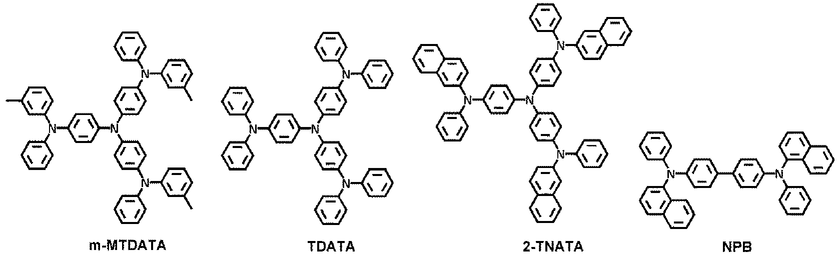

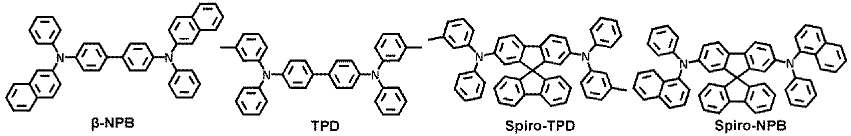

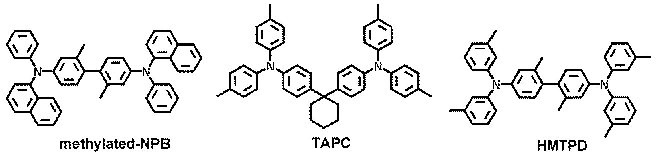

A thickness of the hole transport region may be in a range of about 50 Å to about 10,000 Å, for example, about 100 Å to about 4,000 Å. When the hole transport region includes a hole injection layer, a hole transport layer, or a combination thereof, a thickness of the hole injection layer may be in a range of about 100 Å to about 9,000 Å, for example, about 100 Å to about 1,000 Å, and a thickness of the hole transport layer may be in a range of about 50 Å to about 2,000 Å, for example, about 100 Å to about 1,500 Å. When the thicknesses of the hole transport region, the hole injection layer, and the hole transport layer are within these ranges, satisfactory hole transporting characteristics may be obtained without a substantial increase in driving voltage.

The emission auxiliary layer may increase light-emission efficiency by compensating for an optical resonance distance according to the wavelength of light emitted by the emission layer, and the electron-blocking layer may block the leakage of electrons from the emission layer to the hole transport region. Materials that may be included in the hole transport region may be included in the emission auxiliary layer and the electron-blocking layer.

### [p-dopant]

The hole transport region may further include, in addition to these materials, a charge-generation material for the improvement of conductive properties. The charge-generation material may be uniformly or non-uniformly dispersed in the hole transport region (for example, in the form of a single layer consisting of a charge-generation material).

The charge-generation material may be, for example, a p-dopant.

For example, the p-dopant may have a lowest unoccupied molecular orbital (LUMO) energy level of not more than about -3.5 eV.

In an embodiment, the p-dopant may include a quinone derivative, a cyano group-containing compound, a compound including element EL1 and element EL2, or a combination thereof.

Examples of the quinone derivative are TCNQ, F4-TCNQ, and the like.

Examples of the cyano group-containing compound are HAT-CN, a compound represented by Formula 221, and the like: 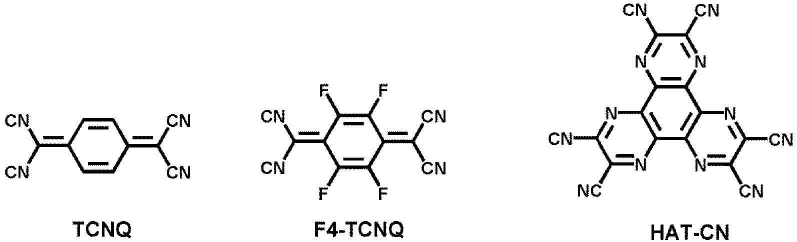 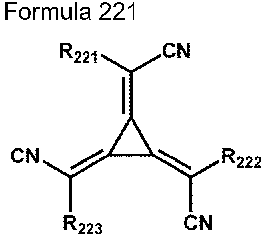
wherein, in Formula 221,
R₂₂₁ to R₂₂₃ may each independently be a C₃-C₆₀ carbocyclic group that is unsubstituted or substituted with at least one R₁₀ₐ or a C₁-C₆₀ heterocyclic group that is unsubstituted or substituted with at least one R₁₀ₐ, and
at least one of R₂₂₁ to R₂₂₃ may each independently be a C₃-C₆₀ carbocyclic group or a C₁-C₆₀ heterocyclic group, each substituted with: a cyano group; -F; -Cl; -Br; -I; a C₁-C₂₀ alkyl group substituted with a cyano group, -F, -Cl, -Br, -I, or a combination thereof; or a combination thereof.

In the compound including element EL1 and element EL2, element EL1 may be metal, metalloid, or a combination thereof, and element EL2 may be non-metal, metalloid, or a combination thereof.

Examples of the metal are: alkali metal (e.g., lithium (Li), sodium (Na), potassium (K), rubidium (Rb), cesium (Cs), etc.); alkaline earth metal (e.g., beryllium (Be), magnesium (Mg), calcium (Ca), strontium (Sr), barium (Ba), etc.); transition metal (e.g., titanium (Ti), zirconium (Zr), hafnium (Hf), vanadium (V), niobium (Nb), tantalum (Ta), chromium (Cr), molybdenum (Mo), tungsten (W), manganese (Mn), technetium (Tc), rhenium (Re), iron (Fe), ruthenium (Ru), osmium (Os), cobalt (Co), rhodium (Rh), iridium (Ir), nickel (Ni), palladium (Pd), platinum (Pt), copper (Cu), silver (Ag), gold (Au), etc.); post-transition metal (e.g., zinc (Zn), indium (In), tin (Sn), etc.); lanthanide metal (e.g., lanthanum (La), cerium (Ce), praseodymium (Pr), neodymium (Nd), promethium (Pm), samarium (Sm), europium (Eu), gadolinium (Gd), terbium (Tb), dysprosium (Dy), holmium (Ho), erbium (Er), thulium (Tm), ytterbium (Yb), lutetium (Lu), etc.); and the like.

Examples of the metalloid are silicon (Si), antimony (Sb), tellurium (Te), and the like.

Examples of the non-metal are oxygen (O), halogen (e.g., F, Cl, Br, I, etc.), and the like.

For example, the compound containing element EL1 and element EL2 may include metal oxide, metal halide (e.g., metal fluoride, metal chloride, metal bromide, metal iodide, etc.), metalloid halide (e.g., metalloid fluoride, metalloid chloride, metalloid bromide, metalloid iodide, etc.), metal telluride, or a combination thereof.

Examples of the metal oxide are tungsten oxide (e.g., WO, W₂O₃, WO₂, WO₃, W₂O₅, etc.), vanadium oxide (e.g., VO, V₂O₃, VO₂, V₂O₅, etc.), molybdenum oxide (e.g., MoO, Mo₂O₃, MoO₂, MoO₃, Mo₂O₅, etc.), rhenium oxide (e.g., ReO₃, etc.), and the like.

Examples of the metal halide are alkali metal halide, alkaline earth metal halide, transition metal halide, post-transition metal halide, lanthanide metal halide, and the like.

Examples of the alkali metal halide are LiF, NaF, KF, RbF, CsF, LiCl, NaCl, KCI, RbCl, CsCl, LiBr, NaBr, KBr, RbBr, CsBr, Lil, Nal, KI, Rbl, Csl, and the like.

Examples of the alkaline earth metal halide are BeF₂, MgF₂, CaF₂, SrF₂, BaF₂, BeCl₂, MgCl₂, CaCl₂, SrCl₂, BaCl₂, BeBr₂, MgBr₂, CaBr₂, SrBr₂, BaBr₂, BeI₂, MgI₂, CaI₂, SrI₂, BaI₂, and the like.

Examples of the transition metal halide are titanium halide (e.g., TiF₄, TiCl₄, TiBr₄, TiI₄, etc.), zirconium halide (e.g., ZrF₄, ZrCl₄, ZrBr₄, ZrI₄, etc.), hafnium halide (e.g., HfF₄, HfCl₄, HfBr₄, HfI₄, etc.), vanadium halide (e.g., VF₃, VCl₃, VBr₃, VI₃, etc.), niobium halide (e.g., NbF₃, NbCl₃, NbBr₃, Nbl₃, etc.), tantalum halide (e.g., TaF₃, TaCl₃, TaBr₃, TaI₃, etc.), chromium halide (e.g., CrF₃, CrCl₃, CrBr₃, CrI₃, etc.), molybdenum halide (e.g., MoF₃, MoCl₃, MoBr₃, MoI₃, etc.), tungsten halide (e.g., WF3, WCl₃, WBr₃, WI₃, etc.), manganese halide (e.g., MnF₂, MnCl₂, MnBr₂, MnI₂, etc.), technetium halide (e.g., TcF₂, TcCl₂, TcBr₂, TcI₂, etc.), rhenium halide (e.g., ReF₂, ReCl₂, ReBr₂, ReI₂, etc.), iron halide (e.g., FeF₂, FeCl₂, FeBr₂, FeI₂, etc.), ruthenium halide (e.g., RuF₂, RuCl₂, RuBr₂, RuI₂, etc.), osmium halide (e.g., OsF₂, OsCl₂, OsBr₂, OsI₂, etc.), cobalt halide (e.g., CoF₂, CoCl₂, CoBr₂, CoI₂, etc.), rhodium halide (e.g., RhF₂, RhCl₂, RhBr₂, RhI₂, etc.), iridium halide (e.g., IrF₂, IrCl₂, IrBr₂, IrI₂, etc.), nickel halide (e.g., NiF₂, NiCl₂, NiBr₂, NiI₂, etc.), palladium halide (e.g., PdF₂, PdCl₂, PdBr₂, PdI₂, etc.), platinum halide (e.g., PtF₂, PtCl₂, PtBr₂, PtI₂, etc.), copper halide (e.g., CuF, CuCl, CuBr, Cul, etc.), silver halide (e.g., AgF, AgCl, AgBr, AgI, etc.), gold halide (e.g., AuF, AuCl, AuBr, Aul, etc.), and the like.

Examples of the post-transition metal halide are zinc halide (e.g., ZnF₂, ZnCl₂, ZnBr₂, ZnI₂, etc.), indium halide (e.g., InI₃, etc.), tin halide (e.g., SnI₂, etc.), and the like.

Examples of the lanthanide metal halide are YbF, YbF₂, YbF₃, SmF₃, YbCl, YbCl₂, YbCls, SmCl₃, YbBr, YbBr₂, YbBr₃, SmBr₃, Ybl, YbI₂, YbI₃, SmI₃, and the like.

Examples of the metalloid halide are antimony halide (e.g., SbCl₅, etc.) and the like.

Examples of the metal telluride are alkali metal telluride (e.g., Li₂Te, Na₂Te, K₂Te, Rb₂Te, Cs₂Te, etc.), alkaline earth metal telluride (e.g., BeTe, MgTe, CaTe, SrTe, BaTe, etc.), transition metal telluride (e.g., TiTe₂, ZrTe₂, HfTe₂, V₂Te₃, Nb₂Te₃, Ta₂Te₃, Cr₂Te₃, Mo₂Te₃, W₂Te₃, MnTe, TcTe, ReTe, FeTe, RuTe, OsTe, CoTe, RhTe, IrTe, NiTe, PdTe, PtTe, Cu₂Te, CuTe, Ag₂Te, AgTe, Au₂Te, etc.), post-transition metal telluride (e.g., ZnTe, etc.), lanthanide metal telluride (e.g., LaTe, CeTe, PrTe, NdTe, PmTe, EuTe, GdTe, TbTe, DyTe, HoTe, ErTe, TmTe, YbTe, LuTe, etc.), and the like.

### [Emission layer in interlayer 130]

When the light-emitting device 10 is a full-color light-emitting device, the emission layer may be patterned into a red emission layer, a green emission layer, and/or a blue emission layer, according to a sub-pixel. In an embodiment, the emission layer may have a stacked structure of two or more layers of a red emission layer, a green emission layer, and a blue emission layer, in which the two or more layers contact each other or are separated from each other, to emit white light. In one or more embodiments, the emission layer may include two or more materials of a red light-emitting material, a green light-emitting material, and a blue light-emitting material, in which the two or more materials are mixed with each other in a single layer, to emit white light.

In an embodiment, the emission layer may include a host and a dopant (or emitter). In an embodiment, the emission layer may further include an auxiliary dopant that promotes energy transfer to a dopant (or emitter), in addition to the host and the dopant (or emitter). When the emission layer includes the dopant (or emitter) and the auxiliary dopant, the dopant (or emitter) and the auxiliary dopant are different from each other.

An content (weight) of the dopant (or emitter) in the emission layer may be in a range of about 0.01 parts by weight to about 15 parts by weight based on 100 parts by weight of the host.

In one or more embodiments, the emission layer may include a quantum dot.

In one or more embodiments, the emission layer may include a delayed fluorescence material. The delayed fluorescence material may act as a host or a dopant in the emission layer 120.

The thickness of the emission layer may be in a range of about 100 Å to about 1,000 Å, for example, about 200 Å to about 600 A. When the thickness of the emission layer 15 is within these ranges, excellent luminescence characteristics may be obtained without a substantial increase in driving voltage.

### [Host]

In an embodiment, the host may include a compound represented by Formula 301:

Formula 301 [Ar₃₀₁]_{xb11}-[(L₃₀₁)_{xb1}-R₃₀₁]_{xb21}

wherein, in Formula 301,
Ar₃₀₁ and L₃₀₁ may each independently be a C₃-C₆₀ carbocyclic group that is unsubstituted or substituted with at least one R₁₀ₐ or a C₁-C₆₀ heterocyclic group that is unsubstituted or substituted with at least one R₁₀ₐ,
xb11 may be 1, 2, or 3,
xb1 may be an integer from 0 to 5,
R₃₀₁ may be hydrogen, deuterium, -F, -Cl, -Br, -I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ,-Si(Q₃₀₁)(Q₃₀₂)(Q₃₀₃), -N(Q₃₀₁)(Q₃₀₂), -B(Q₃₀₁)(Q₃₀₂), -C(=O)(Q₃₀₁), -S(=O)₂(Q₃₀₁), or - P(=O)(Q₃₀₁)(Q₃₀₂),
xb21 may be an integer from 1 to 5, and
Q₃₀₁ to Q₃₀₃ may each be the same as described in connection with Q1.

For example, when xb11 in Formula 301 is not less than 2, two or more of Ar₃₀₁ may be linked to each other via a single bond.

In one or more embodiments, the host may include a compound represented by Formula 301-1, a compound represented by Formula 301-2, or a combination thereof:

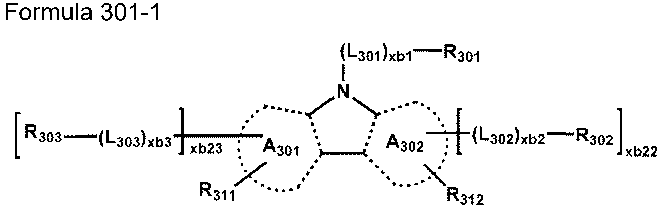

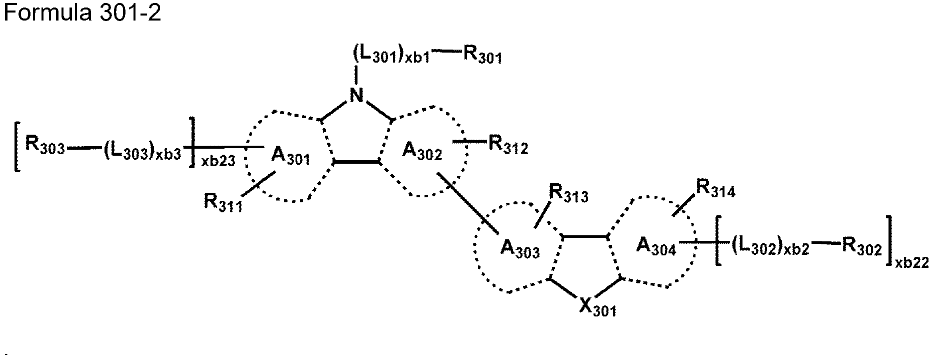

In Formulae 301-1 and 301-2,
ring A₃₀₁ to ring A₃₀₄ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
X₃₀₁ may be O, S, N-[(L₃₀₄)_{xb4}-R₃₀₄], C(R₃₀₄)(R₃₀₅), or Si(R₃₀₄)(R₃₀₅),
xb22 and xb23 may each independently be 0, 1, or 2,
L₃₀₁, xb1, and R₃₀₁ may each be the same as described herein,
L₃₀₂ to L₃₀₄ may each independently be the same as described in connection with L₃₀₁,
xb2 to xb4 may each independently be the same as described in connection with xb1, and
R₃₀₂ to R₃₀₅ and R₃₁₁ to R₃₁₄ may each be the same as described in connection with R₃₀₁.

In one or more embodiments, the host may include an alkali earth metal complex, a post-transition metal complex, or a combination thereof. In one or more embodiments, the host may include a Be complex (e.g., Compound H55), an Mg complex, a Zn complex, or a combination thereof.

In one or more embodiments, the host may include: one of Compounds H1 to H128; 9,10-di(2-naphthyl)anthracene (ADN); 2-methyl-9,10-bis(naphthalen-2-yl)anthracene (MADN); 9,10-di(2-naphthyl)-2-t-butyl-anthracene (TBADN); 4,4'-bis(N-carbazolyl)-1,1'-biphenyl (CBP); 1,3-di-9-carbazolylbenzene (mCP); 1,3,5-tri(carbazol-9-yl)benzene (TCP); or any combination thereof:

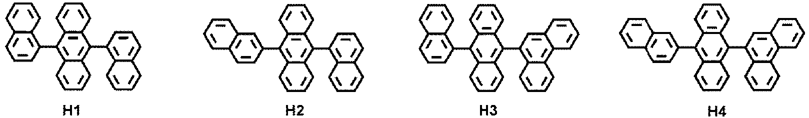

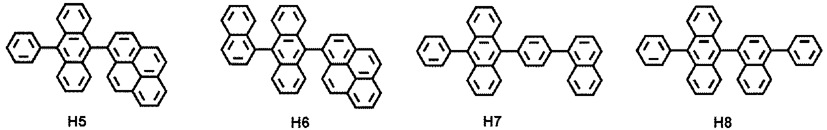

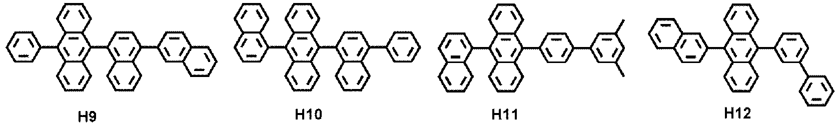

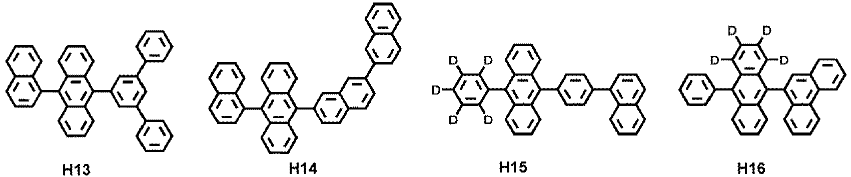

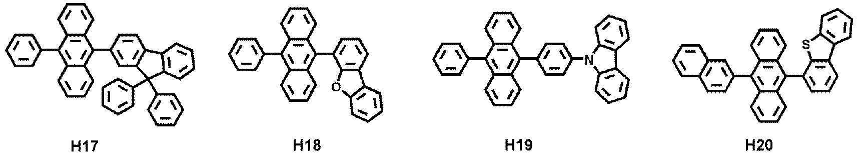

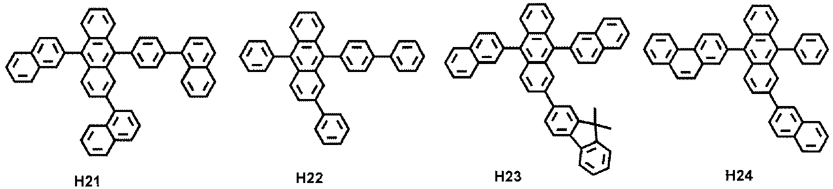

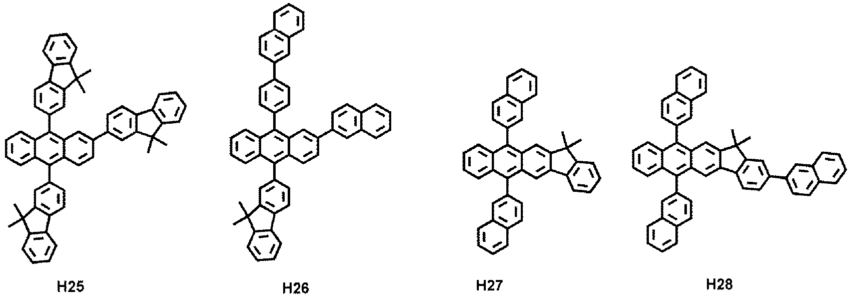

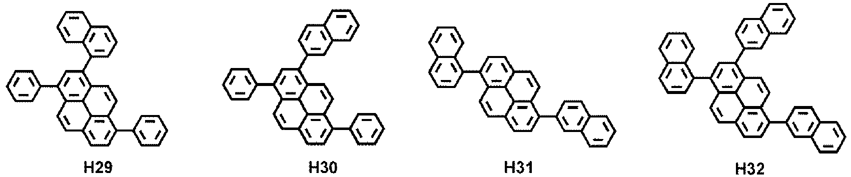

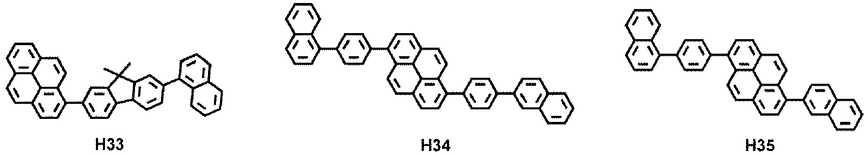

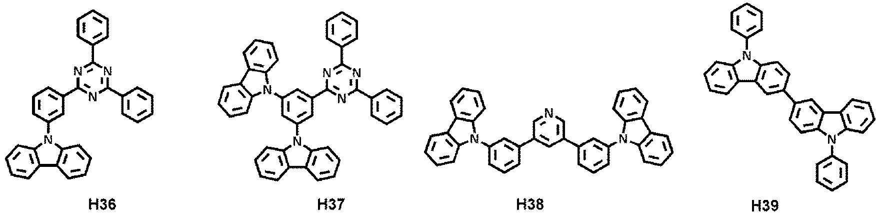

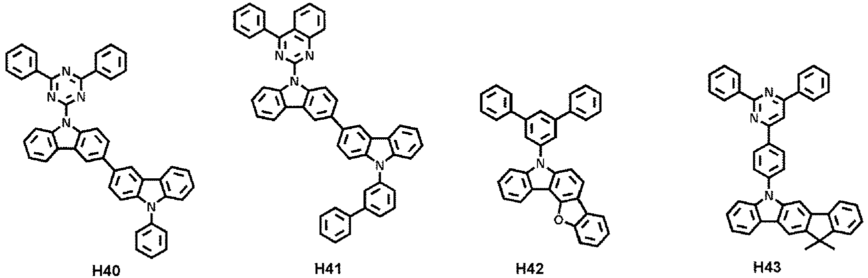

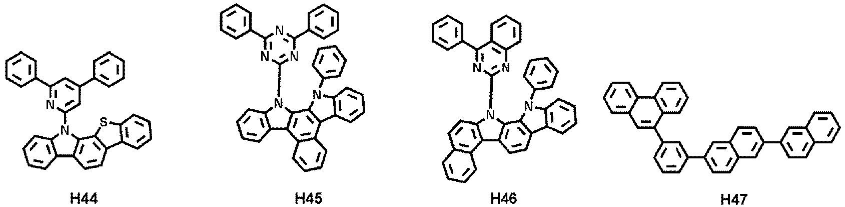

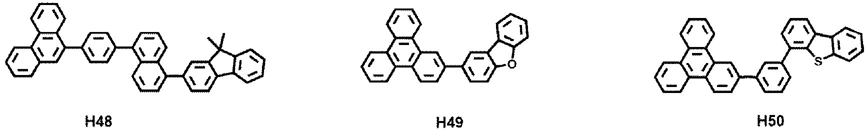

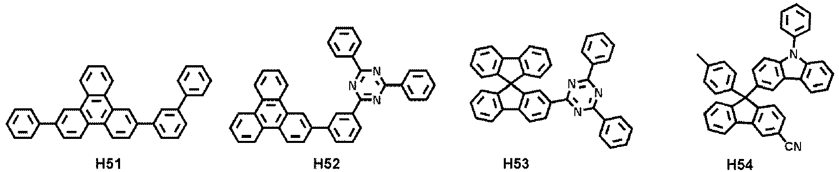

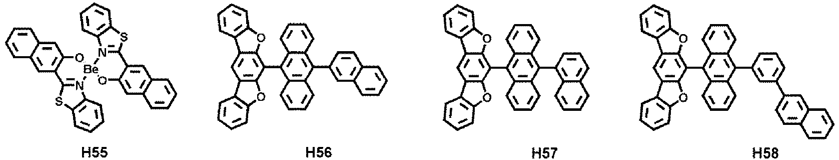

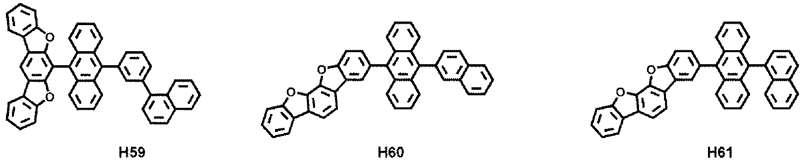

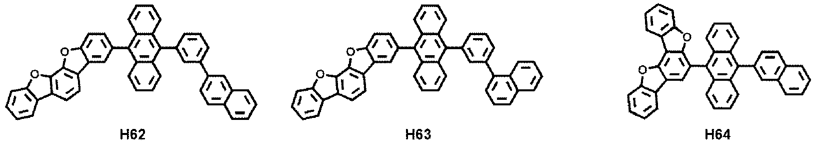

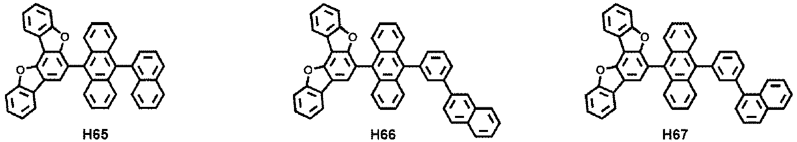

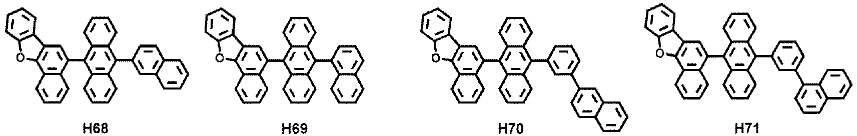

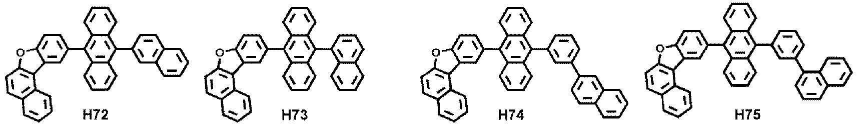

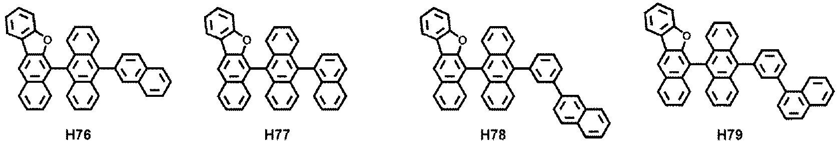

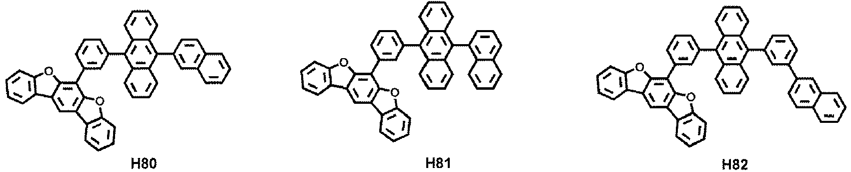

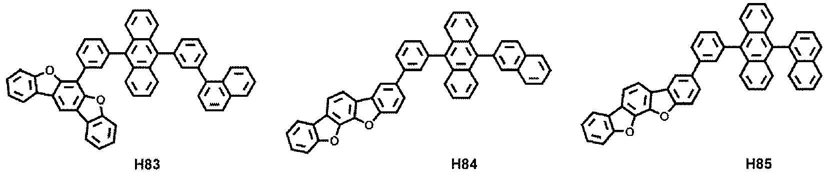

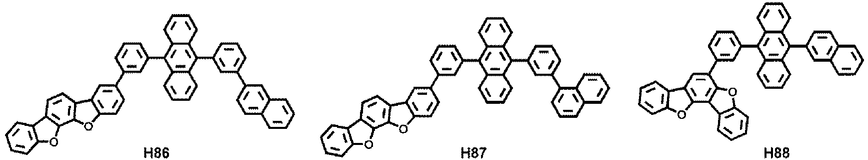

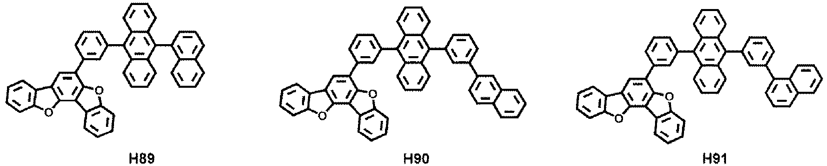

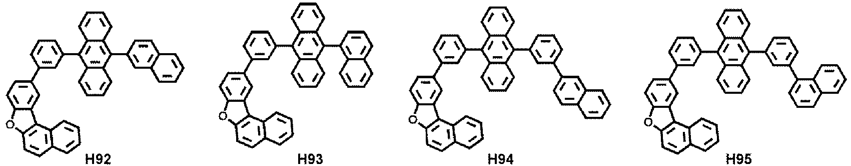

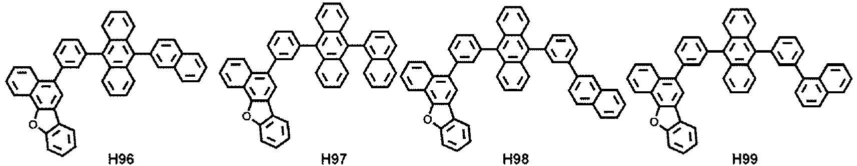

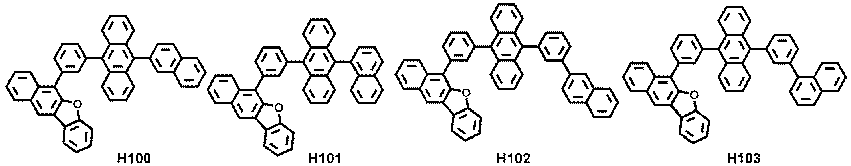

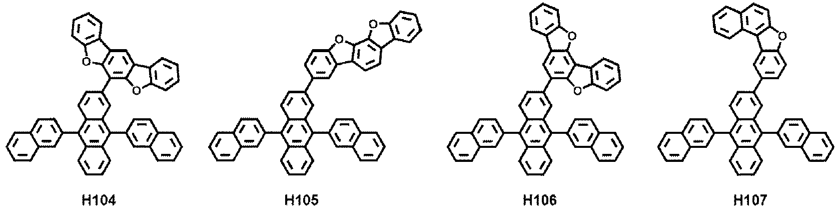

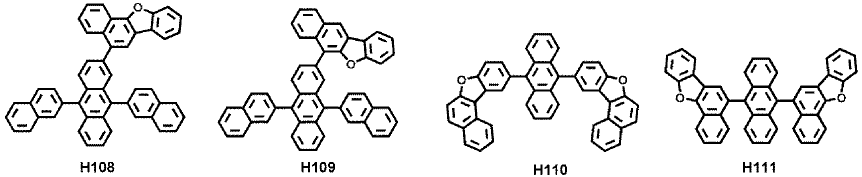

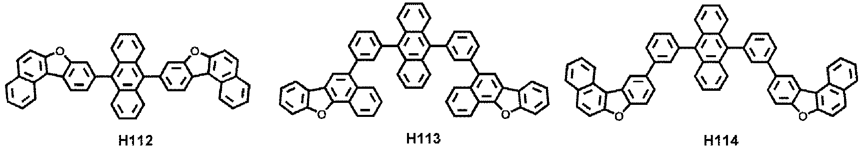

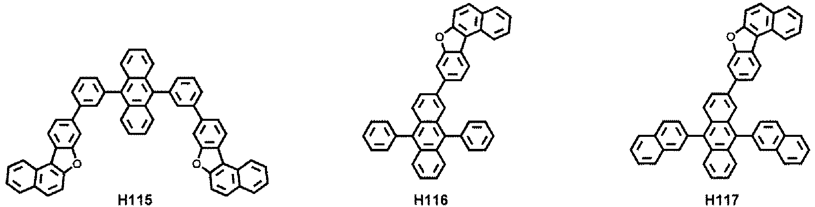

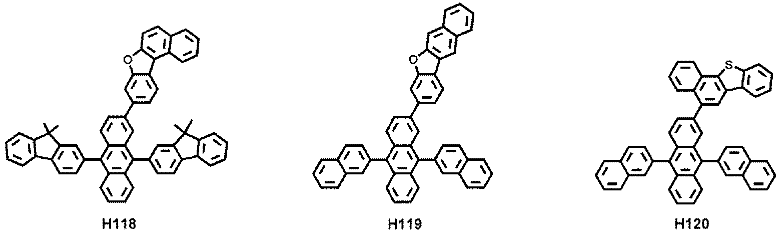

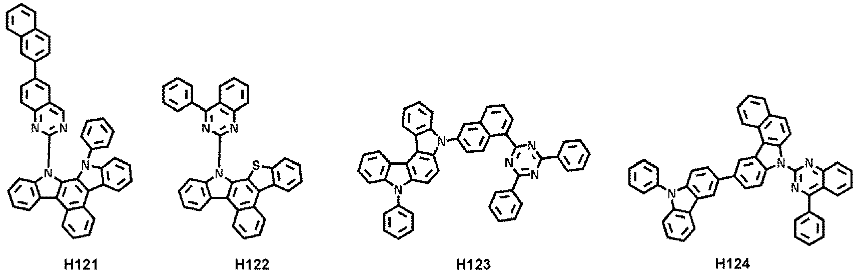

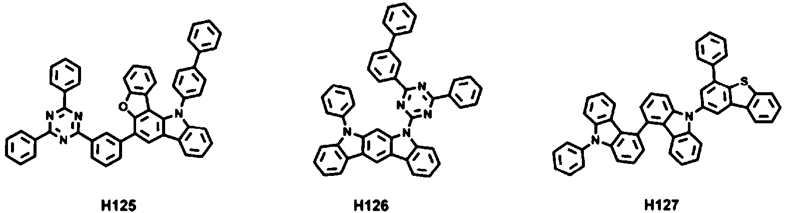

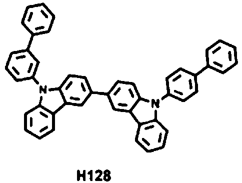

In one or more embodiments, the host may include a silicon-containing compound, a phosphine oxide-containing compound, or a combination thereof.

The host may have various modifications. For example, the host may include only one kind of compound, or may include two or more kinds of different compounds.

### [Phosphorescent dopant]

The emission layer may include a phosphorescent dopant.

The phosphorescent dopant may include at least one transition metal as a central metal.

The phosphorescent dopant may include a monodentate ligand, a bidentate ligand, a tridentate ligand, a tetradentate ligand, a pentadentate ligand, a hexadentate ligand, or a combination thereof.

The phosphorescent dopant may be electrically neutral.

For example, the phosphorescent dopant may include an organometallic compound represented by Formula 401:

Formula 401 M(L₄₀₁)_{xc1}(L₄₀₂)_{xc2}

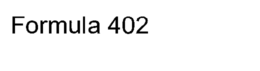

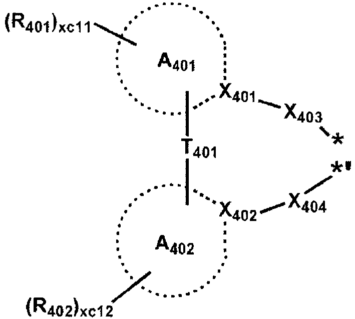

wherein, in Formulae 401 and 402,
M may be a transition metal (e.g., iridium (Ir), platinum (Pt), palladium (Pd), osmium (Os), titanium (Ti), gold (Au), hafnium (Hf), europium (Eu), terbium (Tb), rhodium (Rh), rhenium (Re), or thulium (Tm)),
L₄₀₁ may be a ligand represented by Formula 402, and xc1 may be 1, 2, or 3, wherein, when xc1 is not less than 2, two or more of L₄₀₁ may be identical to or different from each other,
L₄₀₂ may be an organic ligand, and xc2 may be 0, 1, 2, 3, or 4, wherein, when xc2 is not less than 2, two or more of L₄₀₂ may be identical to or different from each other,
X₄₀₁ and X₄₀₂ may each independently be N or C,
ring A₄₀₁ and ring A₄₀₂ may each independently be a C₃-C₆₀ carbocyclic group or a C₁-C₆₀ heterocyclic group,
T₄₀₁ may be a single bond, *-O-*', *-S-*', *-C(=O)-*', *-N(Q₄₁₁)-*', *-C(Q₄₁₁)(Q₄₁₂)-*', *-C(Q₄₁₁)=C(Q₄₁₂)-*', *-C(Q₄₁₁)=*', or *=C(Q₄₁₁)=*',
X₄₀₃ and X₄₀₄ may each independently be a chemical bond (e.g., a covalent bond or a coordination bond), O, S, N(Q₄₁₃), B(Q₄₁₃), P(Q₄₁₃), C(Q₄₁₃)(Q₄₁₄), or Si(Q₄₁₃)(Q₄₁₄),
Q₄₁₁ to Q₄₁₄ may each be the same as described in connection with Q₁,
R₄₀₁ and R₄₀₂ may each independently be hydrogen, deuterium, -F, -CI, -Br, -I, a hydroxyl group, a cyano group, a nitro group, a C₁-C₂₀ alkyl group unsubstituted or substituted with at least one R₁₀ₐ, a C₁-C₂₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, -Si(Q₄₀₁)(Q₄₀₂)(Q₄₀₃), -N(Q₄₀₁)(Q₄₀₂), -B(Q₄₀₁)(Q₄₀₂), -C(=O)(Q₄₀₁), -S(=O)₂(Q₄₀₁), or -P(=O)(Q₄₀₁)(Q₄₀₂),
Q₄₀₁ to Q₄₀₃ may each be the same as described in connection with Q₁,
xc11 and xc12 may each independently be an integer from 0 to 10, and
* and *' in Formula 402 each indicate a binding site to M in Formula 401.

For example, in Formula 402, i) X₄₀₁ may be nitrogen and X₄₀₂ may be carbon, or ii) each of X₄₀₁ and X₄₀₂ may be nitrogen.

In an embodiment, when xc1 in Formula 401 is not less than 2, two ring A₄₀₁(s) among two or more of L₄₀₁ may optionally be linked to each other via T₄₀₂, which is a linking group, and two ring A₄₀₂(s) among two or more of L₄₀₁ may optionally be linked to each other via T₄₀₃, which is a linking group (see Compounds PD1 to PD4 and PD7). T₄₀₂ and T₄₀₃ may each be the same as described in connection with T₄₀₁.

L₄₀₂ in Formula 401 may be an organic ligand. For example, L₄₀₂ may include a halogen group, a diketone group (e.g., an acetylacetonate group), a carboxylic acid group (e.g., a picolinate group), -C(=O), an isonitrile group, -CN group, a phosphorus group (e.g., a phosphine group, a phosphite group, etc.), or a combination thereof.

The phosphorescent dopant may include, for example, one of Compounds PD1 to PD39, or a combination thereof:

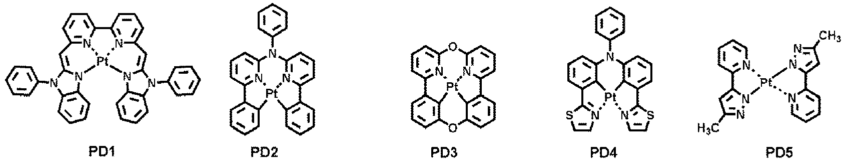

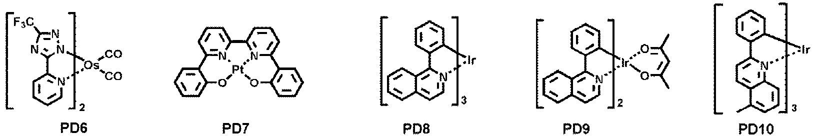

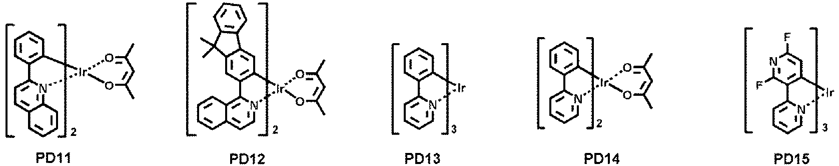

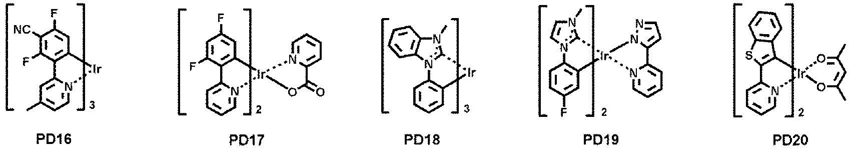

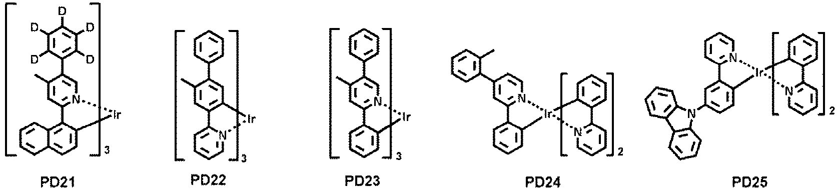

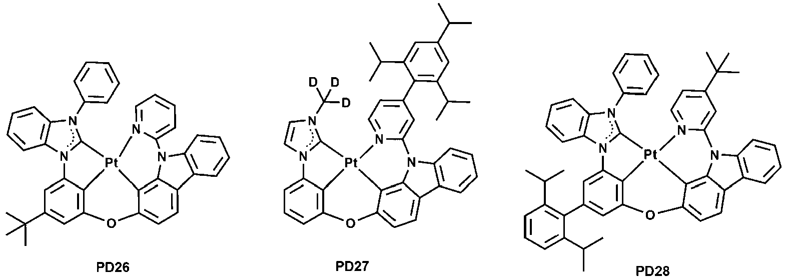

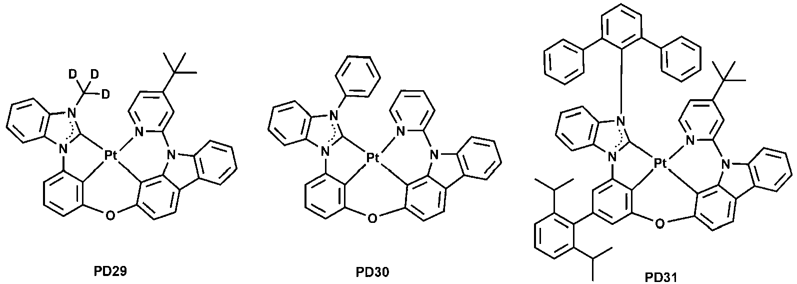

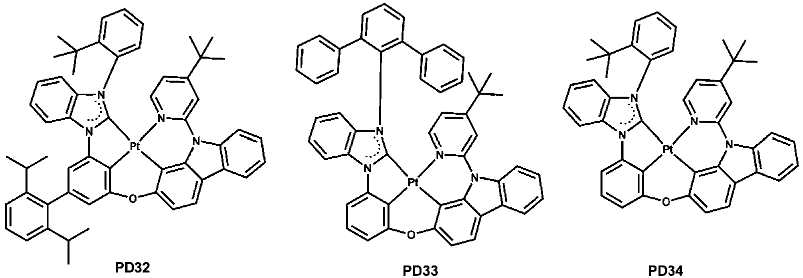

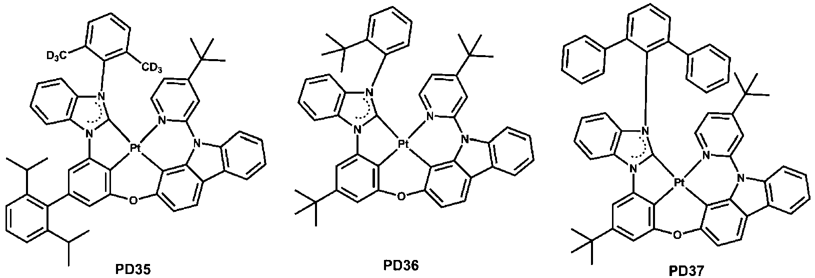

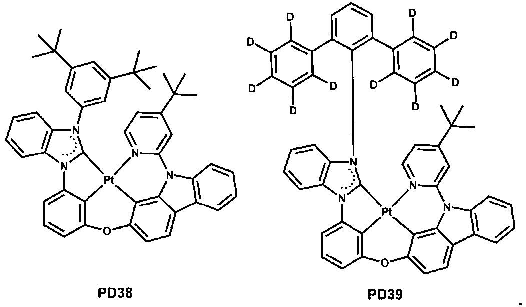

### [Fluorescent dopant]

The emission layer may include a fluorescent dopant and/or an auxiliary dopant.

For example, the fluorescent dopant and/or auxiliary dopant may each independently include a compound represented by Formula 501: 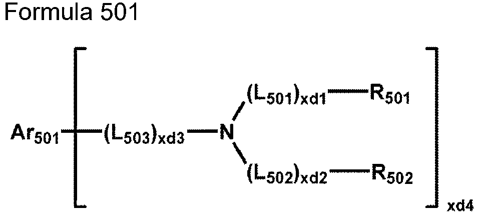
wherein, in Formula 501,
Ar₅₀₁, L₅₀₁ to L₅₀₃, R₅₀₁, and R₅₀₂ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
xd1 to xd3 may each independently be 0, 1, 2, or 3, and
xd4 may be 1, 2, 3, 4, 5, or 6.

For example, Ar₅₀₁ in Formula 501 may be a condensed cyclic group (e.g., an anthracene group, a chrysene group, a pyrene group, etc.) in which three or more monocyclic groups are condensed together.

In an embodiment, xd4 in Formula 501 may be 2.

For example, the fluorescent dopant and the auxiliary dopant may each include one of Compounds FD1 to FD37, DPVBi, DPAVBi, or a combination thereof:

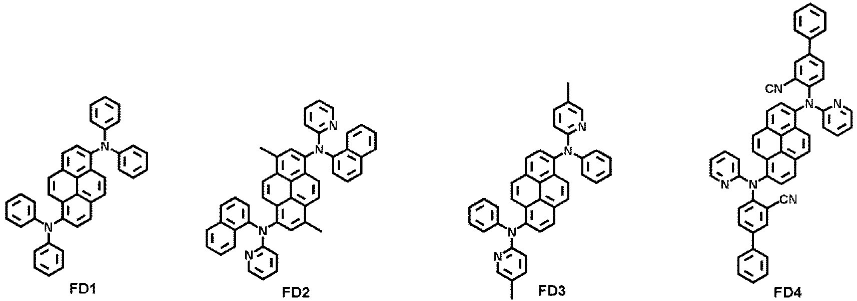

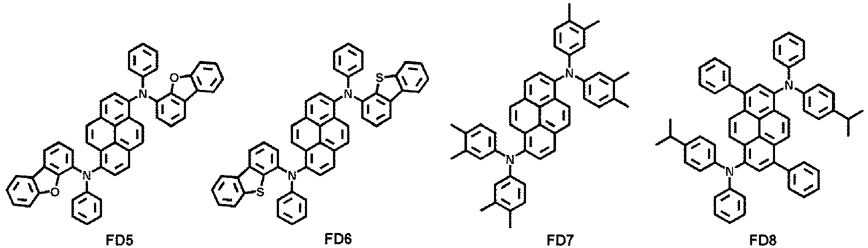

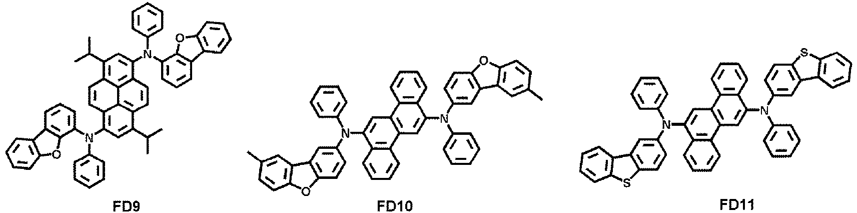

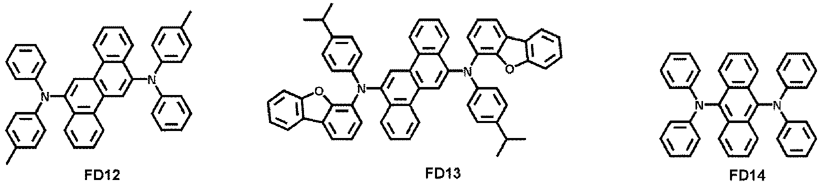

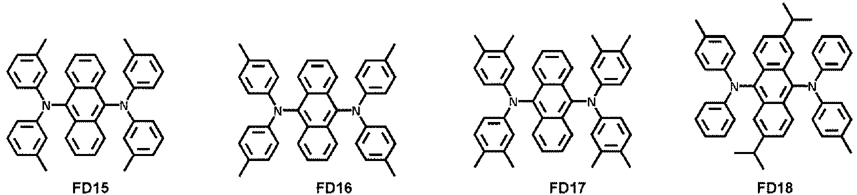

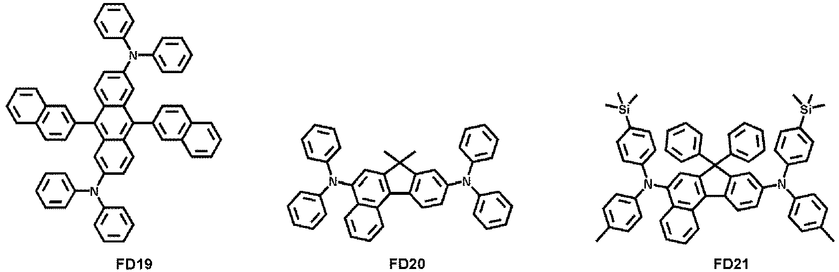

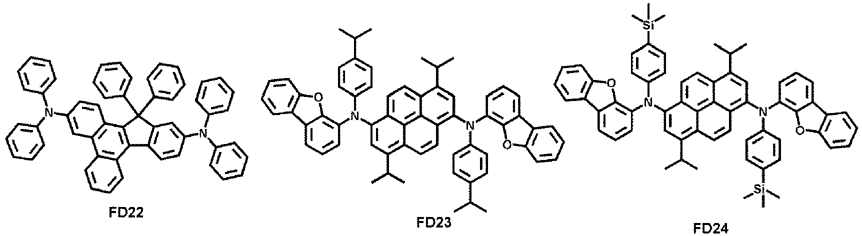

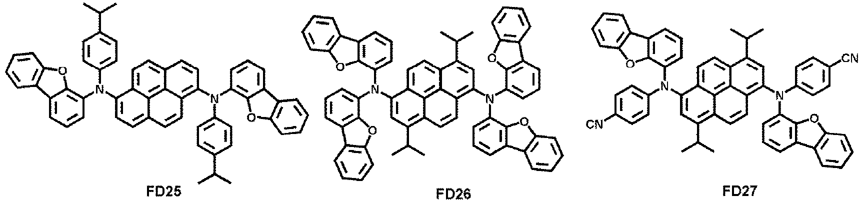

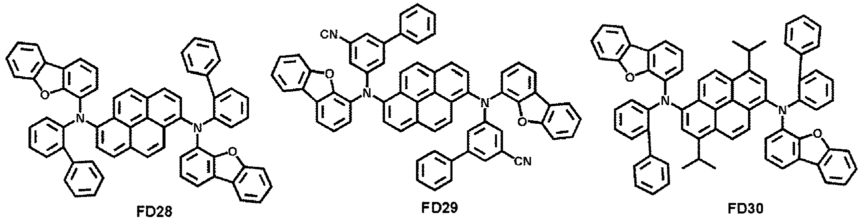

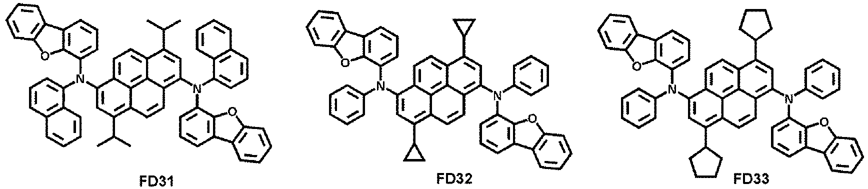

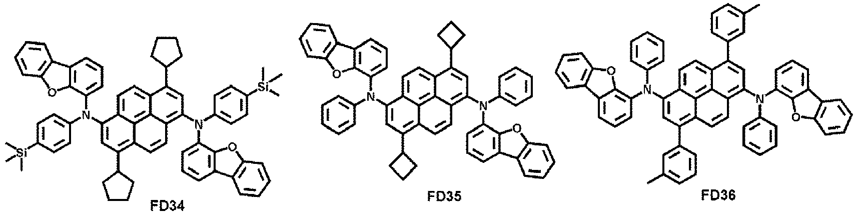

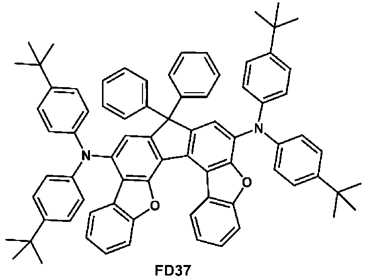

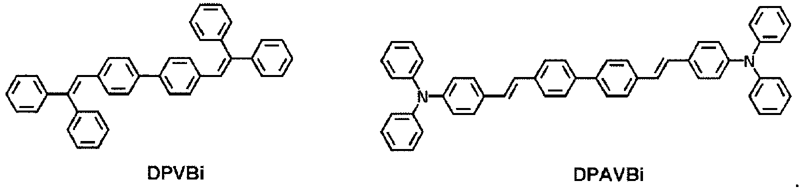

### [Delayed fluorescence material]

The emission layer may include a delayed fluorescence material.

The delayed fluorescence material used herein may be selected from compounds capable of emitting delayed fluorescence based on a delayed fluorescence emission mechanism.

The delayed fluorescence material included in the emission layer may act as a host or a dopant depending on the type of other materials included in the emission layer.

In an embodiment, a difference between a triplet energy level (eV) of the delayed fluorescence material and the singlet energy level (eV) of the delayed fluorescence material may be not less than 0 eV and not more than 0.5 eV. When the difference between the triplet energy level (eV) of the delayed fluorescence material and the singlet energy level (eV) of the delayed fluorescence material is satisfied within the range above, up-conversion from the triplet state to the singlet state of the delayed fluorescence materials may effectively occur, and thus, the light-emitting device 10 may have improved luminescence efficiency.

For example, the delayed fluorescence material may include i) a material including at least one electron donor (e.g., a π electron-rich C₃-C₆₀ cyclic group, such as a carbazole group, etc.) and at least one electron acceptor (e.g., a sulfoxide group, a cyano group, a π electron-deficient nitrogen-containing C₁-C₆₀ cyclic group, etc.), and ii) a material including a C₈-C₆₀ polycyclic group in which two or more cyclic groups are condensed while sharing boron (B).

Examples of the delayed fluorescence material may include at least one of Compounds DF1 to DF14:

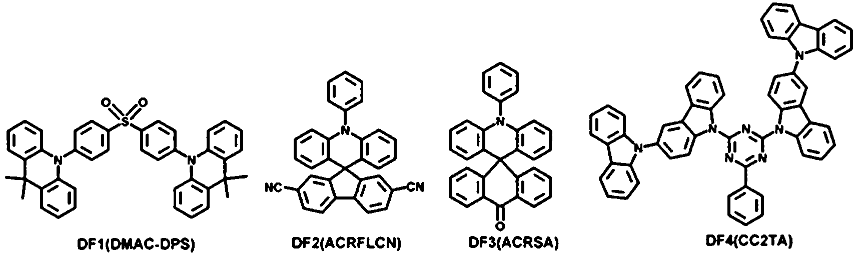

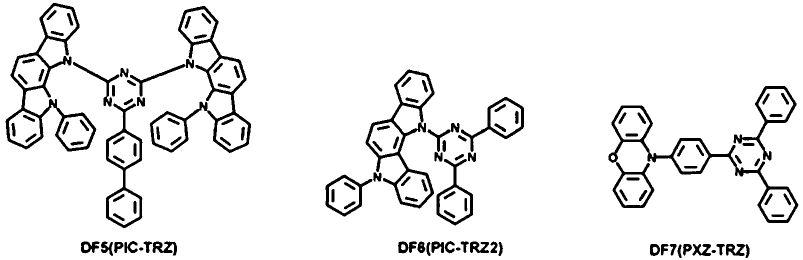

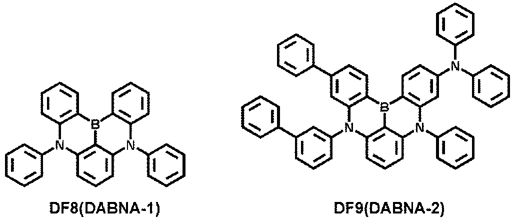

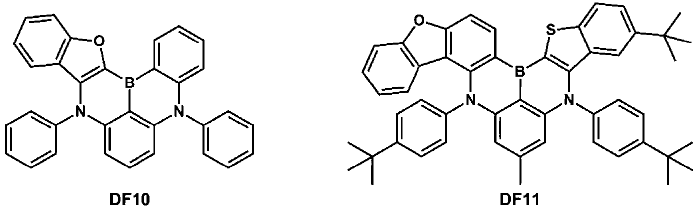

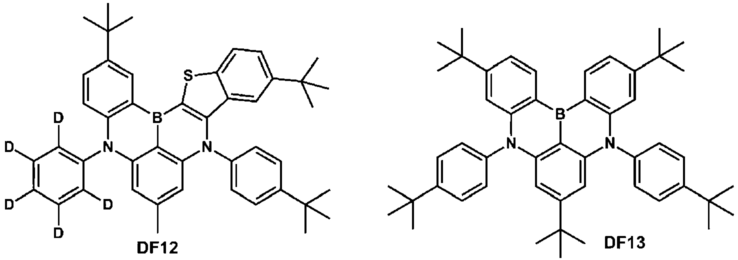

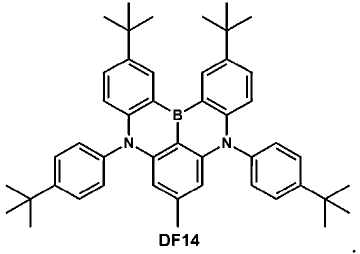

### [Quantum dot]

The emission layer may include quantum dots.

The term "quantum dot" as used herein refers to a crystal of a semiconductor compound, and may include any material capable of emitting light of various emission wavelengths according to the size of the crystal. The quantum dot may emit light of various light emission wavelengths by adjusting the element ratio in the quantum dot compound.

A diameter of the quantum dots may be, for example, in a range of about 1 nm to about 10 nm.

The quantum dots may be synthesized by a wet chemical process, a metal organic chemical vapor deposition process, a molecular beam epitaxy process, or any process similar thereto.

The wet chemical process is a method including mixing a precursor material with an organic solvent and then growing quantum dot particle crystals. When the crystals grow, the organic solvent naturally acts as a dispersant coordinated on the surface of the quantum dot crystals and controls the growth of the crystals so that the growth of quantum dot particles may be controlled through a process which costs lower and is easier than vapor deposition methods, such as metal organic chemical vapor deposition (MOCVD) or molecular beam epitaxy (MBE).

The quantum dots may include: a Group II-Group VI semiconductor compound; a Group III-Group V semiconductor compound; a Group III-Group VI semiconductor compound; a Group I-Group III-Group VI semiconductor compound; a Group IV-Group VI semiconductor compound; a Group IV element or compound; or a combination thereof.

Examples of the Group II-Group VI semiconductor compound may include: a binary compound, such as CdS, CdSe, CdTe, ZnS, ZnSe, ZnTe, ZnO, HgS, HgSe, HgTe, MgSe, MgS, etc.; a ternary compound, such as CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, HgZnTe, MgZnSe, MgZnS, etc.; a quaternary compound, such as CdZnSeS, CdZnSeTe, CdZnSTe, CdHgSeS, CdHgSeTe, CdHgSTe, HgZnSeS, HgZnSeTe, HgZnSTe, etc.; or a combination thereof.

Examples of the Group III-Group V semiconductor compound are: a binary compound, such as GaN, GaP, GaAs, GaSb, AIN, AIP, AIAs, AlSb, InN, InP, InAs, InSb, or the like; a ternary compound, such as GaNP, GaNAs, GaNSb, GaPAs, GaPSb, AINP, AINAs, AINSb, AIPAs, AIPSb, InGaP, InNP, InAIP, InNAs, InNSb, InPAs, InPSb, GaAINP, or the like; a quaternary compound, such as GaAINAs, GaAINSb, GaAIPAs, GaAIPSb, GaInNP, GalnNAs, GalnNSb, GaInPAs, GaInPSb, InAINP, InAINAs, InAINSb, InAIPAs, InAIPSb, or the like; or a combination thereof. Meanwhile, the Group III-Group V semiconductor compound may further include a Group II element. Examples of the Group III-Group V semiconductor compound further including a Group II element may include InZnP, InGaZnP, InAIZnP, etc.

Examples of the Group III-Group VI semiconductor compound may include: a binary compound, such as GaS, GaSe, Ga₂Se₃, GaTe, InS, InSe, In₂S₃, In₂Se₃, InTe, etc.; a ternary compound, such as InGaS₃, InGaSe₃, etc.; or a combination thereof.

Examples of the Group I-Group III-Group VI semiconductor compound include a ternary compound such as AgInS, AgInS₂, AgInSe₂, AgGaS, AgGaS₂, AgGaSe₂, CuInS, CuInS₂, CuInSe₂, CuGaS₂, CuGaSe₂, CuGaO₂, AgGaO₂, AgAIO₂, and the like; a quaternary compound such as AgInGaS₂, AgInGaSe₂, and the like; or a combination thereof.

Examples of the Group IV-Group VI semiconductor compound may include: a binary compound, such as SnS, SnSe, SnTe, PbS, PbSe, or PbTe; a ternary compound, such as SnSeS, SnSeTe, SnSTe, PbSeS, PbSeTe, PbSTe, SnPbS, SnPbSe, SnPbTe, etc.; a quaternary compound, such as SnPbSSe, SnPbSeTe, SnPbSTe, etc.; or a combination thereof.

The Group IV element or compound may include: a single element compound, such as Si, Ge, etc.; a binary compound, such as SiC, SiGe, etc.; or a combination thereof.

Each element included in a multi-element compound such as the binary compound, the ternary compound, and the quaternary compound may be present at a uniform concentration or non-uniform concentration in a particle. That is, the formula indicates the kinds of elements included in a compound, and the ratio of elements in the compound may vary. For example, AgInGaS₂ may refer to AgInₓGa₁₋ₓS₂ (where x is a real number between 0 and 1).

Meanwhile, the quantum dots may have a single structure in which the concentration of each element in the quantum dots is uniform, or a core-shell dual structure. For example, materials included in the core and materials included in the shell may be different from each other.

The shell of the quantum dots may act as a protective layer that prevents chemical degeneration of the core to maintain semiconductor characteristics, and/or as a charging layer that imparts electrophoretic characteristics to the quantum dots. The shell may be a single layer or a multi-layer. The interface between the core and the shell may have a concentration gradient in which the concentration of an element existing in the shell decreases toward the center of the core.

Examples of the shell of the quantum dots may include: oxides of metal, metalloid, or non-metal, a semiconductor compound: or a combination thereof. Examples of the oxides of metal, metalloid, or non-metal may include: a binary compound, such as SiO₂, Al₂O₃, TiO₂, ZnO, MnO, Mn₂O₃, Mn₃O₄, CuO, FeO, Fe₂O₃, Fe₃O₄, CoO, Co₃O₄, NiO, etc.; a ternary compound, such as MgAl₂O₄, CoFe₂O₄, NiFe₂O₄, CoMn₂O₄, etc.; and a combination thereof. Examples of the semiconductor compound may include: as described above, a Group II-Group VI semiconductor compound; a Group III-Group V semiconductor compound; a Group III-Group VI semiconductor compound; a Group I-Group III-Group VI semiconductor compound; a Group IV-Group VI semiconductor compound; or a combination thereof. For example, the semiconductor compound may include CdS, CdSe, CdTe, ZnS, ZnSe, ZnTe, ZnSeS, ZnTeS, GaAs, GaP, GaSb, HgS, HgSe, HgTe, InAs, InP, InGaP, InSb, AlAs, AlP, AlSb, or a combination thereof.

Each element included in a multi-element compound, such as the binary compound or the ternary compound, may be present at a uniform concentration or non-uniform concentration in a particle. That is, the formula indicates the kinds of elements included in a compound, and the ratio of elements in the compound may vary.

A full width at half maximum (FWHM) of the emission wavelength spectrum of the quantum dots may be not more than about 45 nm, for example, not more than about 40 nm, and for example, not more than reproducibility of the quantum dots may be improved. In addition, since light emitted through the quantum dots is emitted in all directions, the wide viewing angle may be improved.

In addition, the quantum dots may be in the form of a spherical particle, a pyramidal particle, a multi-arm particle, a cubic nanoparticle, a nanotube particle, a nanowire particle, a nanofiber particle, a nanoplate particle, or the like.

Since the energy band gap may be adjusted by controlling the size of the quantum dots, light having various wavelength bands may be obtained from the quantum dot-containing emission layer. Accordingly, by using quantum dots of different sizes, a light-emitting device that emits light of various wavelengths may be implemented. In an embodiment, control of the size of the quantum dot or the ratio of elements within the quantum dot compound may be selected to emit red, green and/or blue light. In addition, the quantum dots may be configured to emit white light by combining light of various colors.

### [Electron transport region in interlayer 130]

The electron transport region may include a metal oxide nanoparticle represented by Formula 1 and/or a nanocomposite including the metal oxide nanoparticle.

The electron transport region may have: i) a single-layer structure consisting of a single layer consisting of a single material, ii) a single-layer structure consisting of a single layer consisting of a plurality of different materials, or iii) a multi-layer structure including a plurality of layers including a plurality of different materials.

The electron transport region may include a buffer layer, a hole-blocking layer, an electron control layer, an electron transport layer, an electron injection layer, or a combination thereof.

For example, the electron transport region may have an electron transport layer/electron injection layer structure, a hole-blocking layer/electron transport layer/electron injection layer structure, an electron control layer/electron transport layer/electron injection layer structure, a buffer layer/electron transport layer/electron injection layer structure, or the like, wherein layers of each structure are sequentially stacked from the emission layer.

The electron transport region (e.g., a buffer layer, a hole-blocking layer, an electron control layer, or an electron transport layer in the electron transport region) may include a metal-free compound including at least one π electron-deficient nitrogen-containing C₁-C₆₀ heterocyclic group.

For example, the electron transport region may include a compound represented by Formula 601:

Formula 601 [Ar₆₀₁]ₓₑ₁₁-[(L₆₀₁)ₓₑ₁-R₆₀₁]ₓₑ₂₁.

wherein, in Formula 601,
Ar₆₀₁ and L₆₀₁ may each independently be a C₃-C₆₀carbocyclic group unsubstituted or substituted with at least one R₁₀ₐ or a C₁-C₆₀ heterocyclic group unsubstituted or substituted with at least one R₁₀ₐ,
xe11 may be 1, 2, or 3,
xe1 may be 0, 1, 2, 3, 4, or 5,
R₆₀₁ may be a C₃-C₆₀ carbocyclic group unsubstituted or substituted with at least one R₁₀ₐ, a C₁-C₆₀ heterocyclic group unsubstituted or substituted with at least one R₁₀ₐ, -Si(Q₆₀₁)(Q₆₀₂)(Q₆₀₃), -C(=O)(Q₆₀₁), -S(=O)₂(Q₆₀₁), or -P(=O)(Q₆₀₁)(Q₆₀₂),
Q₆₀₁ to Q₆₀₃ may each be the same as described in connection with Q₁,
xe21 may be 1, 2, 3, 4, or 5, and
at least one of Ar₆₀₁, L₆₀₁, and R₆₀₁ may each independently be a π electron-deficient nitrogen-containing C₁-C₆₀ cyclic group that is unsubstituted or substituted with at least one R₁₀ₐ.

In an embodiment, when xe11 in Formula 601 is not less than 2, two or more of Ar₆₀₁ may be linked to each other via a single bond.

In an embodiment, Ar₆₀₁ in Formula 601 may be a substituted or unsubstituted anthracene group.

In one or more embodiments, the electron transport region may include a compound represented by Formula 601-1: 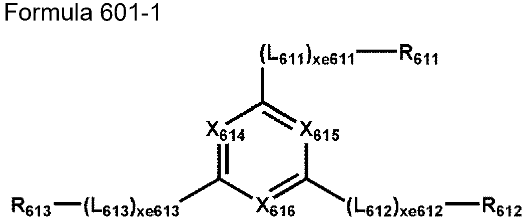
wherein, in Formula 601-1,
X₆₁₄ may be N or C(R₆₁₄), X₆₁₅ may be N or C(R₆₁₅), X₆₁₆ may be N or C(R₆₁₆), and at least one of X₆₁₄ to X₆₁₆ may be N,
L₆₁₁ to L₆₁₃ may each be the same as described in connection with L601,
xe611 to xe613 may each be the same as described in connection with xe1,
R611 to R₆₁₃ may each be the same as described in connection with R₆₀₁, and
R₆₁₄ to R₆₁₆ may each independently be hydrogen, deuterium, -F, -Cl, -Br, -I, a hydroxyl group, a cyano group, a nitro group, a C₁-C₂₀ alkyl group, a C₁-C₂₀ alkoxy group, a C₃-C₆₀ carbocyclic group unsubstituted or substituted with at least one R₁₀ₐ, or a C₁-C₆₀ heterocyclic group unsubstituted or substituted with at least one R₁₀ₐ.

For example, xe1 and xe611 to xe613 in Formulae 601 and 601-1 may each independently be 0, 1, or 2.

The electron transport region may include: one of Compounds ET1 to ET45; 2,9-dimethyl-4,7-diphenyl-1,10-phenanthroline (BCP); 4,7-diphenyl-1,10-phenanthroline (Bphen); Alq₃; BAlq; TAZ; NTAZ; or a combination thereof:

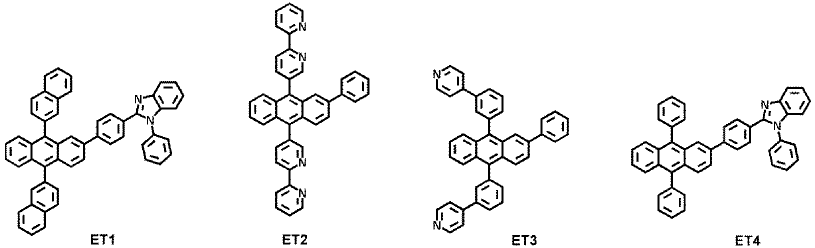

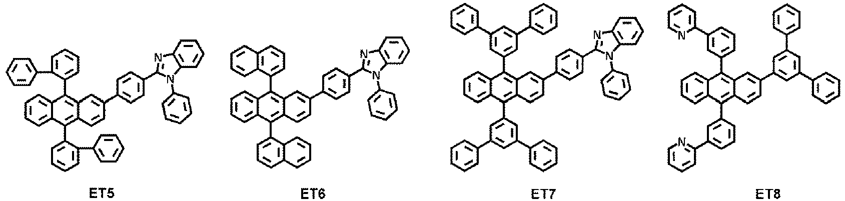

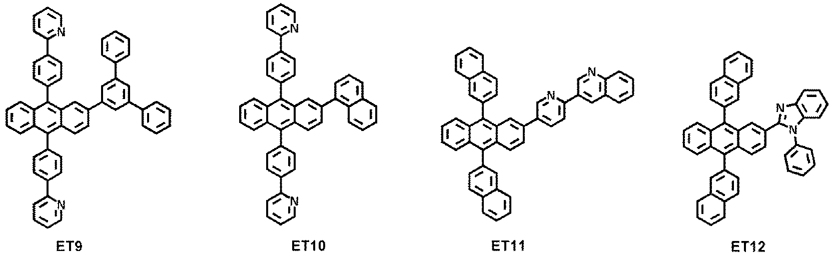

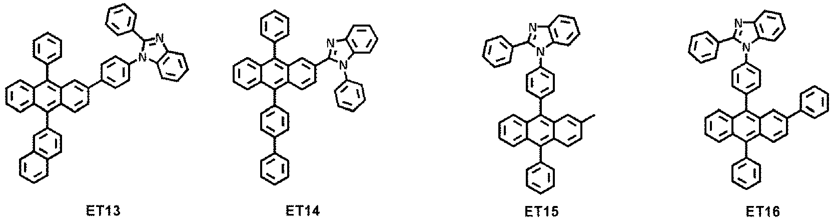

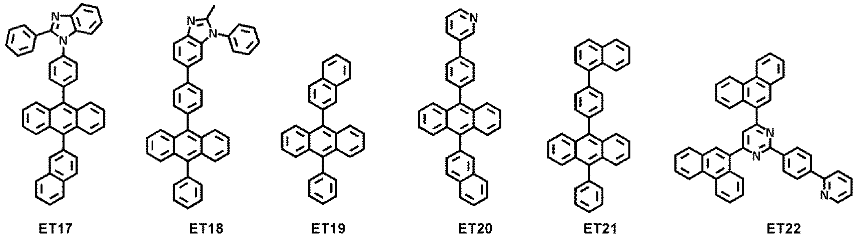

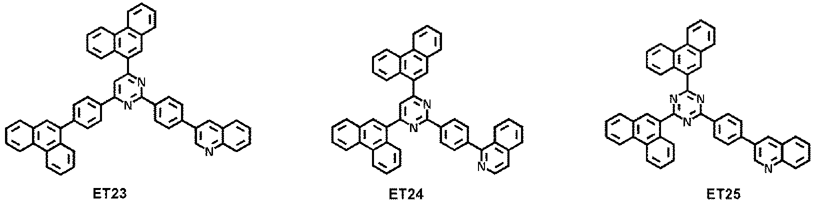

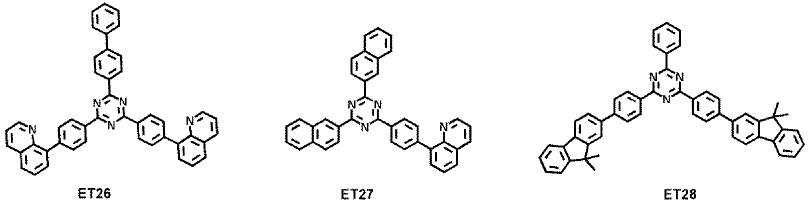

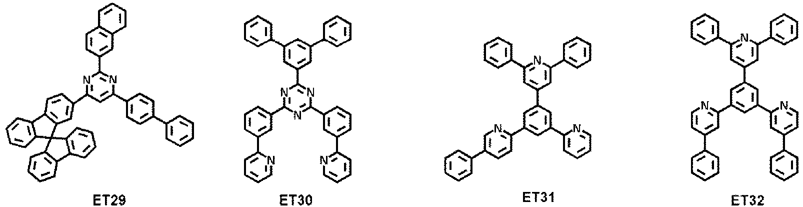

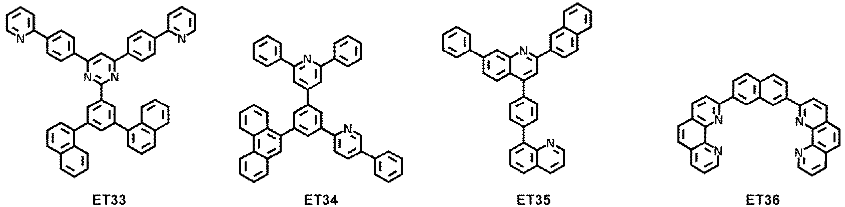

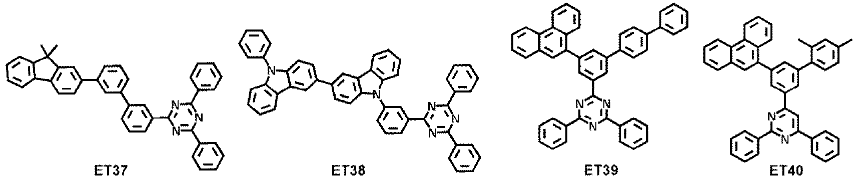

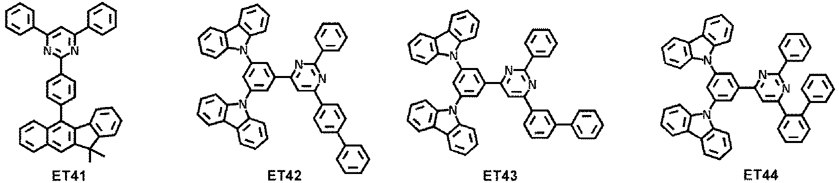

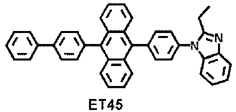

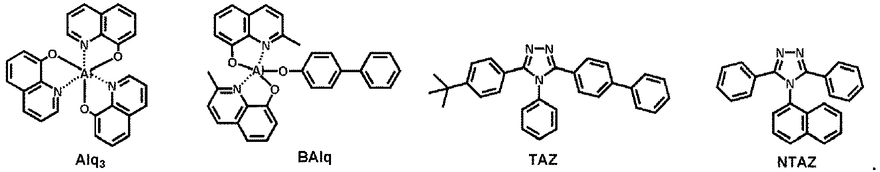

A thickness of the electron transport region may be in a range of about 100 Å to about 5,000 Å, for example, about 160 Å to about 4,000 Å. When the electron transport region includes a buffer layer, a hole-blocking layer, an electron control layer, an electron transport layer, or a combination thereof, a thickness of the buffer layer, the hole-blocking layer, or the electron control layer may each independently be in a range of about 20 Å to about 1,000 Å, for example, about 30 Å to about 300 Å, and a thickness of the electron transport layer may be in a range of about 100 Å to about 1,000 Å, for example, about 150 Å to about 500 Å. When the thicknesses of the buffer layer, the hole-blocking layer, the electron control layer, the electron transport layer, and/or the electron transport region are within these ranges, satisfactory electron transporting characteristics may be obtained without a substantial increase in driving voltage.

The electron transport region (e.g., the electron transport layer in the electron transport region) may further include, in addition to the aforementioned materials, a metal-containing material.

The metal-containing material may include an alkali metal complex, an alkaline earth metal complex, or a combination thereof. The metal ion of an alkali metal complex may be a Li ion, a Na ion, a K ion, a Rb ion, or a Cs ion, and the metal ion of an alkaline earth metal complex may be a Be ion, a Mg ion, a Ca ion, a Sr ion, or a Ba ion. A ligand coordinated with the metal ion of the alkali metal complex or the alkaline earth-metal complex may include a hydroxyquinoline, a hydroxyisoquinoline, a hydroxybenzoquinoline, a hydroxyacridine, a hydroxyphenanthridine, a hydroxyphenyloxazole, a hydroxyphenylthiazole, a hydroxyphenyloxadiazole, a hydroxyphenylthiadiazole, a hydroxyphenylpyridine, a hydroxyphenylbenzimidazole, a hydroxyphenylbenzothiazole, a bipyridine, a phenanthroline, a cyclopentadiene, or a combination thereof.

For example, the metal-containing material may include a Li complex. The Li complex may include, for example, Compound ET-D1 (LiQ) or ET-D2:

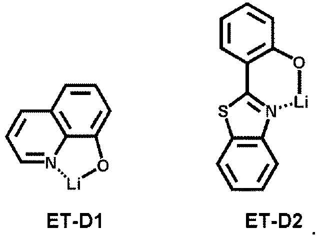

The electron transport region may include an electron injection layer that facilitates the injection of electrons from the second electrode 150. The electron injection layer may directly contact the second electrode 150.

The electron injection layer may have i) a single-layer structure consisting of a single layer consisting of a single material, ii) a single-layer structure consisting of a single layer consisting of a plurality of different materials, or iii) a multi-layer structure including a plurality of layers including a plurality of different materials.

The electron injection layer may include an alkali metal, alkaline earth metal, a rare earth metal, an alkali metal-containing compound, alkaline earth metal-containing compound, a rare earth metal-containing compound, an alkali metal complex, an alkaline earth metal complex, a rare earth metal complex, or a combination thereof.

The alkali metal may include Li, Na, K, Rb, Cs, or a combination thereof. The alkaline earth metal may include Mg, Ca, Sr, Ba, or a combination thereof. The rare earth metal may include Sc, Y, Ce, Tb, Yb, Gd, or a combination thereof.

The alkali metal-containing compound, the alkaline earth metal-containing compound, and the rare earth metal-containing compound may be oxides, halides (e.g., fluorides, chlorides, bromides, or iodides), or tellurides of the alkali metal, the alkaline earth metal, and the rare earth metal, or a combination thereof.

The alkali metal-containing compound may include: an alkali metal oxide, such as Li₂O, Cs₂O, K₂O, etc.; alkali metal halides, such as LiF, NaF, CsF, KF, Lil, Nal, CsI, KI, etc.; or a combination thereof. The alkaline earth metal-containing compound may include an alkaline earth metal compound, such as BaO, SrO, CaO, BaₓSr₁₋ₓO (wherein x is a real number satisfying 0<x<1), BaₓCa₁₋ₓO (wherein x is a real number satisfying 0<x<1), and the like. The rare earth metal-containing compound may include YbF₃, ScF₃, SC₂O₃, Y₂O₃, Ce₂O₃, GdF₃, TbF₃, YbI₃, ScI₃, TbI₃, or a combination thereof. In an embodiment, the rare earth metal-containing compound may include lanthanide metal telluride. Examples of the lanthanide metal telluride are LaTe, CeTe, PrTe, NdTe, PmTe, SmTe, EuTe, GdTe, TbTe, DyTe, HoTe, ErTe, TmTe, YbTe, LuTe, La₂Te₃, Ce₂Te₃, Pr₂Te₃, Nd₂Te₃, Pm₂Te₃, Sm₂Te₃, Eu₂Te₃, Gd₂Te₃, Tb₂Te₃, Dy₂Te₃, Ho₂Te₃, Er₂Te₃, Tm₂Te₃, Yb₂Te₃, Lu₂Te₃, and the like.

The alkali metal complex, the alkaline earth-metal complex, and the rare earth metal complex may include i) one of metal ions of the alkali metal, the alkaline earth metal, and the rare earth metal, and ii) as a ligand bonded to the metal ions, for example, a hydroxyquinoline, a hydroxyisoquinoline, a hydroxybenzoquinoline, a hydroxyacridine, a hydroxyphenanthridine, a hydroxyphenyloxazole, a hydroxyphenylthiazole, a hydroxyphenyloxadiazole, a hydroxyphenylthiadiazole, a hydroxyphenylpyridine, a hydroxyphenyl benzimidazole, a hydroxyphenylbenzothiazole, a bipyridine, a phenanthroline, a cyclopentadiene, or a combination thereof.

In an embodiment, the electron injection layer may consist of an alkali metal, an alkaline earth metal, a rare earth metal, an alkali metal-containing compound, an alkaline earth metal-containing compound, a rare earth metal-containing compound, an alkali metal complex, an alkaline earth metal complex, a rare earth metal complex, or a combination thereof, as described above. In one or more embodiments, the electron injection layer may further include an organic material (e.g., the compound represented by Formula 601).

In one or more embodiments, the electron injection layer may consist of i) an alkali metal-containing compound (e.g., an alkali metal halide), or ii) a) an alkali metal-containing compound (e.g., an alkali metal halide), and b) an alkali metal, an alkaline earth metal, a rare earth metal, or a combination thereof. For example, the electron injection layer may be a KI:Yb co-deposited layer, an Rbl:Yb co-deposited layer, a LiF:Yb co-deposited layer, and the like.

When the electron injection layer further includes an organic material, an alkali metal, an alkaline earth metal, a rare earth metal, an alkali metal-containing compound, an alkaline earth metal-containing compound, a rare earth metal-containing compound, an alkali metal complex, an alkaline earth-metal complex, a rare earth metal complex, or a combination thereof may be uniformly or non-uniformly dispersed in a matrix including the organic material.

A thickness of the electron injection layer may be in a range of about 1 Å to about 100 Å, and, for example, about 3 Å to about 90 Å. When the thickness of the electron injection layer is within these ranges, satisfactory electron injection characteristics may be obtained without a substantial increase in driving voltage.

### [Second electrode 150]

The second electrode 150 is arranged on the interlayer 130 having the aforementioned structure. The second electrode 150 may be a cathode, which is an electron injection electrode, and as a material for forming the second electrode 150, a metal, an alloy, an electrically conductive compound, or a combination thereof, each having a low-work function, may be used.

The second electrode 150 may include Li, Ag, Mg, Al, Al-Li, Ca, Mg-In, Mg-Ag, Yb, Ag-Yb, ITO, IZO, or a combination thereof. The second electrode 150 may be a transmissive electrode, a semi-transmissive electrode, or a reflective electrode.

The second electrode 150 may have a single-layer structure or a multi-layer structure including multiple layers.

### [Capping layer]

A first capping layer may be arranged outside the first electrode 110, and/or a second capping layer may be arranged outside the second electrode 150. In detail, the light-emitting device 10 may have a structure in which the first capping layer, the first electrode 110, the interlayer 130, and the second electrode 150 are sequentially stacked in the stated order, a structure in which the first electrode 110, the interlayer 130, the second electrode 150, and the second capping layer are sequentially stacked in the stated order, or a structure in which the first capping layer, the first electrode 110, the interlayer 130, the second electrode 150, and the second capping layer are sequentially stacked in the stated order.

Light generated in the emission layer of the interlayer 130 of the light-emitting device 10 may be extracted toward the outside through the first electrode 110, which is a semi-transmissive electrode or a transmissive electrode, and the first capping layer. Light generated in the emission layer of the interlayer 130 of the light-emitting device 10 may be extracted toward the outside through the second electrode 150, which is a semi-transmissive electrode or a transmissive electrode, and the second capping layer.

The first capping layer and the second capping layer may increase external emission efficiency according to the principle of constructive interference. Accordingly, the light extraction efficiency of the light-emitting device 10 is increased, so that the luminescence efficiency of the light-emitting device 10 may be improved.

Each of the first capping layer and the second capping layer may include a material having a refractive index of not less than 1.6 (at 589 nm).

The first capping layer and the second capping layer may each independently be an organic capping layer including an organic material, an inorganic capping layer including an inorganic material, or an organic-inorganic composite capping layer including an organic material and an inorganic material.

At least one of the first capping layer and the second capping layer may each independently include a carbocyclic compound, a heterocyclic compound, an amine group-containing compound, a porphine derivative, a phthalocyanine derivative, a naphthalocyanine derivative, an alkali metal complex, an alkaline earth metal complex, or a combination thereof. The carbocyclic compound, the heterocyclic compound, and the amine group-containing compound may optionally be substituted with a substituent including O, N, S, Se, Si, F, CI, Br, I, or a combination thereof. In an embodiment, at least one of the first capping layer and the second capping layer may each independently include an amine group-containing compound.

In one or more embodiments, at least one of the first capping layer and the second capping layer may each independently include a compound represented by Formula 201, a compound represented by Formula 202, or a combination thereof.

In one or more embodiments, at least one of the first capping layer and the second capping layer may each independently include one of Compounds HT28 to HT33, one of Compounds CP1 to CP6, β-NPB, or a combination thereof:

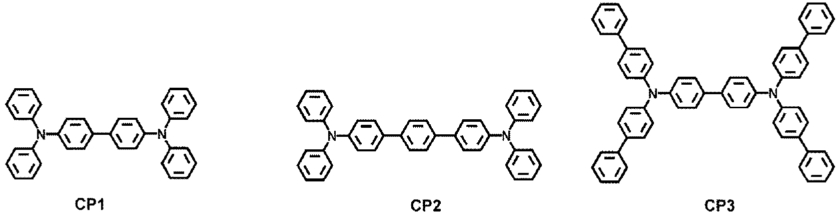

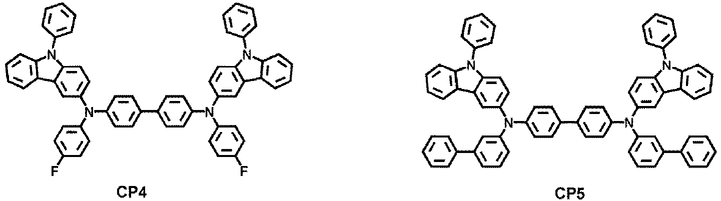

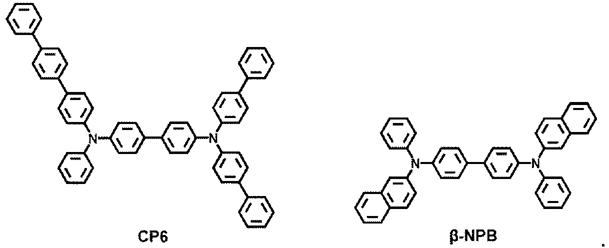

### [Film]

The heterocyclic compound represented by Formula 1 may be included in various films. Accordingly, another aspect provides a film including the heterocyclic compound represented by Formula 1. The film may be, for example, an optical member (or a light control means) (for example, a color filter, a color conversion member, a capping layer, a light extraction efficiency enhancement layer, a selective light absorbing layer, a polarizing layer, a quantum dot-containing layer, or like), a light-blocking member (for example, a light reflective layer, a light absorbing layer, or the like), a protective member (for example, an insulating layer, a dielectric layer, or the like).

### [Electronic apparatus]

The light-emitting device may be included in various electronic apparatuses. For example, the electronic apparatus including the light-emitting device may be a light-emitting apparatus, an authentication apparatus, and the like.

The electronic apparatus (e.g., a light-emitting apparatus) may further include, in addition to the light-emitting device, i) a color filter, ii) a color conversion layer, or iii) a color filter and a color conversion layer. The color filter and/or the color conversion layer may be arranged in at least one traveling direction of light emitted from the light-emitting device. For example, light emitted from the light-emitting device may be blue light, green light, or white light. Details on the light-emitting device may be the same as described herein. In an embodiment, the color conversion layer may include quantum dots.

The electronic apparatus may include a first substrate. The first substrate may include a plurality of subpixel areas, the color filter may include a plurality of color filter areas respectively corresponding to the subpixel areas, and the color conversion layer may include a plurality of color conversion areas respectively corresponding to the subpixel areas.

A pixel-defining film may be arranged among the subpixel areas to define each of the subpixel areas.

The color filter may further include a plurality of color filter areas and light-shielding patterns arranged among the color filter areas, and the color conversion layer may further include a plurality of color conversion areas and light-shielding patterns arranged among the color conversion areas.

The plurality of color filter areas (or the plurality of color conversion areas) may include a first area emitting first color light, a second area emitting second color light, and/or a third area emitting third color light, wherein the first color light, the second color light, and/or the third color light may have different maximum emission wavelengths from one another. For example, the first color light may be red light, the second color light may be green light, and the third color light may be blue light. For example, the plurality of color filter areas (or the plurality of color conversion areas) may include quantum dots. In particular, the first area may include a red quantum dot, the second area may include a green quantum dot, and the third area may not include a quantum dot. Details on the quantum dot may be referred to the descriptions provided herein. The first area, the second area, and/or the third area may each further include a scatter.

For example, the light-emitting device may emit first light, the first area may absorb the first light to emit first-first color light, the second area may absorb the first light to emit second-first color light, and the third area may absorb the first light to emit third-first color light. Here, the first-first color light, the second-first color light, and the third-first color light may have different maximum emission wavelengths. In particular, the first light may be blue light, the first-first color light may be red light, the second-first color light may be green light, and the third-first color light may be blue light.

The electronic apparatus may further include a thin-film transistor, in addition to the light-emitting device as described above. The thin-film transistor may include a source electrode, a drain electrode, and an activation layer, wherein any one of the source electrode and the drain electrode may be electrically connected to any one of the first electrode and the second electrode of the light-emitting device.

The thin-film transistor may further include a gate electrode, a gate insulating film, and the like.

The activation layer may include crystalline silicon, amorphous silicon, an organic semiconductor, an oxide semiconductor, and the like.

The electronic apparatus may further include a sealing portion for sealing the light-emitting device. The sealing portion may be arranged between the color filter and/or the color conversion layer and the light-emitting device. The sealing portion allows light from the light-emitting device to be extracted to the outside, and simultaneously prevents ambient air and moisture from penetrating into the light-emitting device. The sealing portion may be a sealing substrate including a transparent glass substrate or a plastic substrate. The sealing portion may be a thin-film encapsulation layer including at least one layer of an organic layer and/or an inorganic layer. When the sealing portion is a thin film encapsulation layer, the electronic apparatus may be flexible.

Various functional layers may be additionally arranged on the sealing portion, in addition to the color filter and/or the color conversion layer, according to the use of the electronic apparatus. Examples of the functional layers may include a touch screen layer, a polarizing layer, and the like. The touch screen layer may be a pressure-sensitive touch screen layer, a capacitive touch screen layer, or an infrared touch screen layer. The authentication apparatus may be, for example, a biometric authentication apparatus that authenticates an individual by using biometric information of a living body (e.g., fingertips, pupils, etc.).

The authentication apparatus may further include, in addition to the light-emitting device as described above, a biometric information collector.

The electronic apparatus may be applied to various displays, light sources, lighting, personal computers (e.g., a mobile personal computer), mobile phones, digital cameras, electronic organizers, electronic dictionaries, electronic game machines, medical instruments (e.g., electronic thermometers, sphygmomanometers, blood glucose meters, pulse measurement devices, pulse wave measurement devices, electrocardiogram displays, ultrasonic diagnostic devices, or endoscope displays), fish finders, various measuring instruments, meters (e.g., meters for a vehicle, an aircraft, and a vessel), projectors, and the like.

### [Electronic device]

The light-emitting device may be included in various electronic device.

For example, the electronic device including the light-emitting device may be a flat panel display, a curved display, a computer monitor, a medical monitor, a television, a billboard, a light for indoor or outdoor lighting and/or signaling, a head-up display, a fully or partially transparent display, a flexible display, a rollable display, a foldable display, a stretchable display, a laser printer, a telephone, a mobile phone, a tablet, a phablet, a personal digital assistant (PDA), a wearable device, a laptop computer, a digital camera, a camcorder, a viewfinder, a micro display, a 3D display, a virtual or augmented-reality display, a vehicle, a video wall including multiple displays tiled together, a theater or stadium screen, a phototherapy device, and a signboard.

Since the light-emitting device has excellent effects in terms of luminescence efficiency long lifespan, the electronic device including the light-emitting device may have characteristics with high luminance, high resolution, and low power consumption.

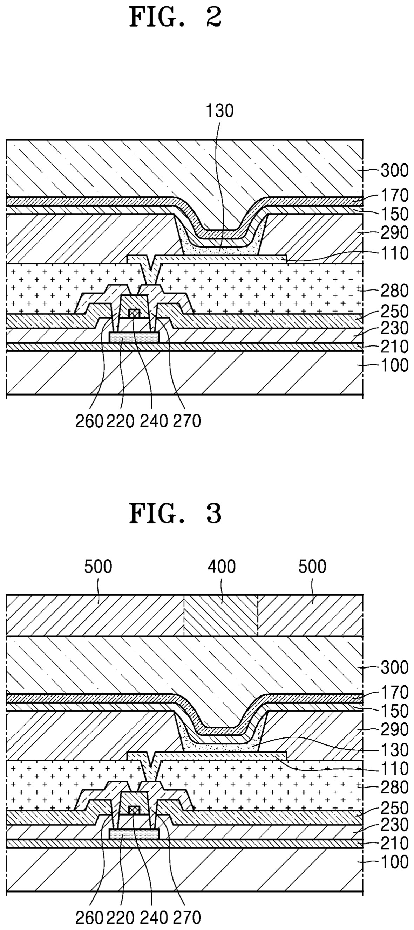

### [Description of FIGS. 2 and 3]

FIG. 2 is a cross-sectional view showing a light-emitting apparatus as an example of the electronic apparatus according to an embodiment.

The light-emitting apparatus of FIG. 2 includes a substrate 100, a thin-film transistor (TFT), a light-emitting device, and an encapsulation portion 300 that seals the light-emitting device.

The substrate 100 may be a flexible substrate, a glass substrate, or a metal substrate. A buffer layer 210 may be arranged on the substrate 100. The buffer layer 210 may prevent penetration of impurities through the substrate 100 and may provide a flat surface on the substrate 100.

A TFT may be arranged on the buffer layer 210. The TFT may include an activation layer 220, a gate electrode 240, a source electrode 260, and a drain electrode 270.

The activation layer 220 may include an inorganic semiconductor such as silicon or polysilicon, an organic semiconductor, or an oxide semiconductor, and may include a source region, a drain region, and a channel region.

A gate insulating film 230 for insulating the activation layer 220 from the gate electrode 240 may be arranged on the activation layer 220, and the gate electrode 240 may be arranged on the gate insulating film 230.

An interlayer insulating film 250 may be arranged on the gate electrode 240. The interlayer insulating film 250 may be arranged between the gate electrode 240 and the source electrode 260 and between the gate electrode 240 and the drain electrode 270, to insulate from one another.

The source electrode 260 and the drain electrode 270 may be arranged on the interlayer insulating film 250. The interlayer insulating film 250 and the gate insulating film 230 may be formed to expose the source region and the drain region of the activation layer 220, and the source electrode 260 and the drain electrode 270 may be arranged in contact with the exposed portions of the source region and the drain region of the activation layer 220.

The TFT may be electrically connected to a light-emitting device to drive the light-emitting device, and may be covered and protected by a passivation layer 280. The passivation layer 280 may include an inorganic insulating film, an organic insulating film, or a combination thereof. A light-emitting device may be provided on the passivation layer 280. The light-emitting device may include the first electrode 110, the interlayer 130, and the second electrode 150.

The first electrode 110 may be arranged on the passivation layer 280. The passivation layer 280 may be arranged to expose a portion of the drain electrode 270, not fully covering the drain electrode 270, and the first electrode 110 may be arranged to be connected to the exposed portion of the drain electrode 270.

A pixel defining layer 290 including an insulating material may be arranged on the first electrode 110. The pixel defining layer 290 may expose a certain region of the first electrode 110, and an interlayer 130 may be formed in the exposed region of the first electrode 110. The pixel defining layer 290 may be a polyimide-based organic film or a polyacrylic-based organic film. Although not shown in FIG. 2, at least some layers of the interlayer 130 may extend beyond the upper portion of the pixel defining layer 290 to be arranged in the form of a common layer.

The second electrode 150 may be arranged on the interlayer 130, and a second capping layer 170 may be additionally formed on the second electrode 150. The second capping layer 170 may be formed to cover the second electrode 150.

The encapsulation portion 300 may be arranged on the second capping layer 170. The encapsulation portion 300 may be arranged on a light-emitting device to protect the light-emitting device from moisture or oxygen. The encapsulation portion 300 may include: an inorganic film including silicon nitride (SiNx), silicon oxide (SiOx), indium tin oxide, indium zinc oxide, or a combination thereof; an organic film including polyethylene terephthalate, polyethylene naphthalate, polycarbonate, polyimide, polyethylene sulfonate, polyoxymethylene, polyarylate, hexamethyldisiloxane, an acrylic resin (e.g., polymethyl methacrylate, polyacrylic acid, or the like), an epoxy-based resin (e.g., aliphatic glycidyl ether (AGE), or the like), or a combination thereof; or a combination of the inorganic films and the organic films.

FIG. 3 is a cross-sectional view of a light-emitting apparatus as an example of the electronic apparatus according to another embodiment.

The light-emitting apparatus of FIG. 3 is the same as the light-emitting apparatus of FIG. 2, except that a light-shielding pattern 500 and a functional region 400 are additionally arranged on the encapsulation portion 300. The functional region 400 may be i) a color filter area, ii) a color conversion area, or iii) a combination of the color filter area and the color conversion area. In an embodiment, the light-emitting device included in the light-emitting apparatus of FIG. 3 may be a tandem light-emitting device.

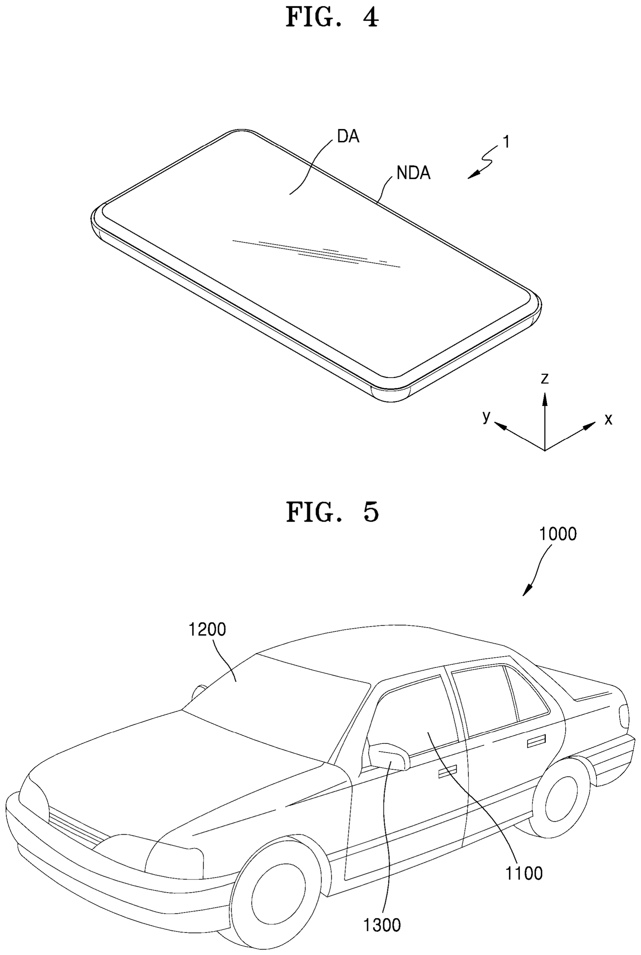

### [Description of FIG. 4]

FIG. 4 is a schematic perspective view of electronic device 1 including a light-emitting device according to an embodiment. The electronic device 1 is a device apparatus that displays a moving image or a still image, and may be portable electronic device, such as a mobile phone, a smart phone, a tablet personal computer (PC), a mobile communication terminal, an electronic notebook, an electronic book, a portable multimedia player (PMP), a navigation, or a ultra-mobile PC (UMPC), as well as various products, such as a television, a laptop, a monitor, a billboard, or an Internet of things (IOT), or a part thereof In addition, the electronic device 1 may be a wearable device, such as a smart watch, a watch phone, a glasses-type display, or a head mounted display (HMD), or a part of the wearable device. However, embodiments of the disclosure are not limited thereto. For example, the electron device 1 may be a dashboard of a vehicle, a center information display (CID) on a center fascia or dashboard of a vehicle, a room mirror display replacing a side mirror of a vehicle, an entertainment display arranged for the rear seat of a vehicle or arranged on the back of the front seat, a head-up display (HUD) installed at the front of a vehicle or projected on a front window glass, or a computer generated hologram augmented reality head up display (CGH AR HUD). FIG. 4 illustrates a case in which the electronic device 1 is a smartphone for convenience of explanation.

The electronic device 1 may include a display area DA and a non-display area NDA outside the display area DA. A display device may implement an image through an array of a plurality of pixels that are two-dimensionally arranged in the display area DA.

The non-display area NDA is an area that does not display an image, and may entirely surround the display area DA. On the non-display area NDA, a driver for providing electrical signals or power to display devices arranged on the display area DA may be arranged. On the non-display area NDA, a pad, which is an area to which an electronic element or a printing circuit board may be electrically connected, may be arranged.

In the electronic device 1, a length in the x-axis direction and a length in the y-axis direction may be different from each other. In an embodiment, as shown in FIG. 4, the length in the x-axis direction may be shorter than the length in the y-axis direction. In one or more embodiments, the length in the x-axis direction may be the same as the length in the y-axis direction. In one or more embodiments, the length in the x-axis direction may be longer than the length in the y-axis direction.

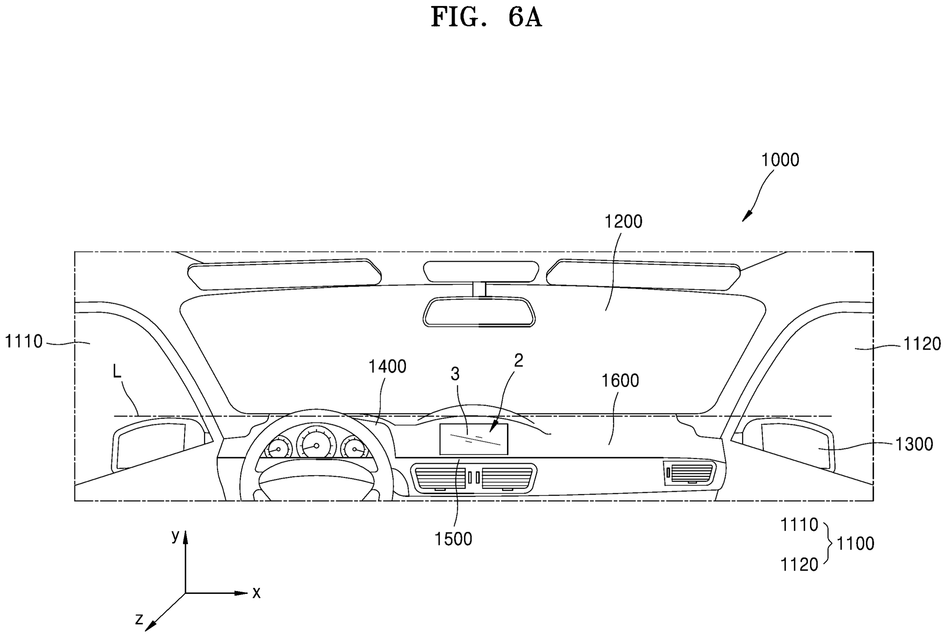

### [Descriptions of FIGS. 5 and 6A to 6C]

FIG. 5 is a schematic view of the exterior of a vehicle 1000 as an electronic apparatus including a light-emitting device according to an embodiment. FIGS. 6A to 6C are each a schematic view of the interior of the vehicle 1000 according to one or more embodiments.

Referring to FIGS. 5 and 6A to 6C, the vehicle 1000 may refer to various apparatuses for moving a subject object to be transported, such as a human, an object, or an animal, from a departure point to a destination. The vehicle 1000 may include a vehicle traveling on a road or a track, a vessel moving over the sea or river, an airplane flying in the sky using the action of air, and the like.

The vehicle 1000 may travel on a road or a track. The vehicle 1000 may move in a predetermined direction according to the rotation of at least one wheel. For example, the vehicle 1000 may include a three-wheeled or four-wheeled vehicle, a construction machine, a two-wheeled vehicle, a prime mover device, a bicycle, and a train running on a track.

The vehicle 1000 may include a body having an interior and an exterior, and a chassis in which mechanical apparatuses necessary for driving are installed as other parts except for the body. The exterior of the vehicle body may include a front panel, a bonnet, a roof panel, a rear panel, a trunk, a pillar provided at a boundary between doors, and the like. The chassis of the vehicle 1000 may include a power generating device, a power transmitting device, a driving device, a steering device, a braking device, a suspension device, a transmission device, a fuel device, front and rear wheels, left and right wheels, and the like.

The vehicle 1000 may include a side window glass 1100, a front window glass 1200, a side mirror 1300, a cluster 1400, a center fascia 1500, a passenger seat dashboard 1600, and a display device 2.

The side window glass 1100 and the front window glass 1200 may be partitioned by a pillar arranged between the side window glass 1100 and the front window glass 1200.

The side window glass 1100 may be installed on the side of the vehicle 1000. In an embodiment, the side window glass 1100 may be installed on a door of the vehicle 1000. A plurality of side window glasses 1100 may be provided and may face each other. In an embodiment, the side window glass 1100 may include a first side window glass 1110 and a second side window glass 1120. In an embodiment, the first side window glass 1110 may be arranged adjacent to the cluster 1400. The second side window glass 1120 may be arranged adjacent to the passenger seat dashboard 1600.

In an embodiment, the side window glasses 1100 may be spaced apart from each other in the x-direction or the -x-direction. For example, the first side window glass 1110 and the second side window glass 1120 may be spaced apart from each other in the x direction or the -x direction. In other words, an imaginary straight line L connecting the side window glasses 1100 may extend in the x-direction or the -x-direction. For example, an imaginary straight line L connecting the first side window glass 1110 and the second side window glass 1120 to each other may extend in the x direction or the -x direction.

The front window glass 1200 may be installed in the front of the vehicle 1000. The front window glass 1200 may be arranged between the side window glasses 1100 facing each other.

The side mirror 1300 may provide a rear view of the vehicle 1000. The side mirror 1300 may be installed on the exterior of the vehicle body. In one embodiment, a plurality of side mirrors 1300 may be provided. Any one of the plurality of side mirrors 1300 may be arranged outside the first side window glass 1110. The other one of the plurality of side mirrors 1300 may be arranged outside the second side window glass 1120.

The cluster 1400 may be arranged in front of the steering wheel. The cluster 1400 may include a tachometer, a speedometer, a coolant thermometer, a fuel gauge turn indicator, a high beam indicator, a warning lamp, a seat belt warning lamp, an odometer, a hodometer, an automatic shift selector indicator lamp, a door open warning lamp, an engine oil warning lamp, and/or a low fuel warning light.

The center fascia 1500 may include a control panel on which a plurality of buttons for adjusting an audio device, an air conditioning device, and a heater of a seat are disposed. The center fascia 1500 may be arranged on one side of the cluster 1400.

A passenger seat dashboard 1600 may be spaced apart from the cluster 1400 with the center fascia 1500 arranged therebetween. In an embodiment, the cluster 1400 may be arranged to correspond to a driver seat (not shown), and the passenger seat dashboard 1600 may be disposed to correspond to a passenger seat (not shown). In an embodiment, the cluster 1400 may be adjacent to the first side window glass 1110, and the passenger seat dashboard 1600 may be adjacent to the second side window glass 1120.

In an embodiment, the display device 2 may include a display panel 3, and the display panel 3 may display an image. The display device 2 may be arranged inside the vehicle 1000. In an embodiment, the display device 2 may be arranged between the side window glasses 1100 facing each other. The display device 2 may be arranged on at least one of the cluster 1400, the center fascia 1500, and the passenger seat dashboard 1600.

The display device 2 may include an organic light-emitting display device, an inorganic electroluminescent display device, a quantum dot display device, and the like. Hereinafter, as the display device 2 according to an embodiment, an organic light-emitting display apparatus including the aforementioned light-emitting device will be described as an example, but various types of the aforementioned display apparatus may be used in embodiments.

Referring to FIG. 6A, the display device 2 may be arranged on the center fascia 1500. In an embodiment, the display device 2 may display navigation information. In an embodiment, the display device 2 may display audio, video, or information regarding vehicle settings.

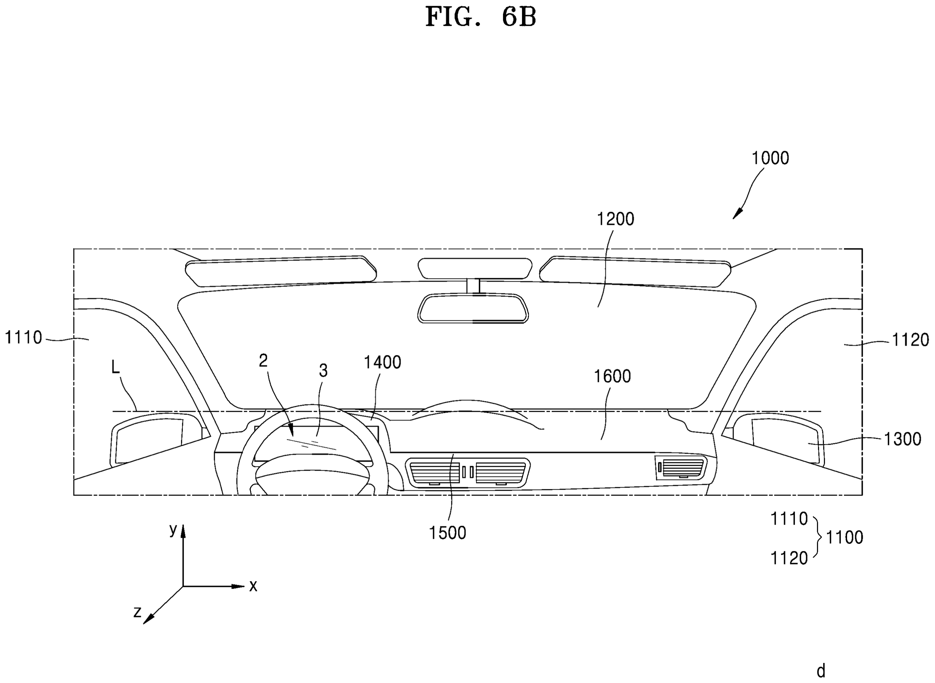

Referring to FIG. 6B, the display device 2 may be arranged on the cluster 1400. When the display device 2 is arranged on the cluster 1400, the cluster 1400 may display driving information and the like through the display device 2. That is, the cluster 1400 may be implemented digitally. The digital cluster 1400 may display vehicle information and driving information as images. For example, a needle and a gauge of a tachometer and various warning light icons may be displayed by a digital signal.

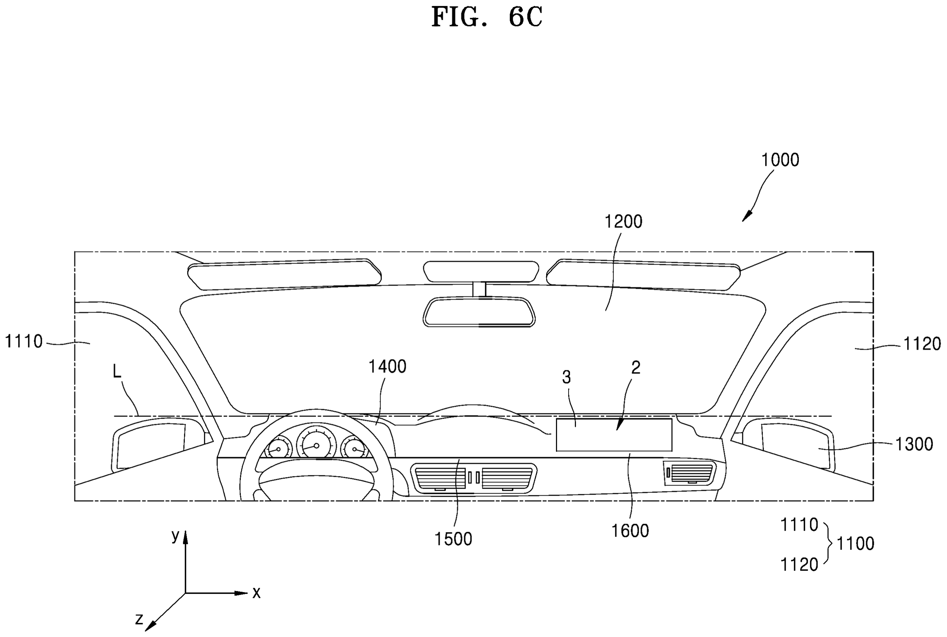

Referring to FIG. 6C, the display device 2 may be arranged on the passenger seat dashboard 1600. The display device 2 may be embedded in the passenger seat dashboard 1600 or arranged on the passenger seat dashboard 1600. In an embodiment, the display device 2 arranged on the passenger seat dashboard 1600 may display an image related to information displayed on the cluster 1400 and/or information displayed on the center fascia 1500. In one or more embodiments, the display device 2 arranged on the passenger seat dashboard 1600 may display information different from information displayed on the cluster 1400 and/or information displayed on the center fascia 1500.

### [Manufacturing method]

The layers constituting the hole transport region, the emission layer, and the layers constituting the electron transport region may be formed in a certain region by using various methods such as vacuum deposition, spin coating, casting, Langmuir-Blodgett (LB) deposition, ink-jet printing, laser-printing, laser-induced thermal imaging, and the like.

When respective layers included in the hole transport region, the emission layer, and respective layers included in the electron transport region are formed by vacuum deposition, the deposition may be performed at a deposition temperature of about 100 °C to about 500 °C, a vacuum degree of about 10⁻⁸ torr to about 10⁻³ torr, and a deposition speed of about 0.01 Å/sec to about 100 Å/sec, depending on a material to be included in a layer to be formed and the structure of a layer to be formed.

### [Definition of terms]

The term "C₃-C₆₀ carbocyclic group" as used herein refers to a cyclic group consisting of carbon only as a ring-forming atom and having three to sixty carbon atoms, and the term "C₁-C₆₀ heterocyclic group" as used herein refers to a cyclic group that has one to sixty carbon atoms and further has, in addition to carbon, a heteroatom as a ring-forming atom. The C₃-C₆₀ carbocyclic group and the C₁-C₆₀ heterocyclic group may each be a monocyclic group consisting of one ring or a polycyclic group in which two or more rings are condensed with each other. For example, the number of ring-forming atoms of the C₁-C₆₀ heterocyclic group may be from 3 to 61.

The "cyclic group" as used herein may include both the C₃-C₆₀carbocyclic group and the C₁-C₆₀ heterocyclic group.

The term "π electron-rich C₃-C₆₀ cyclic group" as used herein refers to a cyclic group that has 3 to 60 carbon atoms and does not include *-N=*' as a ring-forming moiety, and the term "π electron-deficient nitrogen-containing C₁-C₆₀ heterocyclic group" as used herein refers to a heterocyclic group that has 1 to 60 carbon atoms and includes *-N=*' as a ring-forming moiety.

**For** example,
the C₃-C₆₀ carbocyclic group may be i) Group T1 or ii) a condensed cyclic group in which two or more of Group T1 are condensed with each other (e.g., a cyclopentadiene group, an adamantane group, a norbornane group, a benzene group, a pentalene group, a naphthalene group, an azulene group, an indacene group, an acenaphthylene group, a phenalene group, a phenanthrene group, an anthracene group, a fluoranthene group, a triphenylene group, a pyrene group, a chrysene group, a perylene group, a pentaphene group, a heptalene group, a naphthacene group, a picene group, a hexacene group, a pentacene group, a rubicene group, a coronene group, an ovalene group, an indene group, a fluorene group, a spiro-bifluorene group, a benzofluorene group, an indenophenanthrene group, or an indenoanthracene group),
the C₁-C₆₀ heterocyclic group may be i) Group T2, ii) a condensed cyclic group in which two or more of Group T2 are condensed with each other, or iii) a condensed cyclic group in which at least one Group T2 and at least one Group T1 are condensed with each other (e.g., a pyrrole group, a thiophene group, a furan group, an indole group, a benzoindole group, a naphthoindole group, an isoindole group, a benzoisoindole group, a naphthoisoindole group, a benzosilole group, a benzothiophene group, a benzofuran group, a carbazole group, a dibenzosilole group, a dibenzothiophene group, a dibenzofuran group, an indenocarbazole group, an indolocarbazole group, a benzofurocarbazole group, a benzothienocarbazole group, a benzosilolocarbazole group, a benzoindolocarbazole group, a benzocarbazole group, a benzonaphthofuran group, a benzonaphthothiophene group, a benzonaphthosilole group, a benzofurodibenzofuran group, a benzofurodibenzothiophene group, a benzothienodibenzothiophene group, a pyrazole group, an imidazole group, a triazole group, an oxazole group, an isoxazole group, an oxadiazole group, a thiazole group, an isothiazole group, a thiadiazole group, a benzopyrazole group, a benzimidazole group, a benzoxazole group, a benzoisoxazole group, a benzothiazole group, a benzoisothiazole group, a pyridine group, a pyrimidine group, a pyrazine group, a pyridazine group, a triazine group, a quinoline group, an isoquinoline group, a benzoquinoline group, a benzoisoquinoline group, a quinoxaline group, a benzoquinoxaline group, a quinazoline group, a benzoquinazoline group, a phenanthroline group, a cinnoline group, a phthalazine group, a naphthyridine group, an imidazopyridine group, an imidazopyrimidine group, an imidazotriazine group, an imidazopyrazine group, an imidazopyridazine group, an azacarbazole group, an azafluorene group, an azadibenzosilole group, an azadibenzothiophene group, an azadibenzofuran group, etc.),
the π electron-rich C₃-C₆₀ cyclic group may be i) Group T1, ii) a condensed cyclic group in which two or more of Group T1 are condensed with each other, iii) Group T3, iv) a condensed cyclic group in which two or more of Group T3 are condensed with each other, or v) a condensed cyclic group in which at least one Group T3 and at least one Group T1 are condensed with each other (e.g., the C₃-C₆₀ carbocyclic group, a 1H-pyrrole group, a silole group, a borole group, a 2H-pyrrole group, a 3H-pyrrole group, a thiophene group, a furan group, an indole group, a benzoindole group, a naphthoindole group, an isoindole group, a benzoisoindole group, a naphthoisoindole group, a benzosilole group, a benzothiophene group, a benzofuran group, a carbazole group, a dibenzosilole group, a dibenzothiophene group, a dibenzofuran group, an indenocarbazole group, an indolocarbazole group, a benzofurocarbazole group, a benzothienocarbazole group, a benzosilolocarbazole group, a benzoindolocarbazole group, a benzocarbazole group, a benzonaphthofuran group, a benzonaphthothiophene group, a benzonaphthosilole group, a benzofurodibenzofuran group, a benzofurodibenzothiophene group, a benzothienodibenzothiophene group, or the like),
the π electron-deficient nitrogen-containing C₁-C₆₀ heterocyclic group may be i) Group T4, ii) a condensed cyclic group in which two or more of Group T4 are condensed with each other, iii) a condensed cyclic group in which at least one Group T4 and at least one Group T1 are condensed with each other, iv) a condensed cyclic group in which at least one Group T4 and at least one Group T3 are condensed with each other, or v) a condensed cyclic group in which at least one Group T4, at least one Group T1, and at least one Group T3 are condensed with one another (e.g., a pyrazole group, an imidazole group, a triazole group, an oxazole group, an isoxazole group, an oxadiazole group, a thiazole group, an isothiazole group, a thiadiazole group, a benzopyrazole group, a benzimidazole group, a benzoxazole group, a benzoisoxazole group, a benzothiazole group, a benzoisothiazole group, a pyridine group, a pyrimidine group, a pyrazine group, a pyridazine group, a triazine group, a quinoline group, an isoquinoline group, a benzoquinoline group, a benzoisoquinoline group, a quinoxaline group, a benzoquinoxaline group, a quinazoline group, a benzoquinazoline group, a phenanthroline group, a cinnoline group, a phthalazine group, a naphthyridine group, an imidazopyridine group, an imidazopyrimidine group, an imidazotriazine group, an imidazopyrazine group, an imidazopyridazine group, an azacarbazole group, an azafluorene group, an azadibenzosilole group, an azadibenzothiophene group, an azadibenzofuran group, etc.),
Group T1 may be a cyclopropane group, a cyclobutane group, a cyclopentane group, a cyclohexane group, a cycloheptane group, a cyclooctane group, a cyclobutene group, a cyclopentene group, a cyclopentadiene group, a cyclohexene group, a cyclohexadiene group, a cycloheptene group, an adamantane group, a norbornane (or bicyclo[2.2.1]heptane) group, a norbornene group, a bicyclo[1.1.1]pentane group, a bicyclo[2.1.1]hexane group, a bicyclo[2.2.2]octane group, or a benzene group,
Group T2 may be a furan group, a thiophene group, a 1H-pyrrole group, a silole group, a borole group, a 2H-pyrrole group, a 3H-pyrrole group, an imidazole group, a pyrazole group, a triazole group, a tetrazole group, an oxazole group, an isoxazole group, an oxadiazole group, a thiazole group, an isothiazole group, a thiadiazole group, an azasilole group, an azaborole group, a pyridine group, a pyrimidine group, a pyrazine group, a pyridazine group, a triazine group, a tetrazine group, a pyrrolidine group, an imidazolidine group, a dihydropyrrole group, a piperidine group, a tetrahydropyridine group, a dihydropyridine group, a hexahydropyrimidine group, a tetrahydropyrimidine group, a dihydropyrimidine group, a piperazine group, a tetrahydropyrazine group, a dihydropyrazine group, a tetrahydropyridazine group, or a dihydropyridazine group,
Group T3 may be a furan group, a thiophene group, a 1H-pyrrole group, a silole group, or a borole group, and
Group T4 may be a 2H-pyrrole group, a 3H-pyrrole group, an imidazole group, a pyrazole group, a triazole group, a tetrazole group, an oxazole group, an isoxazole group, an oxadiazole group, a thiazole group, an isothiazole group, a thiadiazole group, an azasilole group, an azaborole group, a pyridine group, a pyrimidine group, a pyrazine group, a pyridazine group, a triazine group, or a tetrazine group.

The terms "the cyclic group, the C₃-C₆₀ carbocyclic group, the C₁-C₆₀ heterocyclic group, the π electron-rich C₃-C₆₀ cyclic group, or the π electron-deficient nitrogen-containing C₁-C₆₀ heterocyclic group" as used herein may refer to a group condensed to any cyclic group, a monovalent group, or a polyvalent group (e.g., a divalent group, a trivalent group, a tetravalent group, etc.) according to the structure of a formula for which the corresponding term is used. For example, the "benzene group" may be a benzo group, a phenyl group, a phenylene group, or the like, which may be easily understood by one of ordinary skill in the art according to the structure of a formula including the "benzene group."

Examples of the monovalent C₃-C₆₀ carbocyclic group and the monovalent C₁-C₆₀ heterocyclic group may include a C₃-C₁₀ cycloalkyl group, a C₁-C₁₀ heterocycloalkyl group, a C₃-C₁₀ cycloalkenyl group, a C₁-C₁₀heterocycloalkenyl group, a C₆-C₆₀ aryl group, a C₁-C₆₀ heteroaryl group, a monovalent non-aromatic condensed polycyclic group, and a monovalent non-aromatic condensed heteropolycyclic group. Examples of the divalent C₃-C₆₀carbocyclic group and the monovalent C₁-C₆₀ heterocyclic group are a C₃-C₁₀ cycloalkylene group, a C₁-C₁₀ heterocycloalkylene group, a C₃-C₁₀ cycloalkenylene group, a C₁-C₁₀ heterocycloalkenylene group, a C₆-C₆₀ arylene group, a C₁-C₆₀ heteroarylene group, a divalent non-aromatic condensed polycyclic group, and a substituted or unsubstituted divalent non-aromatic condensed heteropolycyclic group.

The term "C₁-C₆₀ alkyl group" as used herein refers to a linear or branched aliphatic hydrocarbon monovalent group that has one to sixty carbon atoms, and specific examples thereof are a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, and a tert-decyl group. The term "C₁-C₆₀ alkylene group" as used herein refers to a divalent group having the same structure as the C₁-C₆₀ alkyl group.

The term "C₂-C₆₀ alkenyl group" as used herein refers to a monovalent hydrocarbon group having at least one carbon-carbon double bond in the middle or at the terminus of the C₂-C₆₀ alkyl group, and examples thereof are an ethenyl group, a propenyl group, a butenyl group, and the like. The term "C₂-C₆₀ alkenylene group" as used herein refers to a divalent group having the same structure as the C₂-C₆₀ alkenyl group.

The term "C₂-C₆₀ alkynyl group" as used herein refers to a monovalent hydrocarbon group having at least one carbon-carbon triple bond in the middle or at the terminus of the C₂-C₆₀ alkyl group, and examples thereof are an ethynyl group, a propynyl group, and the like. The term "C₂-C₆₀ alkynylene group" as used herein refers to a divalent group having the same structure as the C₂-C₆₀ alkynyl group.

The term "C₁-C₆₀ alkoxy group" as used herein refers to a monovalent group represented by -OA₁₀₁ (wherein A₁₀₁ is the C₁-C₆₀ alkyl group), and examples thereof are a methoxy group, an ethoxy group, an isopropyloxy group, and the like.

The term "C₃-C₁₀ cycloalkyl group" as used herein refers to a monovalent saturated hydrocarbon cyclic group having 3 to 10 carbon atoms, and examples thereof may include a cyclopropyl group, a cyclobutyl group, a cyclopentyl group, a cyclohexyl group, a cycloheptyl group, a cyclooctyl group, an adamantanyl group, a norbornanyl group (or bicyclo[2.2.1]heptyl group), a bicyclo[1.1.1]pentyl group, a bicyclo[2.1.1]hexyl group, a bicyclo[2.2.2]octyl group, and the like. The term "C₃-C₁₀ cycloalkylene group" as used herein refers to a divalent group having the same structure as the C₃-C₁₀ cycloalkyl group.

The term "C₁-C₁₀ heterocycloalkyl group" as used herein refers to a monovalent cyclic group of 1 to 10 carbon atoms, further including, in addition to carbon atoms, at least one heteroatom, as ring-forming atoms, and examples thereof are a 1,2,3,4-oxatriazolidinyl group, a tetrahydrofuranyl group, a tetrahydrothiophenyl group, and the like. The term "C₁-C₁₀ heterocycloalkylene group" as used herein refers to a divalent group having the same structure as the C₁-C₁₀ heterocycloalkyl group.

The term "C₃-C₁₀ cycloalkenyl group" as used herein refers to a monovalent cyclic group that has three to ten carbon atoms and at least one carbon-carbon double bond in the ring thereof and no aromaticity, and examples thereof are a cyclopentenyl group, a cyclohexenyl group, a cycloheptenyl group, and the like. The term "C₃-C₁₀ cycloalkenylene group" as used herein refers to a divalent group having the same structure as the C₃-C₁₀ cycloalkenyl group.

The term "C₁-C₁₀ heterocycloalkenyl group" as used herein refers to a monovalent cyclic group of 1 to 10 carbon atoms, further including, in addition to carbon atoms, at least one heteroatom, as ring-forming atoms, and having at least one carbon-carbon double bond in the cyclic structure thereof. Examples of the C₁-C₁₀ heterocycloalkenyl group are a 4,5-dihydro-1,2,3,4-oxatriazolyl group, a 2,3-dihydrofuranyl group, a 2,3-dihydrothiophenyl group, and the like. The term "C₁-C₁₀ heterocycloalkenylene group" as used herein refers to a divalent group having the same structure as the C₁-C₁₀ heterocycloalkenyl group.

The term "C₆-C₆₀ aryl group" as used herein refers to a monovalent group having a carbocyclic aromatic system of 6 to 60 carbon atoms, and the term "C₆-C₆₀ arylene group" as used herein refers to a divalent group having a carbocyclic aromatic system of 6 to 60 carbon atoms. Examples of the C₆-C₆₀ aryl group are a phenyl group, a pentalenyl group, a naphthyl group, an azulenyl group, an indacenyl group, an acenaphthyl group, a phenalenyl group, a phenanthrenyl group, an anthracenyl group, a fluoranthenyl group, a triphenylenyl group, a pyrenyl group, a chrysenyl group, a perylenyl group, a pentaphenyl group, a heptalenyl group, a naphthacenyl group, a picenyl group, a hexacenyl group, a pentacenyl group, a rubicenyl group, a coronenyl group, an ovalenyl group, and the like. When the C₆-C₆₀ aryl group and the C₆-C₆₀ arylene group each include two or more rings, the rings may be condensed with each other.

The term "C₁-C₆₀ heteroaryl group" as used herein refers to a monovalent group having a heterocyclic aromatic system of 1 to 60 carbon atoms, further including, in addition to carbon atoms, at least one heteroatom, as ring-forming atoms. The term "C₁-C₆₀ heteroarylene group" as used herein refers to a divalent group having a heterocyclic aromatic system of 1 to 60 carbon atoms, further including, in addition to carbon atoms, at least one heteroatom, as ring-forming atoms. Examples of the C₁-C₆₀ heteroaryl group are a pyridinyl group, a pyrimidinyl group, a pyrazinyl group, a pyridazinyl group, a triazinyl group, a quinolinyl group, a benzoquinolinyl group, an isoquinolinyl group, a benzoisoquinolinyl group, a quinoxalinyl group, a benzoquinoxalinyl group, a quinazolinyl group, a benzoquinazolinyl group, a cinnolinyl group, a phenanthrolinyl group, a phthalazinyl group, and a naphthyridinyl group. When the C₁-C₆₀ heteroaryl group and the C₁-C₆₀ heteroarylene group each include two or more rings, the rings may be condensed with each other.

The term "monovalent non-aromatic condensed polycyclic group" as used herein refers to a monovalent group (e.g., having 8 to 60 carbon atoms) having two or more rings condensed to each other, only carbon atoms as ring-forming atoms, and no aromaticity in its entire molecular structure. Examples of the monovalent non-aromatic condensed polycyclic group are an indenyl group, a fluorenyl group, a spiro-bifluorenyl group, a benzofluorenyl group, an indenophenanthrenyl group, an indeno anthracenyl group, and the like. The term "divalent non-aromatic condensed polycyclic group" as used herein refers to a divalent group having the same structure as the monovalent non-aromatic condensed polycyclic group described above.

The term "monovalent non-aromatic hetero-condensed polycyclic group" as used herein refers to a monovalent group (e.g., having 1 to 60 carbon atoms) having two or more rings condensed to each other, further including, in addition to carbon atoms, at least one heteroatom, as ring-forming atoms, and having non-aromaticity in its entire molecular structure. Examples of the monovalent non-aromatic condensed heteropolycyclic group include a pyrrolyl group, a thiophenyl group, a furanyl group, an indolyl group, a benzoindolyl group, a naphtho indolyl group, an isoindolyl group, a benzoisoindolyl group, a naphthoisoindolyl group, a benzosilolyl group, a benzothiophenyl group, a benzofuranyl group, a carbazolyl group, a dibenzosilolyl group, a dibenzothiophenyl group, a dibenzofuranyl group, an azacarbazolyl group, an azafluorenyl group, an azadibenzosilolyl group, an azadibenzothiophenyl group, an azadibenzofuranyl group, a pyrazolyl group, an imidazolyl group, a triazolyl group, a tetrazolyl group, an oxazolyl group, an isoxazolyl group, a thiazolyl group, an isothiazolyl group, an oxadiazolyl group, a thiadiazolyl group, a benzopyrazolyl group, a benzimidazolyl group, a benzoxazolyl group, a benzothiazolyl group, a benzoxadiazolyl group, a benzothiadiazolyl group, an imidazopyridinyl group, an imidazopyrimidinyl group, an imidazotriazinyl group, an imidazopyrazinyl group, an imidazopyridazinyl group, an indenocarbazolyl group, an indolocarbazolyl group, a benzofurocarbazolyl group, a benzothienocarbazolyl group, a benzosilolocarbazolyl group, a benzoindolocarbazolyl group, a benzocarbazolyl group, a benzonaphthofuranyl group, a benzonaphthothiophenyl group, a benzonaphthosilolyl group, a benzofurodibenzofuranyl group, a benzofurodibenzothiophenyl group, and a benzothienodibenzothiophenyl group. The term "divalent non-aromatic hetero-condensed polycyclic group" as used herein refers to a divalent group having the same structure as the monovalent non-aromatic hetero-condensed polycyclic group described above.

The term "C₆-C₆₀ aryloxy group" as used herein indicates -OA₁₀₂ (wherein A₁₀₂ is the C₆-C₆₀ aryl group), and the term "C₆-C₆₀ arylthio group" as used herein indicates -SA₁₀₃ (wherein A₁₀₃ is the C₆-C₆₀ aryl group).

The term "C₇-C₆₀ arylalkyl group" as used herein refers to -A₁₀₄A₁₀₅ (wherein A₁₀₄ is a C₁-C₅₄ alkylene group, and A₁₀₅ is a C₆-C₅₉ aryl group), and the term "C₂-C₆₀ heteroarylalkyl group" as used herein refers to -A₁₀₆A₁₀₇ (wherein A₁₀₆ is a C₁-C₅₉ alkylene group, and A₁₀₇ is a C₁-C₅₉ heteroaryl group).

The term "R₁₀ₐ" as used herein may be:
deuterium, -F, -Cl, -Br, -I, a hydroxyl group, a cyano group, or a nitro group;
a C₁-C₆₀ alkyl group, a C₂-C₆₀ alkenyl group, a C₂-C₆₀ alkynyl group, or a C₁-C₆₀ alkoxy group, each unsubstituted or substituted with deuterium, -F, -Cl, -Br, -I, a hydroxyl group, a cyano group, a nitro group, a C₃-C₆₀carbocyclic group, a C₁-C₆₀ heterocyclic group, a C₆-C₆₀ aryloxy group, a C₆-C₆₀ arylthio group, a C₇-C₆₀ arylalkyl group, a C₂-C₆₀ heteroarylalkyl group, -Si(Q₁₁)(Q₁₂)(Q₁₃), -N(Q₁₁)(Q₁₂), - B(Q₁₁)(Q₁₂), -C(=O)(Q₁₁), -S(=O)₂(Q₁₁), -P(=O)(Q₁₁)(Q₁₂), or a combination thereof;
a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, or a C₂-C₆₀ heteroarylalkyl group, each unsubstituted or substituted with deuterium, -F, -Cl, -Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, a C₂-C₆₀ heteroarylalkyl group, -Si(Q₂₁)(Q₂₂)(Q₂₃), -N(Q₂₁)(Q₂₂), - B(Q₂₁)(Q₂₂), -C(=O)(Q₂₁), -S(=O)₂(Q₂₁), -P(=O)(Q₂₁)(Q₂₂), or a combination thereof; or
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or - P(=O)(Q₃₁)(Q₃₂).

Q₁ to Q3, Q₁₁ to Q13, Q₂₁ to Q23 and Q₃₁ to Q₃₃ used herein may each independently be: hydrogen; deuterium; -F; -Cl; -Br; -I; a hydroxyl group; a cyano group; a nitro group; a C₁-C₆₀ alkyl group; a C₂-C₆₀ alkenyl group; a C₂-C₆₀ alkynyl group; a C₁-C₆₀ alkoxy group; or a C₃-C₆₀carbocyclic group; a C₁-C₆₀ heterocyclic group; a C₇-C₆₀ aryl alkyl group; or a C₂-C₆₀ heteroaryl alkyl group;, each unsubstituted or substituted with deuterium, -F, a cyano group, a C₁-C₆₀ alkyl group, a C₁-C₆₀ alkoxy group, a phenyl group, a biphenyl group, or a combination thereof.

The term "heteroatom" as used herein refers to any atom other than a carbon atom. Examples of the heteroatom are O, S, N, P, Si, B, Ge, Se, and a combination thereof.

The term "third-row transition metal" as used herein includes hafnium (Hf), tantalum (Ta), tungsten (W), rhenium (Re), osmium (Os), iridium (Ir), platinum (Pt), gold (Au), and the like.

"Ph" as used herein refers to a phenyl group, "Me" as used herein refers to a methyl group, "Et" as used herein refers to an ethyl group, "ter-Bu" or "Bu^{t}" as used herein refers to a tert-butyl group, and "OMe" as used herein refers to a methoxy group.

The term "biphenyl group" as used herein refers to "a phenyl group substituted with a phenyl group." In other words, the "biphenyl group" may be a substituted phenyl group having a C₆-C₆₀ aryl group as a substituent.

The term "terphenyl group" as used herein refers to "a phenyl group substituted with a biphenyl group." In other words, the "terphenyl group" may be a substituted phenyl group having, as a substituent, a C₆-C₆₀ aryl group substituted with a C₆-C₆₀ aryl group.
* and *' as used herein, unless defined otherwise, each refer to a binding site to a neighboring atom in a corresponding formula or moiety.

In the present specification, the x-axis, y-axis, and z-axis are not limited to three axes in an orthogonal coordinate system, and may be interpreted in a broad sense including these axes. For example, the x-axis, y-axis, and z-axis may refer to those orthogonal to each other, or may refer to those in different directions that are not orthogonal to each other.

Hereinafter, compounds according to embodiments and light-emitting devices according to embodiments will be described in detail with reference to the following synthesis examples and examples. The wording "B was used instead of A" used in describing Synthesis Examples means that an identical molar equivalent of B was used in place of A.

### [Examples]

### Preparation Example: Synthesis of metal oxide nanoparticles

First compositions were prepared using respective compounds, mixed in the content ratio shown in Table 1 below, and 60 ml of dimethyl sulfoxide as a solvent, and were caused to react under heat treatment conditions, thereby forming metal oxide nanoparticles. At this time, Ac may refer to acetate.

**Table 1**

| | Ni-containing precursor (molar number) | Zn-containing precursor (molar number) | Heat treatment conditions | Synthesized metal oxide nanoparticles |
|---|---|---|---|---|
| Preparation Example 1 | Ni(NO₃)₂•6H₂O (2.85 mol) | ZnCl₂ (0.15 mol) | 160 °C, 3 hours | Ni_{0.97}Zn_{0.03}O |
| Preparation Example 2 | Ni(NO₃)₂•6H₂O (2.70 mol) | ZnCl₂ (0.3 mol) | 160 °C, 3 hours | Ni_{0.92}Zn_{0.08}O |
| Comparative Preparation Example 1 | Ni(NO₃)₂•6H₂O (3 mol) | - | 160 °C, 3 hours | NiO |
| Comparative Preparation Example 2 | Ni(NO₃)₂•6H₂O (2.70 mol) | Zn(Ac)₂ | 160 °C, 3 hours | NiO, ZnO |

### Evaluation Example 1

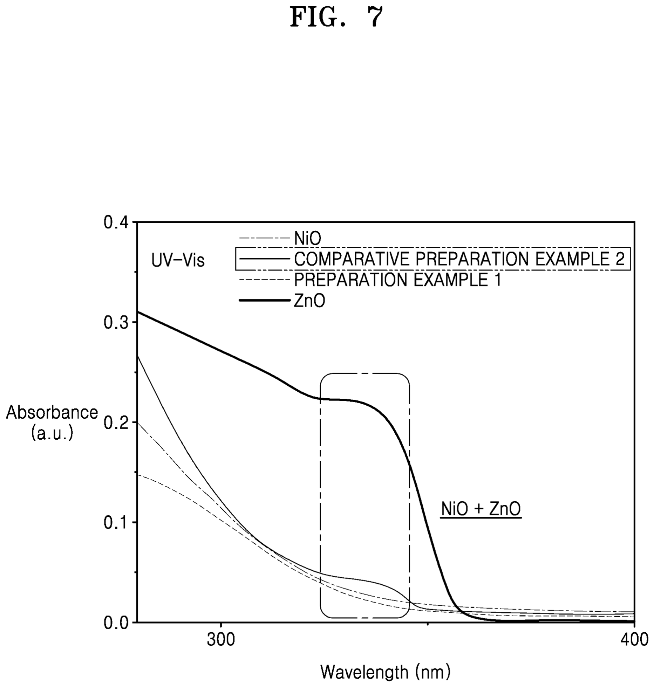

The absorbance of the metal oxide nanoparticles prepared according to each of Preparation Example 1 and Comparative Preparation Example 2 was measured by analyzing the absorption spectrum obtained using a Shimadzu UV-2600i ultra violet (UV)-visible spectrometer, and is shown in FIG. 7.

Referring to FIG. 7, it was confirmed that, unlike in Preparation Example 1, in Comparative Preparation Example 2, only metal oxide nanoparticles of ZnO and NiO were formed instead of the metal oxide nanoparticles according to the present disclosure.

Therefore, it was confirmed that the metal oxide nanoparticles of the present disclosure can be effectively manufactured by Preparation Example 1 according to the present disclosure.

### Evaluation Example 2

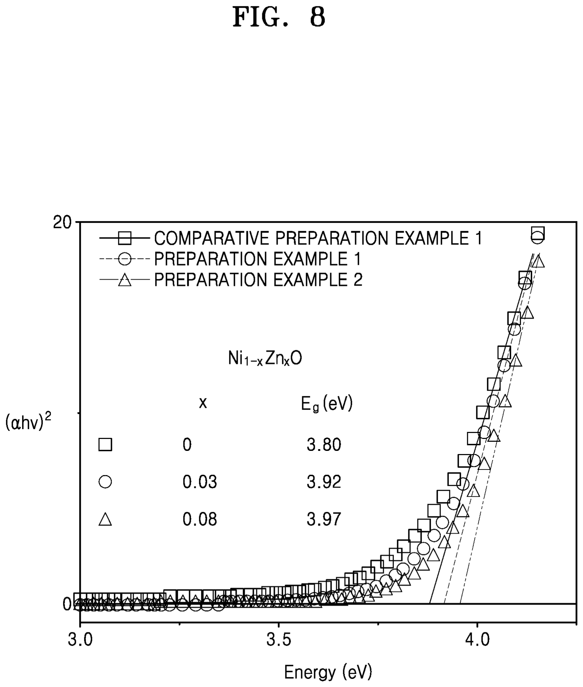

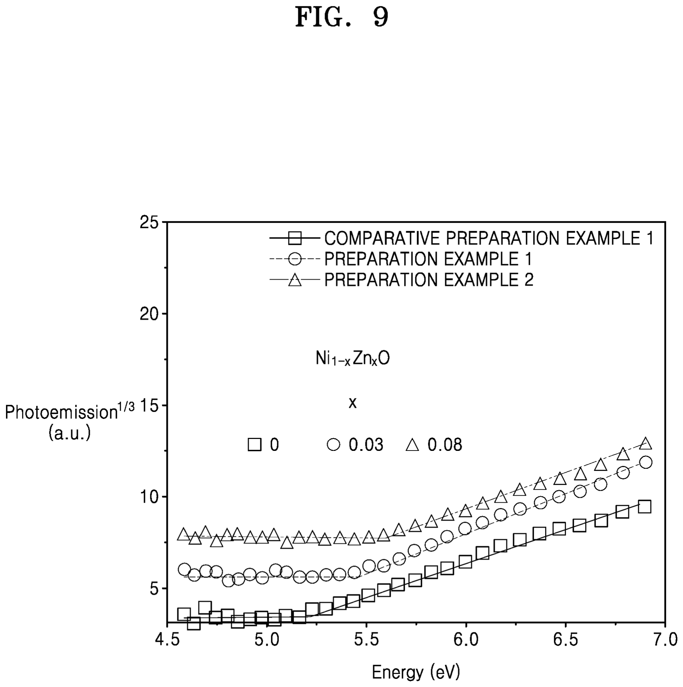

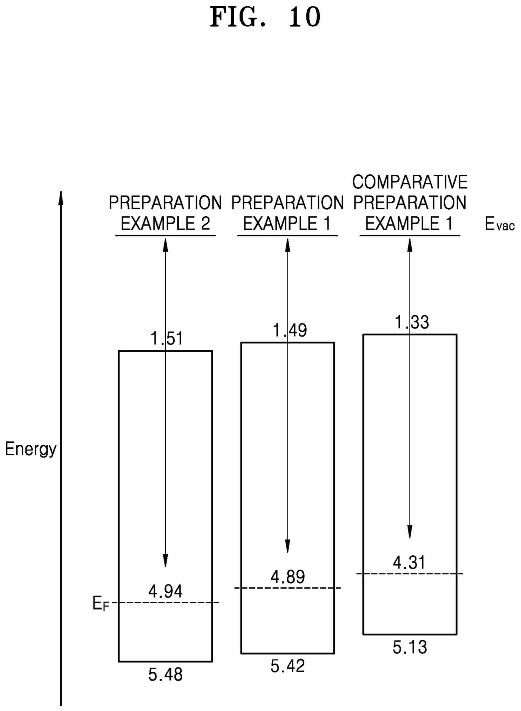

To calculate the band gap of each of Preparation Example 1, Preparation Example 2, and Comparative Preparation Example 1, based on the absorption spectrum through a Shimadzu UV-2600i UV-visible spectrometer, the wavelength was converted into energy (x-axis) and the y-axis was converted through the square of the absorption coefficient (α), Planck's constant (h), and Hammu (v) ((αhv)²), so as to obtain a Tauc plot (see FIG. 7), and the tangent from the upper part of the graph to the x-axis in the Tau plot was drawn along the trend line, and then, the x value of the trend line when y = 0, was calculated and derived as a band gap, and shown in FIG. 8 and Table 2 below. In addition, the energy levels of the valence bands of Preparation Example 1, Preparation Example 2, and Comparative Preparation Example 1 were derived from the band gap calculation results, and are shown in FIGS. 9 and 10 and Table 2 below.

**Table 2**

| Metal oxide nanoparticles | Band gap (eV) | Valence band edge energy levels (eV) |
|---|---|---|
| Preparation Example 1 | 3.92 | -5.42 |
| Preparation Example 2 | 3.97 | -5.48 |
| Comparative Preparation Example 1 | 3.80 | -5.13 |

Referring to FIGS. 8 to 10 and Table 2, it was confirmed that the band gaps of the metal oxide nanoparticles according to Preparation Example 1 and Preparation Example 2 were increased and the absolute values of the energy levels of the valence band edges were increased. Therefore, it was confirmed that not only the energy loss of the emission layer is minimized as the band gap is increased, but also the hole transport performance can be further improved by reducing the difference with the energy level of the emission layer by increasing the absolute value of the valence band energy level.

### Evaluation Example 3

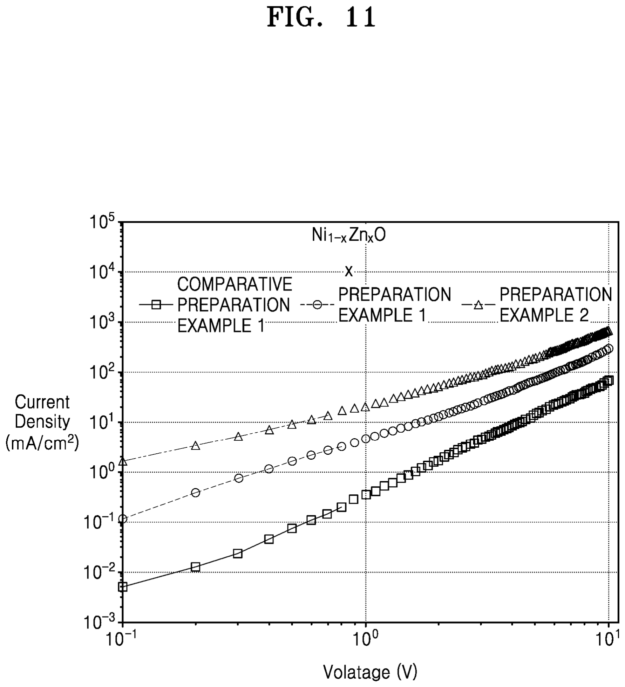

To identify the hole conductivity performance of each of Preparation Example 1, Preparation Example 2, and Comparative Preparation Example 1, the optical power meter (Ocean Optics) instrument, connected to a Keithley 2612B source and a photodiode (diode structure: ITO/metal oxide/Al), was used to measure the current density with respect to voltage, and results thereof are shown in FIG. 11. As this time, the flow of electrons is restricted due to a large energy injection barrier and only holes move. Accordingly, the environment enables the measurement of the hole mobility.

Referring to FIG. 11, it can be seen that the voltage versus current density of each of Preparation Example 1 and Preparation Example 2 was superior to that of Comparative Preparation Example 1, and thus, the hole conductivity of each of Preparation Example 1 and Preparation Example 2 was increased compared to the hole conductivity of Comparative Preparation Example 1.

### Example 1

As an anode, a Corning 15 Ω/cm² (1,200 Å) ITO-deposited glass substrate was cut to a size of 50 mm x 50 mm x 0.7 mm, sonicated with isopropyl alcohol and pure water each for 5 minutes, and then cleaned by exposure to ultraviolet rays and ozone for 30 minutes. The substrate was provided to a vacuum deposition apparatus.

Then, the metal oxide nanoparticles prepared by Preparation Example 1 were mixed with 8 ml of ethanol, which was a solvent, to form an ink composition, which was then spin-coated on the substrate (3,000 rpm, 60 seconds), and heat-treated and annealed at 100 °C to form a hole transport layer having a thickness of 450 Å.

On the hole transport layer, InP/ZnSe/ZnS quantum dots were spin-coated (4,000 rpm for 30 seconds) to form an emission layer having a thickness of 180 Å.

On the emission layer, ZnMgO was spin-coated (2,000 rpm, 60 seconds) to form an electron transport layer having a thickness of 300 Å.

On the electron transport layer, Al was thermally deposited to form a cathode having a thickness of 1,000 Å, thereby completing the manufacture of an organic-light emitting device.

### Example 2 and Comparative Example 1

Organic-light emitting devices were manufactured in the same manner as in Example 1, except that as the metal oxide nanoparticles included in the hole transport layer, the metal oxide nanoparticles synthesized according to Preparation Example 2 and Comparative Preparation Example 1 were used.

### Evaluation Example 4

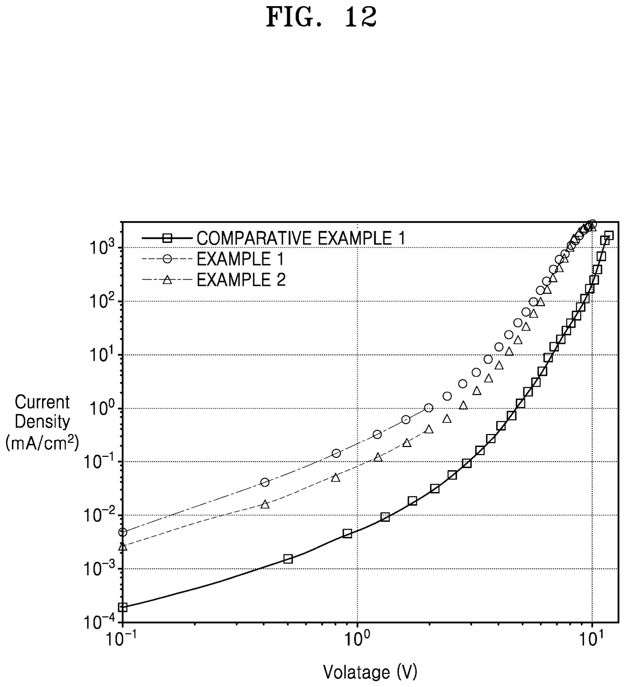

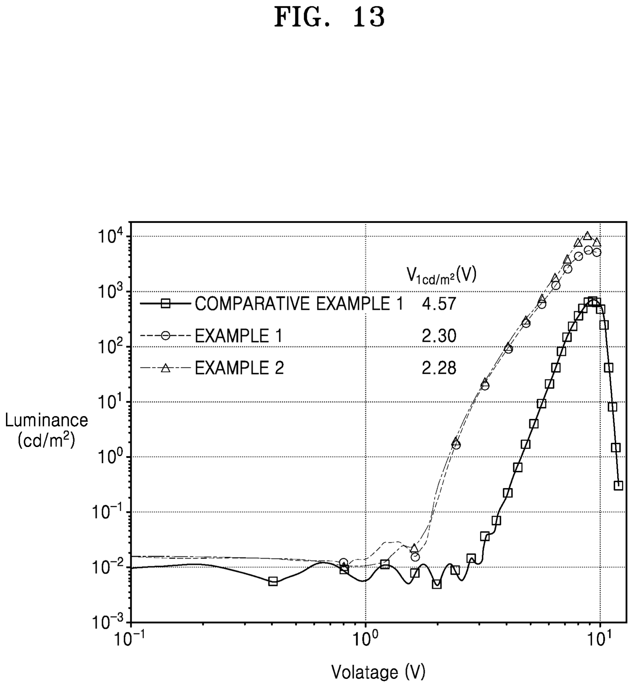

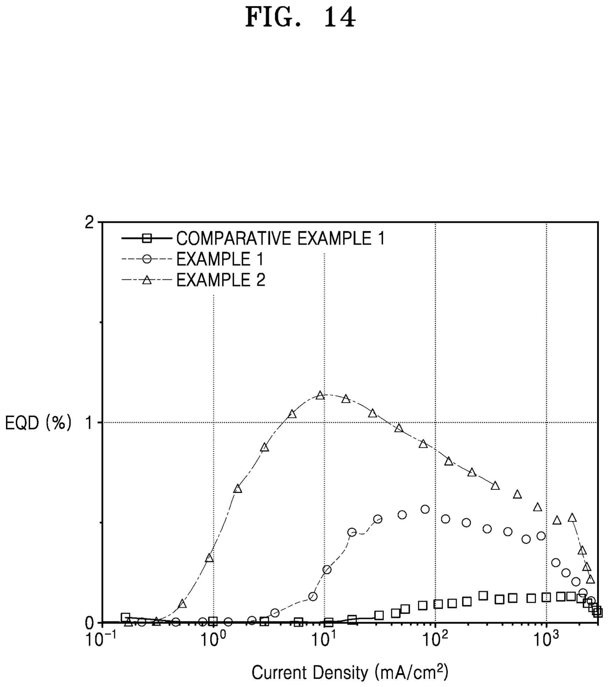

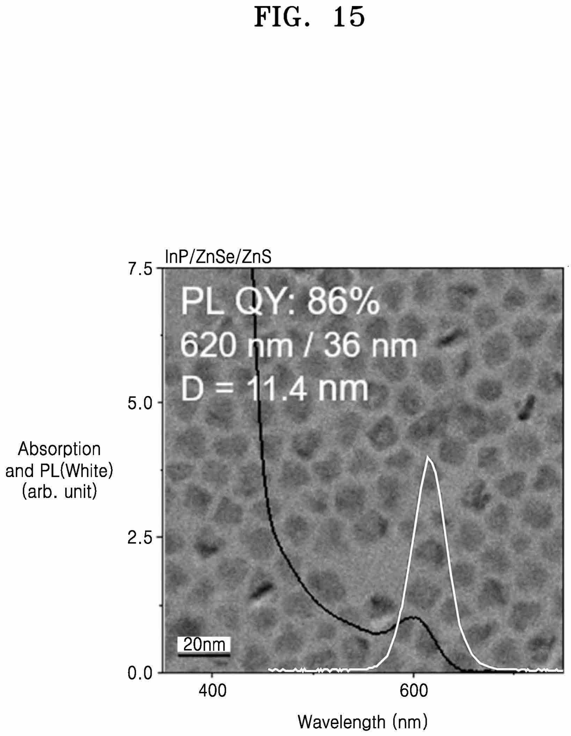

The hole conductivity, luminance, turn-on voltage, and maximum external quantum efficiency of the organic-light emitting device manufactured according to Example 1, Example 2, and Comparative Example 1 were measured and shown in FIGS. 12 to 14 and Table 3. The emission and absorption spectra of quantum dots included in the emission layer of the organic-light emitting device are shown in FIG. 15 and Table 3. For hole conductivity, current density versus voltage was measured using an optical power meter (Ocean Optics) instrument, connected to a Keithley 2612B source and a photodiode (diode structure: ITO/metal oxide/Al); turn-on voltage and luminance were measured using a spectroradiometer CS-1000 device; and the maximum external quantum efficiency was measured using a silver spectroradiometer CS-1000 instrument. In addition, the emission and absorption spectra of the quantum dots were confirmed using a Shimadzu UV-2600i ultraviolet-visible spectrometer and a Horiba FluoroMax Plus-C fluorescence spectrophotometer instrument.

**Table 3**

| | Turn-on voltage (V) | Maximum luminance (cd/m²) | Maximum external quantum efficiency (%) | PLQY (%) | Maximum emission wavelength (nm) of emission layer | Emission color |
|---|---|---|---|---|---|---|
| Example 1 | 2.30 | 11719 | 0.56 | 86 | 620 | Red |
| Example 2 | 2.28 | 13824 | 1.13 | 86 | 620 | Red |
| Comparative Example 1 | 4.57 | 710 | 0.15 | 86 | 620 | Red |

Referring to FIGS. 12 to 15 and Table 3, it can be seen that the organic-light emitting devices according to Example 1 and Example 2 each have a reduced turn-on voltage, increased maximum luminance, and increased maximum external quantum efficiency, compared to the organic-light emitting device of Comparative Example 1.

## Claims

1. A method of preparing a metal oxide nanoparticle represented by Formula 1, the method comprising:
forming a first composition including a nickel-containing precursor and an M-containing precursor; and
heat-treating the first composition, wherein
the M-containing precursor comprises at least one halogen element:
Formula 1 Ni₁₋ₓMₓO
wherein, in Formula 1, x satisfies the condition of 0 <x<1, and M includes at least one metal element.

2. The method of claim 1, wherein
the heat-treating of the first composition is performed in a temperature range of not less than 100 °C and less than 300 °C.

3. The method of claim 1, wherein
M comprises zinc (Zn), magnesium (Mg), copper (Cu), lead (Pb), aluminum (Al), indium (In), strontium (Sr), palladium (Pd), cadmium (Cd), silver (Ag), or a combination thereof.

4. The method of claim 1, wherein
the M-containing precursor is represented by Formula 2:
Formula 2 MX_{y}
wherein, in Formula 2,
X is selected from Cl, Br, and I**,** and y satisfies the condition of 0 <y≤3.

5. The method of claim 1, wherein
the nickel-containing precursor comprises nickel nitrate hydrate, nickel acetate hydrate, nickel acetylacetonate, nickel formate hydrate, nickel chloride hydrate, or a combination thereof.

6. A metal oxide nanoparticle prepared according to the method of claim 1,
wherein the metal oxide nanoparticle is represented by Formula 1:
Formula 1 Ni₁₋ₓMₓO
wherein, in Formula 1, x satisfies the condition of 0 <x<1, and M includes at least one metal element.

7. An ink composition comprising: the metal oxide nanoparticle of claim 6; and at least one solvent.

8. The ink composition of claim 7, wherein the at least one solvent is an alcohol-based solvent, an ether-based solvent, an aromatic solvent, or a combination thereof.

9. A light-emitting device comprising:
a first electrode;
a second electrode facing the first electrode; and
an interlayer arranged between the first electrode and the second electrode and comprising an emission layer, wherein
the interlayer further includes a hole transport region located between the first electrode and the emission layer, and
the hole transport region comprises the metal oxide nanoparticle of claim 6.

10. The light-emitting device of claim 9, wherein
the first electrode is an anode,
the second electrode is a cathode,
the interlayer further comprises an electron transport region located between the emission layer and the second electrode,
the hole transport region comprises a hole injection layer, a hole transport layer, an emission auxiliary layer, an electron-blocking layer, or a combination thereof, and
the electron transport region comprises a hole-blocking layer, an electron transport layer, an electron injection layer, an electron-blocking layer, or a combination thereof.

11. The light-emitting device of claim 10, wherein the metal oxide nanoparticle is included in at least one of the hole transport layer or the hole injection layer.

12. The light-emitting device of claim 9, wherein
the emission layer comprises a quantum dot.

13. The light-emitting device of claim 12, wherein
the quantum dot comprises a Group III-Group V semiconductor compound, a Group II-Group VI semiconductor compound, a Group III-Group VI semiconductor compound, a Group I-Group III-Group VI semiconductor compound, a Group IV-Group VI semiconductor compound, a Group IV element or compound, or a combination thereof.

14. A method of manufacturing the light-emitting device of claim 9, the method comprising:
preparing an ink composition comprising the metal oxide nanoparticle and at least one solvent; and
forming the hole transport region including the metal oxide nanoparticle by spin-coating the ink composition.

15. The method of claim 14, further comprising
heat-treating the ink composition after the spin-coating of the ink composition.

16. An electronic apparatus comprising the light-emitting device of claim 9.

17. The electronic apparatus of claim 16, further comprising
a thin-film transistor, wherein
the thin-film transistor comprises a source electrode and a drain electrode, and
the first electrode of the light-emitting device is electrically connected to at least one of the source electrode and the drain electrode of the thin-film transistor.

18. The electronic apparatus of claim 17, further comprising
a color filter, a color conversion layer, a touch screen layer, a polarizing layer, or a combination thereof.

19. Electronic device comprising the light-emitting device of claim 9.

20. The electronic device of claim 19, wherein
the electronic device is one of a flat panel display, a curved display, a computer monitor, a medical monitor, a television, a billboard, an indoor or outdoor light and/or light for signal, a head-up display, a fully or partially transparent display, a flexible display, a rollable display, a foldable display, a stretchable display, a laser printer, a telephone, a portable phone, a tablet personal computer, a phablet, a personal digital assistant (PDA), a wearable device, a laptop computer, a digital camera, a camcorder, a viewfinder, a micro display, a three-dimensional (3D) display, a virtual reality or augmented reality display, a vehicle, a video wall with multiple displays tiled together, a theater or stadium screen, a phototherapy device, and a signboard.
